(19) Europäisches Patentamt
European Patent Office
Office européen des brevets

(11) **EP 4 345 885 B1**

(12) **EUROPEAN PATENT SPECIFICATION**

(45) Date of publication and mention
of the grant of the patent:
**29.07.2026 Bulletin 2026/31**

(21) Application number: **22832007.3**

(22) Date of filing: **28.06.2022**

(51) International Patent Classification (IPC):
*H01Q 9/04* ^(2006.01)       *H01Q 21/26* ^(2006.01)
*H01Q 9/28* ^(2006.01)       *H01Q 1/24* ^(2006.01)
*H01Q 5/335* ^(2015.01)

(52) Cooperative Patent Classification (CPC):
**H01Q 9/28; H01Q 1/246; H01Q 5/335;**
**H01Q 9/0457; H01Q 21/26**

(86) International application number:
**PCT/CN2022/101755**

(87) International publication number:
**WO 2023/274193 (05.01.2023 Gazette 2023/01)**

(54) **ANTENNA STRUCTURE, ANTENNA MODULE, CHIP, AND ELECTRONIC DEVICE**

ANTENNENSTRUKTUR, ANTENNENMODUL, CHIP UND ELEKTRONISCHE VORRICHTUNG

STRUCTURE D'ANTENNE, MODULE D'ANTENNE, PUCE ET DISPOSITIF ÉLECTRONIQUE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **30.06.2021 CN 202110742511**

(43) Date of publication of application:
**03.04.2024 Bulletin 2024/14**

(73) Proprietor: **Huawei Technologies Co., Ltd.**
**Longgang**
**Shenzhen, Guangdong 518129 (CN)**

(72) Inventors:
• **YAO, Yu**
  **Shenzhen, Guangdong 518129 (CN)**
• **WU, Youquan**
  **Shenzhen, Guangdong 518129 (CN)**
• **HOU, Meng**
  **Shenzhen, Guangdong 518129 (CN)**

(74) Representative: **Isarpatent**
**Patent- und Rechtsanwälte**
**Barth Hassa Peckmann & Partner mbB**
**Friedrichstraße 31**
**80801 München (DE)**

(56) References cited:
CN-A- 102 270 780       CN-A- 106 463 466
CN-A- 108 183 329       CN-A- 112 968 281
CN-U- 209 266 562       JP-A- 2005 197 776
US-A1- 2006 071 308     US-A1- 2019 115 643

• YU BIN ET AL: "A Wideband mmWave Antenna in
Fan-Out Wafer Level Packaging With Tall Vertical
Interconnects for 5G Wireless Communication",
IEEE TRANSACTIONS ON ANTENNAS AND
PROPAGATION, IEEE, USA, vol. 69, no. 10, 15
June 2021 (2021-06-15), pages 6906 - 6911,
XP011881440, ISSN: 0018-926X, [retrieved on
20211004], DOI: 10.1109/TAP.2021.3087859
• WATANABE ATOM O.; ALI MUHAMMAD; SAYEED
SK YEAHIA BEEN; TUMMALA RAO R.;
PULUGURTHA MARKONDEYA RAJ: "A Review
of 5G Front-End Systems Package Integration",
IEEE TRANSACTIONS ON COMPONENTS,
PACKAGING AND MANUFACTURING
TECHNOLOGY, IEEE, USA, vol. 11, no. 1, 1
December 2020 (2020-12-01), USA
, pages 118 - 133, XP011833821, ISSN: 2156-3950,
DOI: 10.1109/TCPMT.2020.3041412

• **LUK KWAI-MAN; LI MINGJIAN: "Magneto-electric dipole antennas for millimeter-wave applications", 2013 ASIA-PACIFIC MICROWAVE CONFERENCE PROCEEDINGS (APMC), IEEE, 5 November 2013 (2013-11-05), pages 304 - 306, XP032549442, DOI: 10.1109/APMC.2013.6695127**
• **LI MINGJIAN; LUK KWAI-MAN: "Wideband Magneto-Electric Dipole Antenna for 60-GHz Millimeter-Wave Communications", IEEE TRANSACTIONS ON ANTENNAS AND PROPAGATION, IEEE, USA, vol. 63, no. 7, 1 July 2015 (2015-07-01), USA, pages 3276 - 3279, XP011662474, ISSN: 0018-926X, DOI: 10.1109/ TAP.2015.2425418**

## Description

## TECHNICAL FIELD

This disclosure generally relates to the field of antenna technologies.

The invention in particular relates to a chip, and an electronic device.

## BACKGROUND

With rapid development of key technologies such as bezel-less screens, keeping an electronic device lightweight and thin and an ultimate screen-to-body ratio has become a trend. This design greatly reduces room for antenna arrangement. In such a condition in which antennas are compactly arranged, it is difficult for a conventional antenna to satisfy a performance requirement of a plurality of communication frequency bands. In addition, in terms of communication frequency bands used by mobile phones, 3G, 4G, and 5G frequency bands are going to coexist for a long time in the future. There are increasingly more antennas and increasingly wider frequency band coverage. Based on these changes, it is urgent to implement new miniaturized antennas on mobile phones.

The paper by YU BIN ET AL: "A Wideband mmWave Antenna in Fan-Out Water Level Packaging With Tall Vertical Interconnects for 5G Wireless Communication", IEEE TRANSACTIONS ON ANTENNAS AND PROPAGATION, IEEE, USA, vol. 69, no. 10, 15 June 2021 (2021-06-15), pages 6906-6911, XP011881440, ISSN: 0018-926X, DOI: 10.1109/TAP.2021.3087859 addresses the general technical problem of designing and integrating high-performance millimeter-wave (mmWave) antennas for fifth-generation (5G) wireless communication systems. Specifically, the issues include achieving wide bandwidth, dual polarization, low back lobes, and good radiation performance in a compact and cost-effective package suitable for consumer electronics. The disclosed antenna uses fan-out wafer-level packaging (FOWLP) technology where the proposed FOWLP technology includes double-sided RDLs, which provide more degrees of freedom in the design of sophisticated antennas-in-packages (AiPs). This allows for more complex and efficient antenna designs. Further, the use of tall Cu V-ICs instead of traditional metallic plating via holes allows for better integration of other devices and components within the package. This is crucial for achieving the desired electrical and thermal performance. The antenna design is a dual-polarized magnetoelectric (ME) dipole antenna. This antenna type is chosen for its good RF performance in bandwidth, low back lobes, and dual-polarization capabilities.

## SUMMARY

The object of the present invention is to provide an antenna structure, a chip, and an electronic device such that a miniaturized design of the antenna structure can be achieved. This object is solved by the attached independent claims and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "...aspect according to an example", "the disclosure describes", or "the disclosure" describe technical teaching which relates to the understanding of the invention or its embodiments, which, however, is not claimed as such.

According to a first aspect according to the invention, the invention provides an antenna structure. The antenna structure includes a ground layer, a feeding element, and an antenna element. The antenna element includes a first metal layer, a second metal layer, a first conducting member, and a second conducting member. The first metal layer and the ground layer are disposed opposite and spaced from each other. The second metal layer is located between the first metal layer and the ground layer, and is spaced from both the first metal layer and the ground layer. The second metal layer includes a first area and a second area that are spaced from each other. The first conducting member is connected between the first metal layer and the first area of the second metal layer. The second conducting member is connected between the ground layer and the second area of the second metal layer.

The feeding element is located on a side that is of the second metal layer and that faces the ground layer. The feeding element is configured to feed the second metal layer and the first metal layer.

It can be understood that, as the first conducting member and the second conducting member are spaced from each other in two areas of the second metal layer, when the antenna element is in a working state, a current path includes the ground layer, the second conducting member, the second area of the second metal layer, the first area of the second metal layer, the first conducting member, and the first metal layer. Because a current may be transmitted between the first area and the second area of the second metal layer, the current path is disposed as bent. Compared with an antenna structure that has a same current path, where the current path of the antenna structure is straight, a cross-sectional height of the antenna structure in this embodiment is smaller, to facilitate achieving thinness of the antenna structure.

In a possible implementation, the first conducting member is a plurality of first metal columns. The second conducting member includes a first metal connection sheet, a plurality of second metal columns, and a plurality of third metal columns. The first metal connection sheet is located between the second metal layer and the ground layer. The plurality of second metal columns are connected between the first metal connection sheet and the second area of the second metal layer. The plurality of third metal columns are connected between the first metal connection sheet and the ground layer.

It can be understood that the antenna structure may be an antenna configured to transmit and receive in a millimeter-wave frequency band. For example, the antenna structure may support frequency bands n257, n258, n259, n260, and n261. For example, the antenna structure may cover a frequency range from 24.25 GHz to 43.5 GHz.

In a possible implementation, a diameter of the third metal column is greater than a diameter of the second metal column.

It can be understood that, when the diameter of the second metal column is smaller, a thickness of a chip bodylectric layer surrounding the second metal columns may be made small. When the diameter of the third metal column is larger, a thickness of a chip bodylectric layer surrounding the third metal columns may be made large. In this way, in a forming process of the antenna structure, the two chip bodylectric boards (one chip bodylectric board is provided with the second metal columns, and the other chip bodylectric board is provided with the third metal columns) of different thicknesses may be stacked up into a whole by bonding, welding, or the like.

In an implementation, the plurality of first metal columns are arranged into an L shape or an arc shape, the first metal connection sheet has an L shape or an arc shape, the plurality of second metal columns are arranged into an L shape or an arc shape, and the plurality of third metal columns are arranged into an L shape or an arc shape.

It can be understood that, as the first metal connection sheet is disposed into an L shape or an arc shape, the plurality of second metal columns are arranged into an L shape or an arc shape, and the plurality of third metal columns are arranged into an L shape or an arc shape, the second metal layer, the second metal columns, the third metal columns, the first metal connection sheet, and the ground layer can circle up to form a space. In this way, another component of the antenna structure may be disposed in the space. On one hand, space utilization of the antenna structure is high. On the other hand, the antenna structure may be compactly disposed, to facilitate miniaturization of the antenna structure.

In an implementation, projections of the third metal columns on the first metal connection sheet at least partly overlap projections of the second metal columns on the first metal connection sheet. In this way, the current path is disposed as bent once. The antenna structure is relatively simple.

In an implementation, the first metal connection sheet includes a third area and a fourth area that are spaced from each other. The second metal columns are connected between the third area of the first metal connection sheet and the second area of the second metal layer. The third metal columns are connected between the fourth area of the first metal connection sheet and the ground layer.

It can be understood that when the antenna element is in the working state, the current path includes the ground layer, the third metal columns, the fourth area of the first metal connection sheet, the third area of the first metal connection sheet, the second metal columns, the second metal layer, the first metal columns, and the first metal layer. In this case, because a current may be transmitted between the fourth area of the first metal connection sheet and the third area of the first metal connection sheet and transmitted between the two areas of the second metal layer, the current path is disposed as bent twice. Compared with the solution in which the current path is disposed as bent once, a cross-sectional height of the antenna structure in this implementation can be smaller. In this way, thinness of the antenna structure is easier to achieve.

In an implementation, there are four antenna elements. The four antenna elements are arranged in two rows and two columns and are spaced from each other. The four antenna elements have a central point. The four antenna elements are a first antenna element, a second antenna element, a third antenna element, and a fourth antenna element.

A second conducting member of the first antenna element is located on a side that is of a first conducting member of the first antenna element and that is farther away from the central point. A second conducting member of the second antenna element is located on a side that is of a first conducting member of the second antenna element and that is farther away from the central point. A second conducting member of the third antenna element is located on a side that is of a first conducting member of the third antenna element and that is farther away from the central point. A second conducting member of the fourth antenna element is located on a side that is of a first conducting member of the fourth antenna element and that is farther away from the central point. In this way, the second conducting member of the first antenna element, the second conducting member of the second antenna element, the second conducting member of the third antenna element, and the second conducting member of the fourth antenna element can circle up to form a space of a relatively large volume.

In addition, the feeding element is located in the space encircled by the second conducting member of the first antenna element, the second conducting member of the second antenna element, the second conducting member of the third antenna element, and the second conducting member of the fourth antenna element. In this way, on one hand, space utilization of the antenna structure is high. On the other hand, the antenna structure may be compactly disposed, to facilitate miniaturization of the antenna structure.

In an implementation, the first antenna element, the second antenna element, the third antenna element, and the fourth antenna element form a centrosymmetric structure.

In an implementation, the feeding element includes a first feeding branch and a second feeding branch that are spaced from each other. One end of the first feeding branch is located on a side that is of a second metal layer of the first antenna element and that faces the ground layer. The other end of the first feeding branch is located on a side that is of a second metal layer of the fourth antenna element and that faces the ground layer. The first feeding branch is configured to feed the second metal layer of the first antenna element, a first metal layer of the first antenna element, the second metal layer of the fourth antenna element, and a first metal layer of the fourth antenna element. One end of the second feeding branch is located on a side that is of a second metal layer of the second antenna element and that faces the ground layer. The other end of the second feeding branch is located on a side that is of a second metal layer of the third antenna element and that faces the ground layer. The second feeding branch is configured to feed the second metal layer of the second antenna element, a first metal layer of the second antenna element, the second metal layer of the third antenna element, and a first metal layer of the third antenna element.

It can be understood that the feeding element may simultaneously feed the first antenna element, the second antenna element, the third antenna element, and the fourth antenna element.

In an implementation, the first antenna element, the second antenna element, the third antenna element, and the fourth antenna element are all symmetric structures. A symmetry plane of the first antenna element, a symmetry plane of the second antenna element, a symmetry plane of the third antenna element, and a symmetry plane of the fourth antenna element all pass through the central point. An extension direction of the first feeding branch is parallel to the symmetry plane of the first antenna element and the symmetry plane of the fourth antenna element. An extension direction of the second feeding branch is parallel to the symmetry plane of the second antenna element and the symmetry plane of the third antenna element. In this way, the antenna structure can generate two types of polarization. A first type of polarization is -45° polarization of the antenna structure. A second type of polarization is +45° polarization of the antenna structure.

In an implementation, the first feeding branch includes a first part, a second part, a third part, a fourth part, and a fifth part that are sequentially connected. A distance between the first part and the ground layer, a distance between the fifth part and the ground layer, and a distance between the second feeding branch and the ground layer are all equal. The second part, the third part, and the fourth part form a "U" shape, and the third part is located between the second feeding branch and the ground layer. In this way, a distance between the first feeding branch and the second metal layer of the first antenna element, a distance between the first feeding branch and the second metal layer of the fourth antenna element, a distance between the second feeding branch and the second metal layer of the second antenna element, and a distance between the first feeding branch and the second metal layer of the third antenna element may be all equal to a large extent.

In an implementation, a distance between the first feeding branch and the ground layer is greater than or less than the distance between the second feeding branch and the ground layer. A structure of the feeding element in this implementation is relatively simple.

In an implementation, the antenna structure further includes a plurality of metal short-circuit hole groups. The plurality of metal short-circuit hole groups are electrically connected to the ground layer and are located on a periphery of the first antenna element, the second antenna element, the third antenna element, and the fourth antenna element.

The first antenna element and the second antenna element form a first gap. At least one metal short-circuit hole group is disposed in an extension direction of the first gap. The first antenna element and the third antenna element form a second gap. At least one metal short-circuit hole group is disposed in an extension direction of the second gap. The third antenna element and the fourth antenna element form a third gap. At least one metal short-circuit hole group is disposed in an extension direction of the third gap. The fourth antenna element and the second antenna element form a fourth gap. At least one metal short-circuit hole group is disposed in an extension direction of the fourth gap.

It can be understood that the antenna structure may have four resonant frequencies. On one hand, within a frequency band range including n257, n258, n259, n260, and n261, the antenna structure may have another resonance point. On the other hand, within the frequency band range including n257, n258, n259, n260, and n261, the antenna structure may have another trap point.

In an implementation, the antenna structure further includes a plurality of matching via groups. The plurality of matching via groups are electrically connected to the ground layer. The plurality of matching via groups are located on the periphery of the antenna elements. The plurality of matching via groups are disposed around the antenna elements.

It can be understood that, as the plurality of matching via groups that are spaced from each other are disposed on the ground layer, the matching via groups can enlarge a current path between the antenna elements and the ground layer. The matching via groups may be configured to tune impedance of the antenna structure, to implement impedance matching. In addition, because the matching via groups may enlarge the current path between the antenna elements and the ground layer, sizes of the antenna elements and the ground layer in embodiments can be made small, to achieve miniaturization of the antenna structure.

In an implementation, the antenna structure further includes a chip bodylectric layer. The ground layer, the feeding element, and the antenna elements are all disposed at the chip bodylectric layer. In this way, the antenna structure has higher integrity and stability.

In an implementation, the chip bodylectric layer is made of an LCP. Because a loss tangent of the LCP remains relatively small at a high frequency, the antenna structure may have a relatively small transmission loss, thereby improving antenna radiation efficiency and obtaining a higher antenna gain.

In an implementation, the first conducting member is a first metal wall. The second conducting member includes a metal connection sheet, a second metal wall, and a third metal wall. The metal connection sheet is located between the second metal layer and the ground layer. The second metal wall is connected between the metal connection sheet and the second area of the second metal layer. The third metal wall is connected between the metal connection sheet and the ground layer.

It can be understood that the antenna structure in this implementation may support a low frequency. For example, a frequency band that can be covered by the antenna structure may be 1.5 GHz to 3 GHz.

In an implementation, the metal connection sheet includes a third area and a fourth area that are spaced from each other. The second metal wall is connected between the third area of the metal connection sheet and the second area of the second metal layer. The third metal wall is connected between the fourth area of the metal connection sheet and the ground layer.

It can be understood that, as the second metal wall and the third metal wall are spaced from each other in two areas of the metal connection sheet, and the first metal wall and the second metal wall are spaced from each other in two areas of the second metal layer, when the antenna element is in the working state, the current path includes the ground layer, the third metal wall, the metal connection sheet, the second metal wall, the second metal layer, the first metal wall, and the first metal layer. Because a current may be transmitted between the third area and the fourth area of the metal connection sheet and transmitted between the first area and the second area of the second metal layer, the current path may be disposed as bent twice. In this way, compared with an antenna structure that has a same current path, where the current path of the antenna structure is straight, a cross-sectional height of the antenna structure in this embodiment is smaller, to facilitate miniaturization of the antenna structure.

In an implementation, a projection of the third metal wall on the metal connection sheet at least partly overlaps a projection of the second metal wall on the metal connection sheet. In this way, the current path is disposed as bent once. The antenna structure is relatively simple.

According to a second aspect, this application provides an antenna module, including a radio frequency circuit and the antenna structure described above. The radio frequency circuit is electrically connected to a feeding element of the antenna structure.

It can be understood that when the antenna structure is applied to the antenna module, because the antenna structure can achieve miniaturization, the antenna module can also achieve miniaturization.

According to a third aspect, this application provides an electronic device. The electronic device includes a circuit board and the antenna module described above. The antenna module is disposed on the circuit board.

It can be understood that when the antenna module is used in the electronic device, because the antenna module can achieve miniaturization, the electronic device can also achieve miniaturization.

In an implementable, the antenna structure and the circuit board are an integrally formed structure. In this way, a structure of the antenna module is simpler.

According to a fourth aspect, this application provides a chip. The chip includes a package substrate, an injection molded piece, a chip body, and the antenna structure described above. Both the antenna structure and the chip body are disposed on the package substrate and are electrically connected to the package substrate. The injection molded piece is configured to package the antenna structure and the chip body.

It can be understood that when the antenna structure is applied to the chip, because the antenna structure can achieve miniaturization, the chip can also achieve miniaturization.

In an implementation, the chip body is a radio frequency transceiver chip. The antenna structure is electrically connected to the chip body via the package substrate.

According to a fifth aspect, this application provides an electronic device. The electronic device includes a circuit board and the chip described above. The chip is disposed on the circuit board.

It can be understood that when the chip is used in the electronic device, because the chip can achieve miniaturization, the electronic device can also achieve miniaturization.

In the following description, features which in the above summary of the invention have been marked as "not claimed" or "according to the invention" are also hereinafter, when they are described and explained with reference to the drawings, to be understood as "not claimed" or "not part of the invention" or "according to the invention". Even if sometimes in the description of the embodiments below, features marked above "according to the invention" or "the invention" are referred to in connection with the words "can" or "may" or other expressions which contain the notion of them being "optional", it should be understood that indeed such features are considered essential to the invention as claimed and not optional.

## BRIEF DESCRIPTION OF DRAWINGS

FIG. 1 is a schematic diagram of a structure of an electronic device according to an embodiment of this application;

FIG. 2 is an exploded schematic diagram of a part of the electronic device shown in FIG. 1;

FIG. 3 is an exploded schematic diagram of a part of a circuit board component shown in FIG. 2;

FIG. 4 is an exploded schematic diagram of a part of an antenna structure shown in FIG. 3;

FIG. 5 is an exploded schematic diagram of a first antenna element and a second antenna element shown in FIG. 4;

FIG. 6 is a schematic diagram of a part of a structure of an antenna structure shown in FIG. 3;

FIG. 7 is a schematic diagram of structures of a first metal connection sheet and a second metal connection sheet of the first antenna element shown in FIG. 5;

FIG. 8 is a schematic diagram of a part of a structure of an antenna structure shown in FIG. 3;

FIG. 9 is a schematic diagram of a part of a structure of an antenna structure shown in FIG. 3;

FIG. 10 is a schematic diagram of a structure of a second metal sheet of the first antenna element shown in FIG. 5;

FIG. 11 is a schematic diagram of a part of a structure of an antenna structure shown in FIG. 3;

FIG. 12 is a schematic diagram of a structure of a first metal sheet of the first antenna element shown in FIG. 5;

FIG. 13 is a schematic diagram of a part of a structure of an antenna structure shown in FIG. 3;

FIG. 14 is a schematic cross-sectional diagram of a part of the antenna structure shown in FIG. 13 cut along a line A-A;

FIG. 15 is an exploded schematic diagram of a third antenna element and a fourth antenna element shown in FIG. 4;

FIG. 16 is a schematic diagram of a part of a structure of an antenna structure shown in FIG. 3;

FIG. 17 is a schematic diagram of a part of a structure of an antenna structure shown in FIG. 3;

FIG. 18 is a schematic diagram of a structure of an antenna structure shown in FIG. 3;

FIG. 19 is a schematic diagram of a structure of a feeding element shown in FIG. 4;

FIG. 20 is a schematic diagram of a part of a structure of an antenna structure shown in FIG. 3;

FIG. 21 is a schematic cross-sectional diagram of the antenna structure shown in FIG. 20 cut along a line B-B;

FIG. 22 is a schematic diagram of a part of a structure of an antenna structure shown in FIG. 3;

FIG. 23 is a schematic cross-sectional diagram of the antenna structure shown in FIG. 22 cut along a line C-C;

FIG. 24 is a schematic diagram of a part of a structure of an antenna structure shown in FIG. 3;

FIG. 25a is a data diagram in which a reflection coefficient of an antenna structure changes with a frequency according to an embodiment of this application;

FIG. 25b is a schematic diagram of a type of polarization of an antenna structure according to an embodiment of this application;

FIG. 25c is a schematic diagram of another type of polarization of an antenna structure according to an embodiment of this application;

FIG. 25d is a schematic cross-sectional diagram of a part of a package substrate structure according to an embodiment;

FIG. 26 is a schematic diagram of structures of a first metal connection sheet and a second metal connection sheet of a first antenna element in another implementation according to an embodiment of this application;

FIG. 27 is a schematic diagram of a part of a structure of an antenna structure in another implementation according to an embodiment of this application;

FIG. 28 is a schematic cross-sectional diagram of a part of an antenna structure in another implementation according to an embodiment of this application;

FIG. 29 is a schematic diagram of a structure of an antenna structure in another implementation according to an embodiment of this application;

FIG. 30a is a data diagram in which a reflection coefficient of an antenna structure changes with a frequency according to an embodiment of this application;

FIG. 30b is a schematic diagram of a current in an antenna structure in a frequency band of n259 according to an embodiment of this application;

FIG. 30c is a schematic diagram of an electric field of an antenna structure in a frequency band of n259 according to an embodiment of this application;

FIG. 30d is a schematic diagram of a current in an antenna structure in a frequency band of n260 according to an embodiment of this application;

FIG. 30e is a schematic diagram of an electric field of an antenna structure in a frequency band of n260 according to an embodiment of this application;

FIG. 31 is a schematic diagram of a structure of an antenna structure in still another implementation according to an embodiment of this application;

FIG. 32a is a data diagram in which a reflection coefficient of an antenna structure changes with a frequency according to an embodiment of this application;

FIG. 32b is a schematic cross-sectional diagram of a chip according to an embodiment of this application;
FIG. 33 is a schematic diagram of a structure of an electronic device according to another embodiment of this application;
FIG. 34 is an exploded schematic diagram of an antenna structure shown in FIG. 33;
FIG. 35 is an exploded schematic diagram of a first antenna element in FIG. 34;
FIG. 36 is a schematic diagram of a part of a structure of an antenna structure shown in FIG. 33;
FIG. 37 is a schematic diagram of a part of a structure of an antenna structure shown in FIG. 33; and
FIG. 38 is a schematic diagram of a structure of an antenna structure shown in FIG. 33.

## DESCRIPTION OF EMBODIMENTS

To facilitate understanding of an antenna structure provided in embodiments of this application, related terms used in this application are explained below.

It should be understood that, in this application, an "electrical connection" may be understood as a manner in which elements or components are physically in contact and electrically conducting; or may be understood as a manner in which different elements or components are connected through a physical line that can transfer an electrical signal in wiring, for example, printed circuit board (Printed Circuit Board, PCB) copper foil or a conductive wire. The electrical connection includes a direct connection and indirect coupling. Both "connection" and "interconnection" may mean a mechanical connection relationship or a physical connection relationship. The term "connection" is used as an example. The term "connection" should be understood in a broad sense. For example, a "connection" may be a detachable connection, a nondetachable connection, may be a direct connection, or may be an indirect connection through an intermediary. For example, a connection between A and B may mean that there is a fastening component (for example, a screw, a bolt, or a rivet) between A and B, or A and B are in contact with each other and A and B are difficult to be separated.

In this application, "length" may be understood as a physical length of an object, or may be understood as an electrical length. The electrical length may be a product of a physical length (that is, a mechanical length or a geometric length) and a ratio of a transmission time period of an electrical or electromagnetic signal in a medium to time required for the signal to pass through a distance as long as the physical length of the medium in free space. The electrical length may satisfy the following formula:

$$\overline{L} = L \times \frac{a}{b}$$

L is the physical length, a is a transmission time period of an electrical or electromagnetic signal in a medium, and b is a transmission time period in free space.

Alternatively, the electrical length may be a ratio of a physical length (that is, a mechanical length or a geometric length) to a wavelength of a transmitted electromagnetic wave. The electrical length may satisfy the following formula:

$$\overline{L} = \frac{L}{\lambda}$$

L is the physical length, and $\lambda$ is the wavelength of the electromagnetic wave.

Coupling is a phenomenon that two or more circuit elements or electrical networks closely cooperate with and affect each other in input and output, so that energy is transmitted from one side to another side through interaction.

An antenna gain indicates how strong an antenna radiates an input power in a specified direction. Generally, a narrower main lobe of an antenna pattern indicates a smaller side lobe and a higher antenna gain.

Antenna radiation efficiency is a ratio of a power radiated by an antenna into space (that is, a power for effectively converting to an electromagnetic wave) to an active power input to the antenna. The active power input to the antenna is equal to an input power of the antenna minus a power loss. The power loss mainly includes a return power loss and an ohmic power loss of metal and/or a chip bodylectric power loss.

An antenna return loss may be understood as a ratio of a power of a signal reflected back to an antenna port by an antenna circuit to a transmit power of the antenna port. A smaller reflected signal indicates a larger signal radiated by an antenna into space and higher radiation efficiency of the antenna. A larger reflected signal indicates a smaller signal radiated by the antenna into space and lower radiation efficiency of the antenna.

The antenna return loss may be represented by an S11 parameter, and the S11 parameter is usually a negative number. A smaller S11 parameter indicates a smaller antenna return loss and higher antenna system efficiency; and a larger S11 parameter indicates a larger antenna return loss and lower antenna system efficiency.

Antenna isolation indicates a ratio of a quantity of signals, transmitted by one antenna, received by another antenna to a quantity of signals transmitted by the antenna. Isolation is a physical quantity used to measure a degree of mutual coupling between antennas. If two antennas form a dual-port network, isolation between the two antennas is S21 and S12 for antennas. The antenna isolation may be represented by S21 and S12 parameters. The S21 and S12 parameters are usually negative numbers. Smaller S21 and S12 parameters indicate larger isolation between antennas and a smaller degree of mutual coupling between the antennas; and larger S21 and S12 parameters indicate smaller isolation between the antennas and a larger degree of mutual coupling between the antennas. The antenna isolation depends on a radiation pattern of the antennas, a spatial distance between the antennas, an antenna gain, and the like.

Reference ground may be a ground layer of a circuit board of an electronic device (for example, a mobile phone), or may be a ground layer formed by a middle plate in an electronic device or a ground metal layer formed by a metal thin film below a screen. A circuit board may be a printed circuit board (printed circuit board, PCB), for example, an 8-layer, 10-layer, or 12-layer to 14-layer board having 8, 10, 12, 13, or 14 layers of a conductive material, or an element that is separated and electrically insulated by using a chip bodylectric layer or insulation layer, for example, glass fiber, polymer, or the like. The circuit board generally includes a chip bodylectric substrate, a ground layer, and a routing layer. The routing layer and the ground layer are electrically connected through vias. Components such as a display 120, a touchscreen, an input button, a transmitter, a processor, a memory, a battery 140, a charging circuit, and a system on chip (system on chip, SoC) structure may be mounted on the circuit board or connected to the circuit board; or may be electrically connected to the routing layer and/or the ground layer of the circuit board. For example, a radio frequency source is disposed in the routing layer.

The ground layer, the ground layer, and the ground metal layer are made of a conductive material. The conductive material may be any one of the following materials: copper, aluminum, stainless steel, brass and alloys thereof, copper foil on a chip bodylectric substrate, aluminum foil on the chip bodylectric substrate, gold foil on the chip bodylectric substrate, silver-plated copper, silver-plated copper foil on the chip bodylectric substrate, silver foil on the chip bodylectric substrate and tin-plated copper, cloth impregnated with graphite powder, a graphite-coated substrate, a copper-plated substrate, a brass-plated substrate and an aluminum-plated substrate. A person skilled in the art can understand that the ground layer/ground layer/ground metal layer may alternatively be made of another conductive material.

Embodiments of this application are described below with reference to the accompanying drawings in embodiments of this application.

In the descriptions of embodiments of this application, "a plurality of" means two or more. In the descriptions of embodiment of this application, a range of A to B includes the endpoints A and B. In addition, orientation terms mentioned in embodiments of this application, for example, "top", "bottom", and "side", are merely directions with reference to the accompanying drawings. Therefore, the orientation terms are used to better and more clearly describe and understand embodiments of this application, but do not indicate or imply that the specified apparatus or element must have a specific orientation, and be constructed and operated in a specific orientation. Therefore, the orientation terms cannot be understood as a limitation on embodiments of this application.

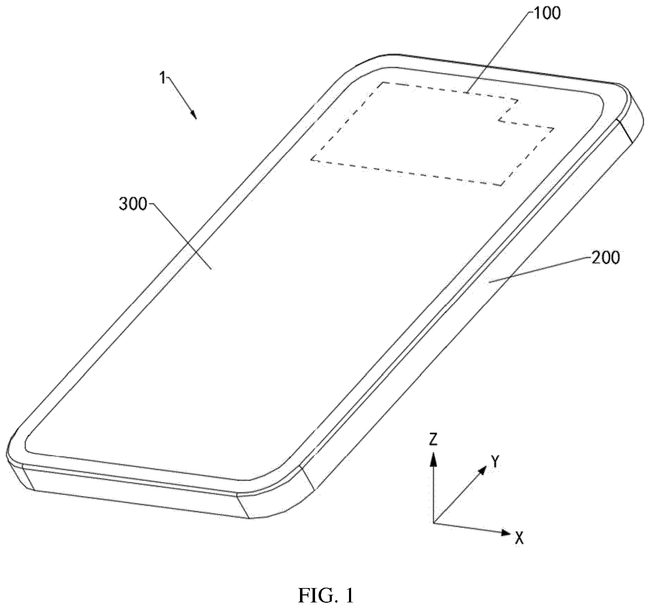

In addition, mathematical concepts mentioned in embodiments of this application such as being symmetric, equal, 45°, parallel, perpendicular, and the like are limitations in terms of existing process level, but are not subject to absolutely strict definitions in a mathematical sense. A small deviation is allowed, so that being approximately symmetric, approximately equal, approximately 45°, approximately parallel, and approximately perpendicular are acceptable. For example, that A is parallel to B means that A and B are parallel or approximately parallel, and an included angle between A and B may be between 0 degrees to 10 degrees. For example, that A is perpendicular to B means that A is perpendicular to B or approximately perpendicular to B, and an included angle between A and B may be between 80 degrees to 100 degrees. FIG. 1 is a schematic diagram of a structure of an electronic device 1 according to an embodiment of this application. The electronic device 1 may be a mobile phone, a watch, a tablet computer (tablet personal computer), a laptop computer (laptop computer), a personal digital assistant (personal digital assistant, PDA), a camera, a personal computer, a notebook computer, a vehicle-mounted device, a wearable, augmented reality (augmented reality, AR) glasses, an AR helmet, virtual reality (virtual reality, VR) glasses, a VR helmet, mixed reality (mixed reality, MR) glasses, an MR helmet, or a device that can be used to transmit a millimeter-wave antenna. In the embodiment shown in FIG. 1, an example in which the electronic device 1 is a mobile phone is used for description.

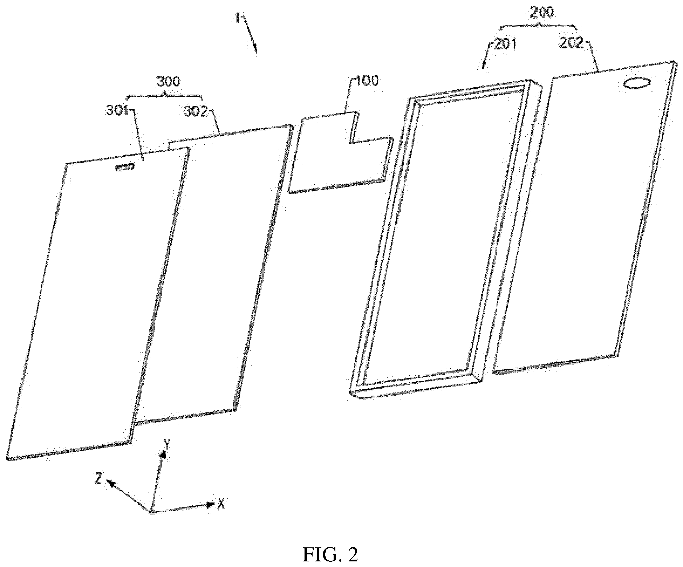

Refer to FIG. 2 with reference to FIG. 1. FIG. 2 is an exploded schematic diagram of a part of the electronic device 1 shown in FIG. 1. The electronic device 1 includes a circuit board component 100, a housing 200, and a screen 300. It can be understood that FIG. 1 and FIG. 2 schematically show some components included in the electronic device 1. Actual shapes, actual sizes, actual locations, and actual structures of these components are not limited to those shown in FIG. 1, FIG. 2, and the following accompanying drawings. It should be noted that, because the circuit board component 100 is located inside the electronic device 1, in FIG. 1, the circuit board component 100 is represented schematically by a dashed line.

The screen 300 may be configured to display an image or the like. The screen 300 may be a flat screen, or may be a curved screen. The screen 300 may include a transparent cover plate 301 and a display screen 302. The transparent cover plate 301 is layered on the display screen 302. The transparent cover plate 301 may be disposed in close contact with the display screen 302, and may be configured to provide light transmission, protection, and dust-proof functions for the display screen 302. The transparent cover plate 301 may be made of glass. The display screen 302 may be configured to display an image or the like. The display screen 302 may be a liquid crystal display (liquid crystal display, LCD) screen, an organic light-emitting diode (organic light-emitting diode, OLED) display screen, an active-matrix organic light-emitting diode or active matrix organic light-emitting diode (active-matrix organic light-emitting diode, AMOLED) display screen, a quantum dot light-emitting diode (quantum dot light emitting diode, QLED) display screen, or the like.

For example, the housing 200 includes a frame 201 and a rear cover 202. The rear cover 202 may be fixed to one side of the frame 201 by using an adhesive. In another embodiment, the rear cover 202 and the frame 201 may alternatively be an integrally formed structure.

In addition, the screen 300 may be fixed to the other side of the frame 201 by using an adhesive. The screen 300 is disposed opposite the rear cover 202, and a transparent cover plate 301 of the screen 300 is located on a side that is of a display screen 302 of the screen 300 and that is farther away from the rear cover 202. In this case, the rear cover 202, the frame 201, and the screen 300 may jointly circle up to form an interior of the electronic device 1. Components such as a battery, a speaker, a receiver, a camera, and a microphone may be disposed in the interior of the electronic device 1.

For example, the housing 200 may further include a middle plate (not shown in the figure). The middle plate is located between the screen 300 and the rear cover 202. The middle plate may be at least partly spaced from the frame 201, at least partly connected to an inner side of the frame 201, or partly spaced from the frame and partly connected to an inner side of the frame 201. For example, the inner side of the frame includes an extension part. The frame is connected to the middle plate via the extension part, or the frame and the middle plate are an integrated structure.

In addition, the circuit board component 100 is fastened in the interior of the electronic device 1. For example, the circuit board component 100 may be fastened in the interior of the electronic device 1 by using a fastener (a bolt, a screw, a dowel, or the like). In this case, the housing 200 and the screen 300 can protect the circuit board component 100.

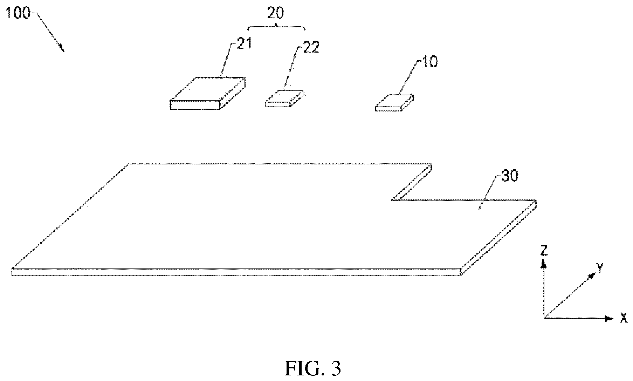

FIG. 3 is an exploded schematic diagram of a part of the circuit board component 100 shown in FIG. 2. The circuit board component 100 includes an antenna structure 10, a radio frequency circuit 20, and a circuit board (printed circuit board, PCB) 30.

The circuit board 30 may be a rigid circuit board, may be a flexible circuit board, or may be a rigid-flex circuit board. In addition, the circuit board 30 may be an FR-4 chip bodylectric board, may be a Rogers (Rogers) chip bodylectric board, may be a hybrid chip bodylectric board of FR-4 and Rogers, or the like. Herein, FR-4 is a grade designation for flame retardant material, and a Rogers chip bodylectric board is a high-frequency board. It can be understood that the circuit board 30 may include one board component. For example, the circuit board 30 may be a primary board, a secondary board, or any flexible circuit board connecting a primary board and a secondary board. For example, both the primary board and the secondary board are rigid circuit boards. The circuit board 30 may alternatively include a plurality of board components. For example, the circuit board 30 may include a primary board, a secondary board, and a subboard. The subboard is electrically connected between the primary board and the secondary board. For example, both the primary board and the secondary board are rigid circuit boards, and the subboard is a flexible circuit board.

Both the antenna structure 10 and the radio frequency circuit 20 are disposed on the circuit board 30. The antenna structure 10 may be electrically connected to the radio frequency circuit 20 via the circuit board 30. In this case, the radio frequency circuit 20 may transmit a radio frequency signal to the antenna structure 10 via the circuit board 30, so that the antenna structure 10 radiates an electromagnetic wave based on the radio frequency signal. In addition, when the antenna structure 10 receives an electromagnetic wave and converts the electromagnetic wave into a radio frequency signal, the radio frequency circuit 20 may further receive, by using the circuit board 30, the radio frequency signal converted by the antenna structure 10.

For example, the antenna structure 10 may be integrated into the circuit board 30. In this case, the antenna structure 10 and the circuit board 30 are an integrally formed structure.

The radio frequency circuit 20 includes a radio frequency transceiver chip 21 and a matching circuit 22. The matching circuit 22 may include electronic components such as an antenna switch, a capacitor, an inductor, or a resistor. The matching circuit 22 is electrically connected between the radio frequency transceiver chip 21 and the antenna structure 10. The radio frequency transceiver chip 21 is configured to transmit a radio frequency signal to the antenna structure 10, so that the antenna structure 10 radiates an electromagnetic wave based on the radio frequency signal. In addition, when the antenna structure 10 receives an electromagnetic wave and converts the electromagnetic wave into a radio frequency signal, the radio frequency transceiver chip 21 may further receive the radio frequency signal converted by the antenna structure 10.

In addition, the matching circuit 22 may be configured to perform signal processing on the radio frequency signal, for example, signal amplification or filtering.

In an embodiment, the antenna structure 10 and the matching circuit 22 may be integrated into the radio frequency transceiver chip 21. In this case, the antenna structure 10, the matching circuit 22, and the radio frequency transceiver chip 21 are an overall structure. In this way, a space in the electronic device 1 occupied by the matching circuit 22 and the antenna structure 10 can be smaller, to improve utilization of an internal space of the electronic device 1, reduce a transmission loss of an antenna, and improve antenna efficiency.

In an embodiment, the circuit board component 100 may further include a functional chip. For example, the functional chip is a central processing unit (central processing unit, CPU), a graphics processing unit (graphics processing unit, GPU), a universal flash storage (universal flash storage, UFS), or a power management integrated circuit (power management integrated circuit).

For example, the radio frequency circuit 20 and the antenna structure 10 may be integrated into the functional chip. In this case, the radio frequency circuit 20, the antenna structure 10, and the functional chip form an overall structure. For example, the radio frequency circuit 20 and the antenna structure 10 may be integrated into a CPU. In this way, a space in the electronic device 1 occupied by the radio frequency circuit 20 and the antenna structure 10 can be smaller, to improve utilization of an internal space of the electronic device 1.

It can be understood that an implementation in which the antenna structure 10 is disposed on the circuit board 30 is provided above. In another implementation, the antenna structure 10 may alternatively be disposed on another substrate, for example, a low-temperature co-fired ceramic (low-temperature co-fired ceramic, LTCC) substrate.

Refer to FIG. 3 again with reference to FIG. 1 and FIG. 2. A radiation direction of the antenna structure 10 may be set in a plurality of manners.

In a first optional manner, the antenna structure 10 may radiate or receive an electromagnetic wave to or from the outside of the electronic device 1 via the rear cover 202.

For example, the rear cover 202 is made of an insulating material (for example, glass, ceramic, or a plastic material), so that the antenna structure 10 can directly radiate or receive an electromagnetic wave to or from the outside of the electronic device 1 via the rear cover 202.

For example, the rear cover 202 is made of a metal material (for example, an aluminum alloy material), and a through hole (not shown in the figure) is provided on the rear cover 202, so that the antenna structure 10 can radiate or receive an electromagnetic wave to or from the outside of the electronic device 1 through the through hole on the rear cover 202. In addition, the through hole is filled with an insulating material (for example, materials such as polymer, glass, or ceramic, or a combination of these materials), so that integrity of the rear cover 202 and surface flatness of the rear cover 201 can be ensured without affecting electromagnetic wave transmission.

In a second optional manner, the antenna structure 10 may radiate or receive an electromagnetic wave to or from the outside of the electronic device 1 via the frame 201.

For example, the frame 201 is made of an insulating material (for example, glass, ceramic, or a plastic material), so that the antenna structure 10 can directly radiate or receive an electromagnetic wave to or from the outside of the electronic device 1 via the frame 201.

For example, the frame 201 is made of a metal material (for example, an aluminum alloy material), and a through hole (not shown in the figure) is provided on the frame 201, so that the antenna structure 10 can radiate or receive an electromagnetic wave to or from the outside of the electronic device 1 through the through hole on the frame 201. In addition, the through hole is filled with an insulating material (for example, materials such as polymer, glass, or ceramic, or a combination of these materials), so that integrity of the frame 201 and surface flatness of the frame 201 can be ensured without affecting electromagnetic wave transmission.

In a third optional manner, the antenna structure 10 may radiate or receive an electromagnetic wave to or from the outside of the electronic device 1 via the screen 300.

For example, the antenna structure 10 is disposed between the transparent cover plate 301 of the screen 300 and the display screen 302 of the screen 300, so that the antenna structure 10 can directly radiate or receive an electromagnetic wave to or from the outside of the electronic device 1 via the transparent cover plate 301.

For example, the antenna structure 10 is directly embedded inside the transparent cover plate 301 of the screen 300, so that an electromagnetic wave can be radiated to or received from the outside of the electronic device 1 via the transparent cover plate 301.

For example, the screen 300 may be a notched screen, a waterdrop screen, or the like. The antenna structure 10 may radiate or receive an electromagnetic wave to or from the outside of the electronic device 1 through a "waterdrop", a "notch", or another location on the screen 300. For example, the "waterdrop" or the "notch" on the screen 300 is a perforated structure. In this case, the antenna structure 10 may radiate or receive an electromagnetic wave to or from the outside of the electronic device 1 through a perforated location on the screen 300.

In another implementation, any two of the first optional manner to the third optional manner may be combined with each other, or the three implementations may be combined. In this way, the antenna structure 10 is not limited to radiation from one part. For example, when the antenna structure 10 is close to the rear cover 202 and the frame 201, the antenna structure 10 may radiate or receive an electromagnetic wave to or from the outside of the electronic device 1 via an insulating part of the rear cover 202 and the frame 201.

For example, the antenna structure 10 may support frequency bands n257, n258, n259, n260, and n261. For example, the antenna structure 10 may cover a frequency range from 24.25 GHz to 43.5 GHz. f0 is defined as a center frequency of the antenna structure 10. In this embodiment, f0=(24.25+43.5)/2 GHz=33.875 GHz. λ0 is defined as a medium wavelength of the center frequency. The antenna structure 10 may be applied to a millimeter-wave frequency band. The antenna structure 10 may satisfy a 5G (5th Generation, fifth Generation) mobile communication requirement of a user, and be applied to scenarios such as calling or video calling. Alternatively, an NFC (Near Field Communication, near field communication) chip is disposed in the electronic device 1, to satisfy a near field communication requirement of a user, and be applied to scenarios such as mobile payment, public transport payment, and identity verification. In another embodiment, the antenna structure 10 may alternatively cover another frequency band. In this case, the center frequency f0 of the antenna structure 10 changes accordingly.

In embodiments, several manners of disposing the antenna structure 10 are described in detail with reference to related accompanying drawings.

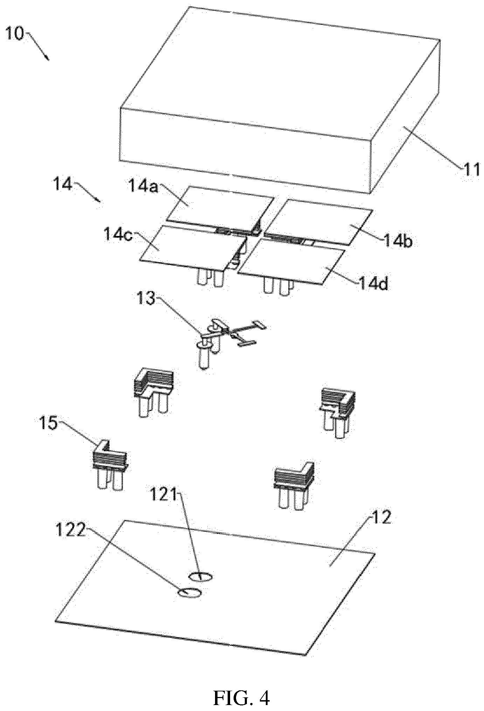

FIG. 4 is an exploded schematic diagram of a part of the antenna structure 10 shown in FIG. 3. The antenna structure 10 includes a chip bodylectric layer 11, a ground layer 12, a feeding element 13, antenna elements 14, and a plurality of matching via groups 15.

The chip bodylectric layer 11 is an LCP (Liquid Crystal Polymer, liquid crystal polymer) chip bodylectric layer 11, may be an FR-4 chip bodylectric layer 11, may be a Rogers (Rogers) chip bodylectric layer 11, may be a hybrid chip bodylectric board of FR-4 and Rogers, or the like. It can be understood that, when the chip bodylectric layer is made of LCP, because a loss tangent of the LCP remains relatively small at a high frequency, the antenna structure may have a relatively small transmission loss, thereby improving antenna radiation efficiency and obtaining a higher antenna gain.

The ground layer 12, the feeding element 13, the antenna elements 14, and the plurality of matching via groups 15 may all be disposed at the chip bodylectric layer 11. It can be understood that the chip bodylectric layer 11 may be configured to support the ground layer 12, the feeding element 13, the antenna elements 14, and the plurality of matching via groups 15, so that the ground layer 12, the feeding element 13, the antenna elements 14, and the plurality of matching via groups 15 form an overall structure.

In an implementation, the chip bodylectric layer 11 may surround or half-surround the ground layer 12, the feeding element 13, the antenna elements 14, and the plurality of matching via groups 15. When the chip bodylectric layer 11 half-surrounds the ground layer 12, the feeding element 13, the antenna elements 14, and the plurality of matching via groups 15, at least a part of the ground layer 12, the feeding element 13, the antenna elements 14, and the plurality of matching via groups 15 may be exposed relative to the chip bodylectric layer 11.

In an implementation, the ground layer 12, the feeding element 13, the antenna elements 14, and the plurality of matching via groups 15 may be disposed on a surface of the chip bodylectric layer 11.

In an embodiment, a structure formed by the ground layer 12, the feeding element 13, the antenna elements 14, and the plurality of matching via groups 15 is a multi-layer structure. In a process of forming the antenna structure 10, the multi-layer structure needs to be formed layer by layer. In a process of forming each layer of the multi-layer structure, a sublayer of the chip bodylectric layer may be correspondingly formed in this embodiment. In this way, after the antenna structure 10 is formed, with the chip bodylectric layer 11, the ground layer 12, the feeding element 13, the antenna elements 14, and the plurality of matching via groups 15 can all be embedded in the chip bodylectric layer 11 just right. Therefore, although the chip bodylectric layer 11 shown in FIG. 4 is an overall structure, the chip bodylectric layer 11 may alternatively be formed by stacking a plurality of sublayers.

In another embodiment, the antenna structure 10 may alternatively not include the chip bodylectric layer 11. In this case, the ground layer 12, the feeding element 13, and the antenna elements 14 may be fastened to each other by using a support or the like.

In another embodiment, the antenna structure 10 may alternatively not include the matching via groups 15.

Refer to FIG. 4 again. The ground layer 12 is configured to provide grounding for the antenna elements 14. The ground layer 12 may be made of a metal material, for example, copper, gold, or silver. A shape of the ground layer 12 may be a square, a rectangle, a circle, or the like. Specifically, the shape of the ground layer 12 is not limited. This embodiment is described by using an example in which the shape of the ground layer 12 is a square.

In addition, the ground layer 12 is provided with a first through hole 121 and a second through hole 122 that are spaced from each other. Both the first through hole 121 and the second through hole 122 penetrate two opposite surfaces of the ground layer 12 (for example, a top surface and a bottom surface of the ground layer 12). The feeding element 13 may be electrically connected to the radio frequency circuit 20 outside the antenna structure 10 through the first through hole 121 and the second through hole 122.

Refer to FIG. 4 again. There may be one or more antenna elements 14. In this implementation, a plurality of antenna elements 14 are used as an example for description. The plurality of antenna elements 14 are arranged in m rows and n columns, where both m and n are positive integers. A gap is formed between two adjacent antenna elements 14. The plurality of antenna elements 14 may form a "1×1" array, a "2×1" array, a "1x2" array, a "2×2" array, a "3×3" array, or the like. This embodiment is described by using an example in which the plurality of antenna elements 14 form a "2×2" array. In this case, there are four antenna elements 14, specifically including a first antenna element 14a, a second antenna element 14b, a third antenna element 14c, and a fourth antenna element 14d.

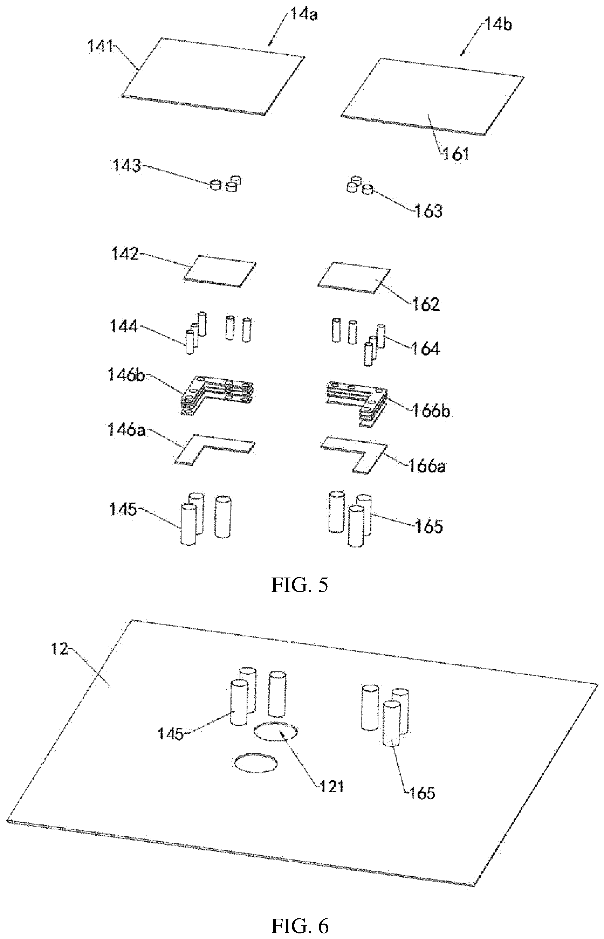

FIG. 5 is an exploded schematic diagram of the first antenna element 14a and the second antenna element 14b shown in FIG. 4. The first antenna element 14a includes a first metal layer 141, a second metal layer 142, first metal columns 143, second metal columns 144, third metal columns 145, a first metal connection sheet 146a, and second metal connection sheets 146b. The first metal columns 143 form a first conducting member in an implementation. The second metal columns 144, the third metal columns 145, the first metal connection sheet 146a, and the second metal connection sheets 146b form a second conducting member in this implementation.

It should be noted that, to avoid lengthy related descriptions below, the first metal layer 141 of the first antenna element 14a, the second metal layer 142 of the first antenna element 14a, the first metal columns 143 of the first antenna element 14a, the second metal columns 144 of the first antenna element 14a, the third metal columns 145 of the first antenna element 14a, the first metal connection sheet 146a of the first antenna element 14a, the second metal connection sheets 146b of the first antenna element 14a, and related descriptions are simplified as the first metal layer 141, the second metal layer 142, the first metal columns 143, the second metal columns 144, the third metal columns 145, the first metal connection sheet 146a, the second metal connection sheets 146b, and related descriptions. In addition, the first metal layer 141, the second metal layer 142, the first metal columns 143, the second metal columns 144, the third metal columns 145, the first metal connection sheet 146a, the second metal connection sheets 146b, and the like are named with a number to distinguish from a first metal layer 161 of the second antenna element 14b, a second metal layer 162 of the second antenna element 14b, first metal columns 163 of the second antenna element 14b, second metal columns 164 of the second antenna element 14b, third metal columns 165 of the second antenna element 14b, a first metal connection sheet 166a of the second antenna element 14b, second metal connection sheets 166b of the second antenna element 14b, and the like below.

FIG. 6 is a schematic diagram of a part of a structure of the antenna structure 10 shown in FIG. 3. The third metal columns 145 are connected to the ground layer 12. For example, there are three third metal columns 145. The three third metal columns 145 may be arranged into an "L" shape, or may be arranged into an arc shape. The three third metal columns 145 are disposed half-round the first through hole 121 on the ground layer 12. In another embodiment, a quantity and an arrangement shape of the third metal columns 145 are not specifically limited.

It should be noted that, a structure of the third metal columns 145 may be formed by forming a layer of metal material on a wall of a via. In this case, the third metal columns 145 have a roughly "tube-like" structure. A structure of the third metal columns 145 may alternatively be formed by filling a metal material in a via. In this case, the third metal columns 145 may be a "column-shaped" structure. In another embodiment, the third metal columns 145 may alternatively be another structure. This is not specifically limited in this embodiment. It can be understood that, for a structure of a metal column (for example, the first metal columns 143 and the second metal columns 144) mentioned below, refer to the structure of the third metal columns 145 in this embodiment. Details are not described below again.

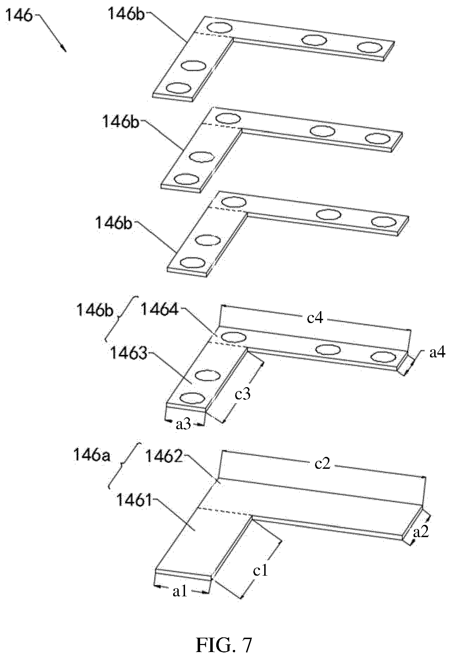

FIG. 7 is a schematic diagram of structures of the first metal connection sheet 146a and the second metal connection sheets 146b of the first antenna element 14a shown in FIG. 5. In this embodiment, there is one first metal connection sheet 146a. In another embodiment, a quantity of first metal connection sheets 146a is not limited.

In addition, the first metal connection sheet 146a includes a first connection part 1461 and a second connection part 1462. The first connection part 1461 is connected to the second connection part 1462, to form a bent shape. For example, the first metal connection sheet 146a has an "L" shape, an arc shape, or the like. It should be noted that, to clearly describe a structure of the first metal connection sheet 146a, in FIG. 7, the first connection part 1461 and the second connection part 1462 are distinguished schematically by using a dashed line.

For example, a width $a1$ of the first connection part 1461 is equal to a width $a2$ of the second connection part 1462. In addition, a length $c2$ of the second connection part 1462 is equal to a sum of a length $c1$ of the first connection part 1461 and the width $a2$ of the second connection part 1462. In another embodiment, a size of each part of the first metal connection sheet 146a is not specifically limited.

Refer to FIG. 7 again. There may be a plurality of second metal connection sheets 146b. For example, there are four second metal connection sheets 146b. In another embodiment, a quantity of second metal connection sheets 146b is not limited.

In addition, one of the second metal connection sheets 146b is used as an example for description. The second metal connection sheet 146b includes a third connection part 1463 and a fourth connection part 1464. The third connection part 1463 is connected to the fourth connection part 1464, to form a bent shape. For example, the second metal connection sheet 146b may have an "L" shape, an arc shape, or the like. It should be noted that, in FIG. 7, the third connection part 1463 and the fourth connection part 1464 are distinguished schematically by using a dashed line.

For example, a width $a3$ of the third connection part 1463 is equal to a width $a4$ of the fourth connection part 1464. The width $a3$ of the third connection part is less than the width $a1$ of the first connection part 1461. The width $a4$ of the fourth connection part 1464 is less than the width $a2$ of the second connection part 1462. In addition, a length c4 of the fourth connection part 1464 is equal to a sum of a length c3 of the third connection part 1463 and the width a4 of the fourth connection part 1464. The length c4 of the fourth connection part 1464 is equal to the length c2 of the second connection part 1462. In another embodiment, a size of each part of the second metal connection sheet 146b is not specifically limited.

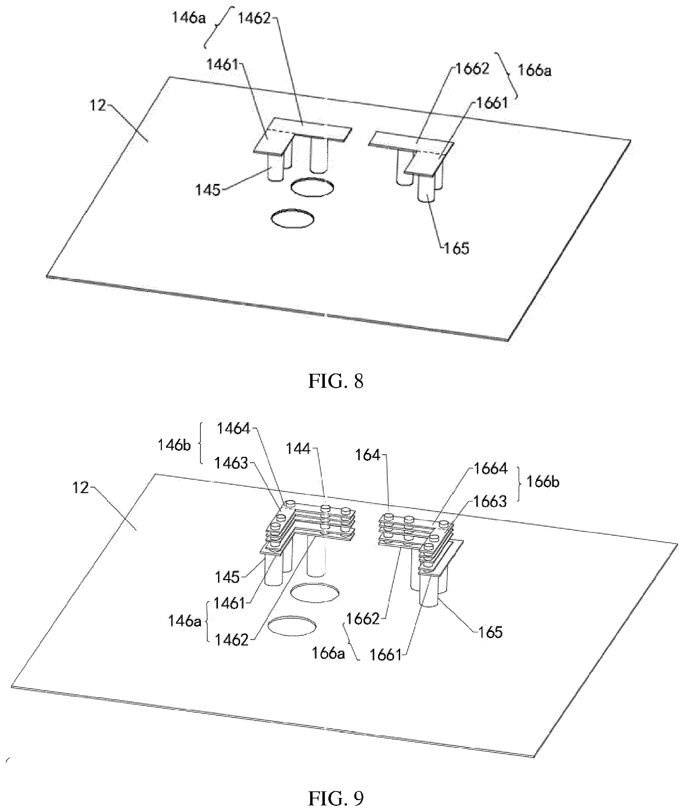

FIG. 8 is a schematic diagram of a part of the structure of the antenna structure 10 shown in FIG. 3. The ground layer 12 and the first metal connection sheet 146a are spaced from and disposed opposite each other, and the first metal connection sheet 146a is connected to end parts that are of the third metal columns 145 and that are farther away from the ground layer 12. In this case, the third metal columns 145 are connected between the ground layer 12 and the first metal connection sheet 146a, and the third metal columns 145, the ground layer 12, and the first metal connection sheet 146a are electrically connected to each other.

For example, one of the third metal columns 145 is connected to the first connection part 1461 of the first metal connection sheet 146a. Two of the third metal columns 145 are connected to the second connection part 1462 of the first metal connection sheet 146a. In addition, the third metal columns 145 may penetrate the first metal connection sheet 146a.

Refer to FIG. 9 with reference to FIG. 8. FIG. 9 is a schematic diagram of a part of the structure of the antenna structure 10 shown in FIG. 3. The plurality of second metal connection sheets 146b are located on a side that is of the first metal connection sheet 146a and that is farther away from the third metal columns 145. The plurality of second metal connection sheets 146b are disposed along a thickness direction of the antenna structure 10 and are spaced from each other. Third connection parts 1463 of the second metal connection sheets 146b are spaced from and disposed opposite each other, and each are spaced from and disposed opposite the first connection part 1461 of the first metal connection sheet 146a. Fourth connection parts 1464 of the second metal connection sheets 146b are spaced from and disposed opposite each other, and each are spaced from and disposed opposite the second connection part 1462 of the first metal connection sheet 146a.

The plurality of second metal columns 144 are spaced from each other, and one end of each of the second metal columns 144 is further connected to the first metal connection sheet 146a. Projections of the plurality of second metal columns 144 on the first metal connection sheet 146a at least partly overlap projections of the plurality of third metal columns 145 on the first metal connection sheet 146a. In addition, the plurality of second metal columns 144 are further connected to the plurality of second metal connection sheets 146b. The second metal connection sheets 146b, the second metal columns 144, the first metal connection sheet 146a, the third metal columns 145, and the ground layer 12 are electrically connected to each other.

For example, the plurality of second metal columns 14 may be arranged into an "L" shape, or may be arranged into an arc shape.

For example, each of the second metal columns 144 may penetrate each of the second metal connection sheets 146b. In this case, the second metal columns 144 and the second metal connection sheets 146b are connected to each other more stably. In another implementation, each of the second metal columns 144 may not penetrate each of the second metal connection sheets 146b. In this case, the second metal columns 144 are disposed between every two second metal connection sheets 146b, and the second metal columns 144 are disposed between the second metal connection sheets 146b and the first metal connection sheet 146a, so that the second metal connection sheets 146b, the second metal columns 144, and the first metal connection sheet 146a are electrically connected to each other.

In this embodiment, a diameter of the second metal column 144 is less than a diameter of the third metal column 145. It can be understood that, when the diameter of the second metal column 144 is smaller, a thickness of a chip bodylectric layer surrounding the second metal columns 144 may be made small. When the diameter of the third metal column 145 is larger, a thickness of a chip bodylectric layer surrounding the third metal columns 145 may be made large. In this way, in a forming process of the antenna structure 10, the two chip bodylectric boards (one chip bodylectric board is provided with the second metal columns 144, and the other chip bodylectric board is provided with the third metal columns 145) of different thicknesses may be stacked up into a whole by bonding, welding, or the like.

In addition, when the diameter of the second metal column 144 is less than the diameter of the third metal column 145, the width a3 of the third connection part is set to less than the width a1 of the first connection part 1461, and the width a4 of the fourth connection part 1464 is set to less than the width a2 of the second connection part 1462, so that there is enough room on the first connection part 1461 and the second connection part 1462 for a connection to the third metal columns 145, and high connection stability is ensured.

In another embodiment, the first antenna element 14a may not include the third metal columns 145 and the first metal connection sheet 146a. In this case, the second metal columns 144 may be directly connected to the ground layer 12.

In another embodiment, the first antenna element 14a may not include the second metal connection sheets 146b.

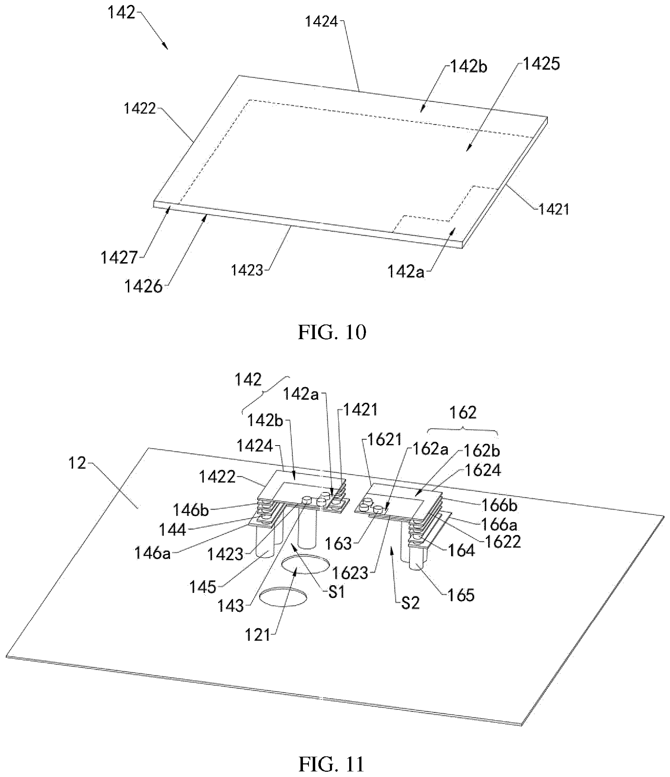

FIG. 10 is a schematic diagram of a structure of the second metal sheet 142 of the first antenna element 14a shown in FIG. 5. The second metal layer 142 includes a top surface 1425 and a bottom surface 1426 that are disposed opposite each other, and a lateral surface 1427 that connects the top surface 1425 and the bottom surface 1426. Because a thickness of the first metal layer 141 in embodiments is smaller than a length and a width of the first metal layer 141, a distance between the top surface 1425 of the first metal layer 141 and the bottom surface 1426 of the first metal layer 141 is small. The top surface 1425 of the first metal layer 141 and the bottom surface 1426 of the first metal layer 141 have a roughly same structure. In this way, this embodiment can be described by using the top surface 1425 of the first metal layer 141 as an example. In addition, because the thickness of the first metal layer 141 is relatively small, a structure of the first metal layer 141 is slightly affected by a structure of the lateral surface 1427 of the first metal layer 141. Therefore, as the structure of the top surface 1425 of the first metal layer 141 is described, a three-dimensional structure of the first metal layer 141 may be further roughly reflected.

A shape of the second metal layer 142 may be a square, a rectangle, a circle, or the like. This embodiment is described by using an example in which the shape of the second metal layer 142 is a square. Specifically, the second metal layer 142 includes a first edge 1421 and a second edge 1422 that are disposed opposite each other, and a third edge 1423 and a fourth edge 1424 that are disposed opposite each other. The third edge 1423 and the fourth edge 1424 are connected between the first edge 1421 and the second edge 1422. Because the second metal layer 142 is a square, lengths of the first edge 1421, the second edge 1422, the third edge 1423, and the fourth edge 1424 of the second metal layer 142 are all equal. For example, a length b1 of the edges of the second metal layer 142 is equal to the length c4 of the second connection part 1464 of the second metal connection sheet 146b (refer to FIG. 7).

In this embodiment, the second metal layer 142 includes a first area 142a and a second area 142b that are spaced from each other. In FIG. 10, the first area 142a and the second area 142b are distinguished schematically by using a dashed line. For example, the first area 142a and the second area 142b may each have an "L" shape. The first area 142a is disposed near the first edge 1421 and the third edge 1423. The second area 142b is disposed near the second edge 1422 and the fourth edge 1424. In another embodiment, shapes of the first area 142a and the second area 142b are not specifically limited.

Refer to FIG. 11 with reference to FIG. 9 and FIG. 10. FIG. 11 is a schematic diagram of a part of the structure of the antenna structure 10 shown in FIG. 3. The second metal layer 142 and the second metal connection sheets 146b are spaced from and disposed opposite each other. One end of each of the second metal columns 144 is connected to the second area 142b of the second metal layer 142. In this case, each of the second metal columns 14 is connected between the second area 142b of the second metal layer 142 and the first metal connection sheet 146a. A part of the second metal columns 144 are disposed near the second edge 1422 of the second metal layer 142, and a part of the second metal columns 144 are disposed near the fourth edge 1424 of the second metal layer 142.

In this implementation, the second metal layer 142, the second metal columns 144, the third metal columns 145, the first metal connection sheet 146a, the second metal connection sheets 146b, and the ground layer 12 circle up to form a first space S1. It can be understood that another component of the antenna structure 10 may be disposed in the first space S1. In this way, on one hand, space utilization of the antenna structure 10 is high. On the other hand, the antenna structure 10 may be compactly disposed, to facilitate miniaturization of the antenna structure 10.

For example, the first through hole 121 on the ground layer 12 is interconnected to the first space S1.

In addition, one end of each of the first metal columns 143 is connected to the first area 142a of the second metal layer 142. For example, there are three first metal columns 143. The three first metal columns 143 may be arranged into an "L" shape, or may be arranged into an arc shape.

It can be understood that, as the second metal columns 144 are connected to the second area 142b of the second metal layer 142, and the first metal columns 143 are connected to the first area 142a of the second metal layer 142, in this case, the first metal columns 143 and the second metal columns 144 are spaced from each other in two areas of the second metal layer 142. To be specific, projections of the first metal columns 143 on the second metal layer 142 do not overlap projections of the second metal columns 144 on the second metal layer 142. In addition, the first metal columns 143, the second metal layer 142, the second metal columns 144, the third metal columns 145, the first metal connection sheet 146a, the second metal connection sheets 146b, and the ground layer 12 are electrically connected to each other.

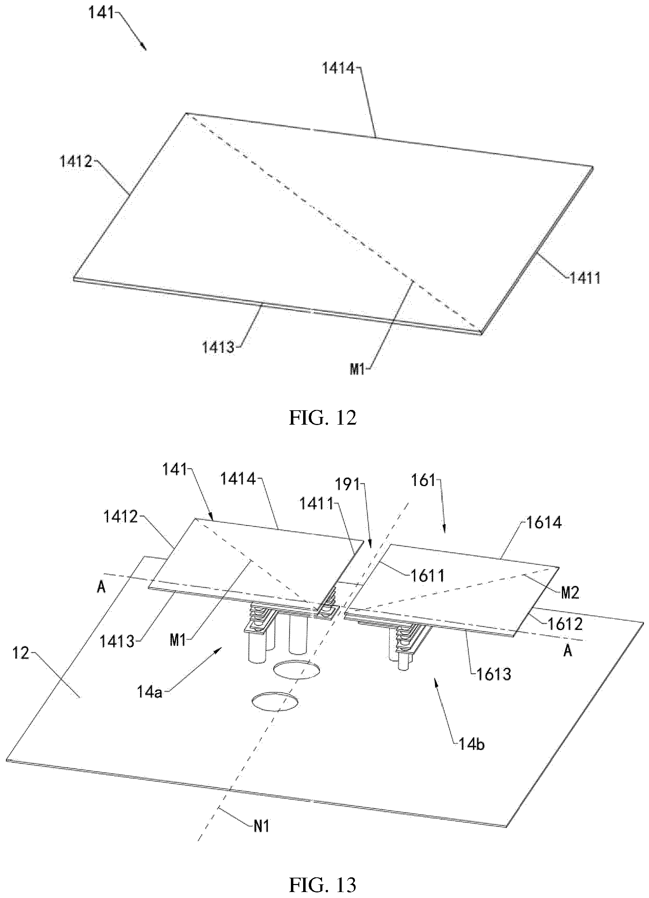

FIG. 12 is a schematic diagram of a structure of the first metal sheet 141 of the first antenna element 14a shown in FIG. 5. A shape of the first metal layer 141 may be a square, a rectangle, a circle, or the like. This embodiment is described by using an example in which the shape of the first metal layer 141 is a square. Specifically, the first metal layer 141 includes a first edge 1411 and a second edge 1412 that are disposed opposite each other, and a third edge 1413 and a fourth edge 1414 that are disposed opposite each other. The third edge 1413 and the fourth edge 1414 are connected between the first edge 1411 and the second edge 1412. Because the first metal layer 141 is a square, lengths of the first edge 1411, the second edge 1412, the third edge 1413, and the fourth edge 1414 of the first metal layer 141 are all equal. For example, the length of the edge of the first metal layer 141 is in the range of $0.25\lambda0$ to $0.35\lambda0$. In this embodiment, a size of the first metal layer 141 is greater than a size of the second metal layer 142.

In addition, there is a diagonal line M1 of the first metal layer 141. One end of the diagonal line M1 is located at a joint between the first edge 1411 and the third edge 1413, and the other end is located at a joint between the second edge 1412 and the fourth edge 1414. It should be noted that the diagonal line M1 is not an actual structure on the first metal layer 141. The diagonal line M1 is a virtual line. FIG. 12 shows the diagonal line M1 represented by a dashed line.

Refer to FIG. 13 with reference to FIG. 11 and FIG. 12. FIG. 13 is a schematic diagram of a part of the structure of the antenna structure 10 shown in FIG. 3. The first metal layer 141 and the second metal layer 142 are spaced from and disposed opposite each other. The first metal layer 141 is fastened to end parts of the first metal columns 143. The first metal columns 143 are connected between the first metal layer 141 and the first area 142a of the second metal layer 142. The first metal layer 141 is electrically connected to the first metal columns 143. In addition, a projection of the second metal layer 142 on a plane, on which the first metal layer 141 is located, is located in the first metal layer 141. A projection of the first metal layer 141 on the ground layer 12 is located in the ground layer 12.

For example, the first edge 1411 of the first metal layer 141 is disposed opposite the first edge 1421 of the second metal layer 142. In other words, a projection of the first edge 1421 of the second metal layer 142 on the first metal layer 141 overlaps the first edge 1411 of the first metal layer 141. The third edge 1413 of the first metal layer 141 is disposed opposite the third edge 1423 of the second metal layer 142. In other words, a projection of the third edge 1423 of the second metal layer 142 on the first metal layer 141 overlaps the third edge 1413 of the first metal layer 141.

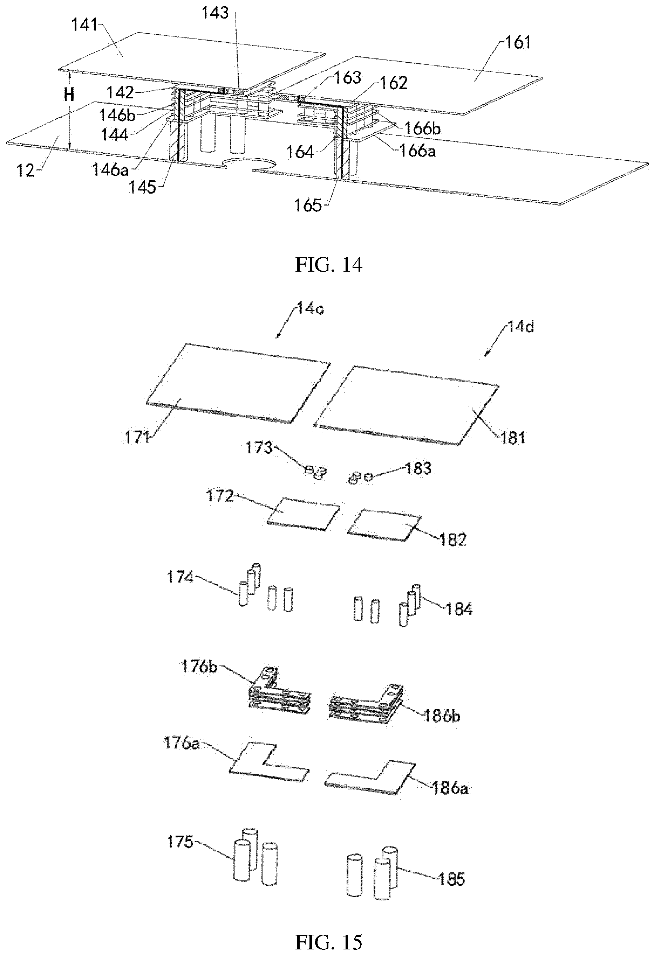

FIG. 14 is a schematic cross-sectional diagram of a part of the antenna structure 10 shown in FIG. 13 cut along a line A-A. As the first metal columns 143 and the second metal columns 144 are spaced from each other in two areas of the second metal layer 142, when the first antenna element 14a is in a working state, a current path (simply represented by thick lines in FIG. 14) includes the ground layer 12, the third metal columns 145, the first metal connection sheet 146a, the second metal columns 144, the second area 142b (refer to FIG. 11) of the second metal layer 142, and the first area 142a (refer to FIG. 11) of the second metal layer 142, the first metal columns 143, and the first metal layer 141. Because a current may be transmitted between the first area 142a and the second area 142b of the second metal layer 142, the current path is disposed as bent once. Compared with an antenna structure that has a same current path, where the current path of the antenna structure is straight, a cross-sectional height H of the antenna structure 10 in this embodiment is smaller, to facilitate achieving thinness of the antenna structure 10.

For example, when a length of the current path (to be specific, an electrical length is equal to a sum of the cross-sectional height H of the antenna structure 10 and the length of the edge of the second metal layer 142) is in the range of $0.25\lambda0$ to $0.32\lambda0$, the cross-sectional height H of the antenna structure 10 may be in the range of $0.15\lambda0$ to $0.21\lambda0$. In this way, the cross-sectional height H of the antenna structure 10 in this implementation is greatly reduced from another cross-sectional height of the antenna structure 10.

For example, the first antenna element 14a may be a symmetric structure, a partly symmetric structure, a structure having same or similar parts, or a structure having different parts. In this embodiment, the first antenna element 14a is a symmetric structure. Specifically, refer to FIG. 13 again. The first antenna element 14a is symmetrical along a symmetry plane of the first antenna element 14a. The symmetry plane of the first antenna element 14a is perpendicular to the plane on which the first metal layer 141 is located, and the diagonal line M1 of the first metal layer 141 is located on the symmetry plane of the first antenna element 14a.

Refer to FIG. 5 again. The second antenna element 14b includes a first metal layer 161, a second metal layer 162, first metal columns 163, second metal columns 164, third metal columns 165, a first metal connection sheet 166a, and second metal connection sheets 166b. For structures of the first metal layer 161, the second metal layer 162, the first metal columns 163, the second metal columns 164, the third metal columns 165, the first metal connection sheet 166a, and the second metal connection sheets 166b, refer to structures of the first metal layer 141, the second metal layer 142, the first metal columns 143, the second metal columns 144, the third metal columns 145, the first metal connection sheet 146a, and the second metal connection sheets 146b of the first antenna element 14a. Details are not described herein again.

In another embodiment, the second antenna element 14b may not include the third metal columns 165, the first metal connection sheet 166a, and the second metal connection sheets 166b.

Refer to FIG. 6 again. The third metal columns 165 are connected to the ground layer 12. The third metal columns 165 of the second antenna element 14b are located on one side of the third metal columns 145 of the first antenna element 14a. For example, there are three third metal columns 165. The three third metal columns 165 are arranged into an "L" shape, or into an arc shape. In another embodiment, a quantity of third metal columns 165 is not specifically limited.

Refer to FIG. 8 again. The first metal connection sheet 166a is connected to end parts that are of the third metal columns 165 and that are farther away from the ground layer 12. In this case, the third metal columns 165 are connected between the first metal connection sheet 166a and the ground layer 12, and the third metal columns 165, the first metal connection sheet 166a, and the ground layer 12 are electrically connected to each other.

In addition, a first connection part 1661 of the first metal connection sheet 166a of the second antenna element 14b is disposed opposite the first connection part 1461 of the first metal connection sheet 146a of the first antenna element 14a. A second connection part 1662 of the first metal connection sheet 166a of the second antenna element 14b is disposed opposite the second connection part 1642 of the first metal connection sheet 146a of the first antenna element 14a.

For example, one of the third metal columns 165 is connected to the first connection part 1661 of the first metal connection sheet 166a. Two of the third metal columns 165 are connected to the second connection part 1662 of the first metal connection sheet 166a.

Refer to FIG. 9 with reference to FIG. 8. The plurality of second metal connection sheets 166b are located on a side that is of the first metal connection sheet 166a and that is farther away from the third metal columns 165. The plurality of second metal connection sheets 166b are disposed along the thickness direction of the antenna structure 10 and are spaced from each other. Third connection parts 1663 of the second metal connection sheets 166b are spaced from and disposed opposite each other, and each are spaced from and disposed opposite the first connection part 1661 of the first metal connection sheet 166a. Fourth connection parts 1664 of the second metal connection sheets 166b are spaced from and disposed opposite each other, and each are spaced from and disposed opposite the second connection part 1662 of the first metal connection sheet 166a.

In addition, the plurality of second metal columns 164 are spaced from each other, and one end of each of the second metal columns 164 is further connected to the first metal connection sheet 166a. Projections of the plurality of second metal columns 164 on the first metal connection sheet 166a at least partly overlap projections of the plurality of third metal columns 165 on the first metal connection sheet 166a. The plurality of second metal columns 164 are further connected to the plurality of second metal connection sheets 166b. In this case, the second metal connection sheets 166b, the second metal columns 164, the first metal connection sheet 166a, the third metal columns 165, and the ground layer 12 are electrically connected to each other.

For example, each of the second metal columns 164 may penetrate each of the second metal connection sheets 166b. In this case, the second metal columns 164 and the second metal connection sheets 166b are connected to each other more stably. In another implementation, each of the second metal columns 164 may not penetrate each of the second metal connection sheets 166b. In this case, the second metal columns 164 are disposed between every two second metal connection sheets 166b, and the second metal columns 164 are disposed between the second metal connection sheets 166b and the first metal connection sheet 166a, so that the second metal connection sheets 166b, the second metal columns 164, and the first metal connection sheet 166a are electrically connected to each other.

In another embodiment, when the second antenna element 14b does not include the third metal columns 165 and the first metal connection sheet 166a, the second metal columns 164 may be directly connected to the ground layer 12.

Refer to FIG. 11 again with reference to FIG. 9 and FIG. 10. The second metal layer 162 is fastened to end parts of the plurality of second metal columns 164. A first edge 1621 of the second metal layer 162 of the second antenna element 14b and the first edge 1421 of the second metal layer 142 of the first antenna element 14a are spaced from each other.

One end of each of the second metal columns 164 is connected to a second area 162b of the second metal layer 162. In this case, a part of the second metal columns 164 are disposed near a second edge 1622 of the second metal layer 162. A part of the second metal columns 144 are disposed near a fourth edge 1624 of the second metal layer 162.

It can be understood that the second metal layer 162, the second metal columns 164, the third metal columns 165, the first metal connection sheet 166a, the second metal connection sheets 166b, and the ground layer 12 circle up to form a second space S2. The second space S2 is interconnected to the first space S1. It can be understood that another component of the antenna structure 10 may be disposed in the second space S2. In this way, on one hand, space utilization of the antenna structure 10 is high. On the other hand, the antenna structure 10 may be compactly disposed, to facilitate miniaturization of the antenna structure 10.

In addition, one end of each of the first metal columns 163 is connected to a first area 162a of the second metal layer 162. For example, there are three first metal columns 163. The three first metal columns 163 are arranged into an "L" shape.

It can be understood that, as the second metal columns 164 are connected to the second area 162b of the second metal layer 162, and the first metal columns 163 are connected to the first area 162a of the second metal layer 162, in this case, the first metal columns 163 and the second metal columns 164 are spaced from each other in two areas of the second metal layer 162. To be specific, projections of the first metal columns 163 on the second metal layer 162 do not overlap projections of the second metal columns 164 on the second metal layer 162. In addition, the first metal columns 163, the second metal layer 162, the second metal columns 164, the third metal columns 165, the first metal connection sheet 166a, the second metal connection sheets 166b, and the ground layer 12 are electrically connected to each other.

Refer to FIG. 13 with reference to FIG. 11. The first metal layer 161 and the second metal layer 162 are spaced from and disposed opposite each other. The first metal layer 161 is fastened to end parts of the first metal columns 163. In this case, the first metal layer 161 is electrically connected to the first metal columns 163. A projection of the second metal layer 162 on a plane, on which the first metal layer 161 is located, is located in the first metal layer 161. A projection of the first metal layer 161 on the ground layer 12 is located in the ground layer 12.

In this embodiment, a first edge 1611 of the first metal layer 161 of the second antenna element 14b and the first edge 1411 of the first metal layer 141 of the first antenna element 14a form a first gap 191. A projection of the first gap 191 on the ground layer 12 is located in the ground layer 12.

For example, a projection of the first edge 1621 of the second metal layer 162 on the first metal layer 161 overlaps the first edge 1611 of the first metal layer 161. A projection of a third edge 1623 of the second metal layer 162 on the first metal layer 161 overlaps a third edge 1613 of the first metal layer 161.

Refer to FIG. 14 again. As the first metal columns 163 and the second metal columns 164 are spaced from each other in two areas of the second metal layer 162, when the second antenna element 14b is in a working state, a current path (simply represented by thick lines in FIG. 14) includes the ground layer 12, the third metal columns 165, the first metal connection sheet 166a, the second metal columns 164, and the second area 162b (refer to FIG. 11) of the second metal layer 162, the first area 162a (refer to FIG. 11) of the second metal layer 162, the first metal columns 163, and the first metal layer 161. Because the current may be transmitted between the first area 162a and the second area 162b of the second metal layer 162, the current path is disposed as bent once. In this way, compared with an antenna structure that has a same current path, where the current path of the antenna structure is straight, a cross-sectional height H of the antenna structure 10 in this embodiment is smaller, to facilitate achieving thinness of the antenna structure 10.

For example, the second antenna element 14b may be a symmetric structure, a partly symmetric structure, a structure having same or similar parts, or a structure having different parts. In this embodiment, the second antenna element 14b is a symmetric structure. Specifically, refer to FIG. 13 again. The second antenna element 14b is symmetrical along a symmetry plane of the second antenna element 14b. The symmetry plane of the second antenna element 14b is perpendicular to the plane on which the first metal layer 161 is located, and a diagonal line M2 of the first metal layer 161 is located on the symmetry plane of the second antenna element 14b. One end of the diagonal line M2 of the first metal layer 161 is located at a joint between the first edge 1611 and the third edge 1613, and the other end is located at a joint between a second edge 1612 and a fourth edge 1614.

For example, the second antenna element 14b and the first antenna element 14a may be symmetrical, partly symmetrical, have a same or similar structure, or have different structures. In embodiments, the second antenna element 14b and the first antenna element 14a form a symmetric structure. Specifically, the second antenna element 14b and the first antenna element 14a are symmetrical along a first symmetry plane N1. It should be noted that the first symmetry plane N1 is not an actual structure on the antenna structure 10. The first symmetry plane N1 is a virtual plane. In FIG. 13, the first symmetry plane N1 is represented schematically by a dashed line.

FIG. 15 is an exploded schematic diagram of the third antenna element 14c and the fourth antenna element 14d shown in FIG. 4. The third antenna element 14c includes a first metal layer 171, a second metal layer 172, first metal columns 173, second metal columns 174, third metal columns 175, a first metal connection sheet 176a, and second metal connection sheets 176b. For structures of the first metal layer 171, the second metal layer 172, the first metal columns 173, the second metal columns 174, the third metal columns 175, the first metal connection sheet 176a, and the second metal connection sheets 176b, refer to structures of the first metal layer 141, the second metal layer 142, the first metal columns 143, the second metal columns 144, the third metal columns 145, the first metal connection sheet 146a, and the second metal connection sheets 146b of the first antenna element 14a. Details are not described herein again.

In another embodiment, the third antenna element 14c may not include the third metal columns 175, the first metal connection sheet 176a, and the second metal connection sheets 176b.

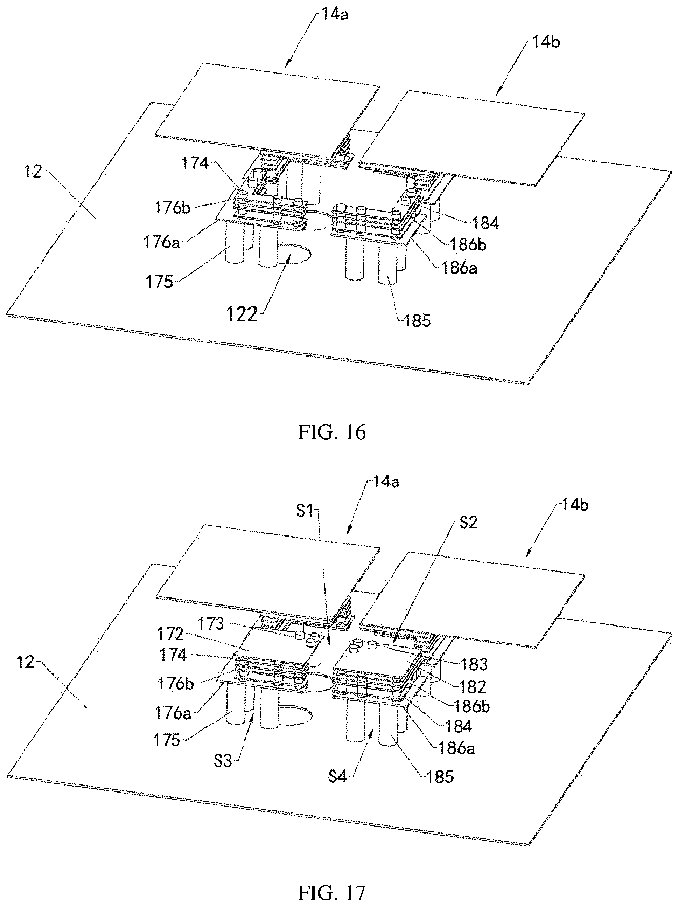

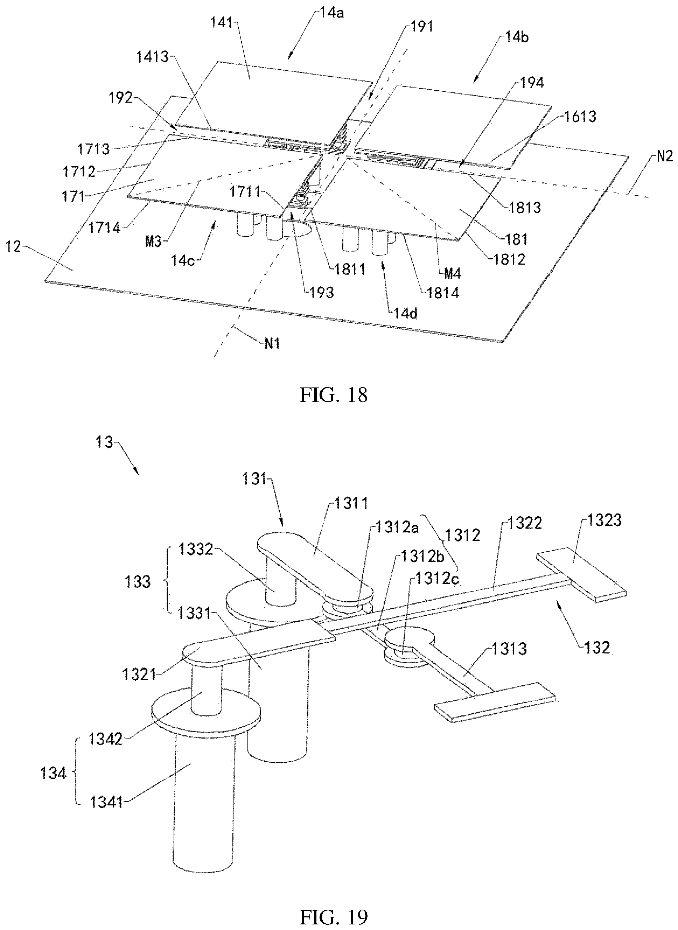

Refer to FIG. 16 to FIG. 18. FIG. 16 is a schematic diagram of a part of the structure of the antenna structure 10 shown in FIG. 3. FIG. 17 is a schematic diagram of a part of the structure of the antenna structure 10 shown in FIG. 3. FIG. 18 is a schematic diagram of the structure of the antenna structure 10 shown in FIG. 3. For a manner of disposing the first metal layer 171, the second metal layer 172, the first metal columns 173, the second metal columns 174, the third metal columns 175, the first metal connection sheet 176a, and the second metal connection sheets 176b of the third antenna element 14c, refer to the manner of disposing the first metal layer 141, the second metal layer 142, the first metal columns 143, the second metal columns 144, the third metal columns 145, the first metal connection sheet 146a, and the second metal connection sheets 146b of the first antenna element 14a. Details are not described herein again.

The third antenna element 14c is located on one side of the first antenna element 14a. The third antenna element 14c and the first antenna element 14a are disposed opposite and spaced from each other. In this case, the first antenna element 14a is located between the second antenna element 14b and the third antenna element 14c.

In addition, a third edge 1713 of the first metal layer 171 of the third antenna element 14c and the third edge 1413 of the first metal layer 141 of the first antenna element 14a form a second gap 192. The second gap 192 is interconnected to the first gap 191.

In this implementation, the second metal layer 172, the second metal columns 174, the third metal columns 175, the first metal connection sheet 176a, the second metal connection sheets 176b, and the ground layer 12 of the third antenna element 14c may circle up to form a third space S3. The third space S3 is interconnected to the first space S1 and the second space S2. It can be understood that another component of the antenna structure 10 may be disposed in the third space S3. In this way, on one hand, space utilization of the antenna structure 10 is high. On the other hand, the antenna structure 10 may be compactly disposed, to facilitate miniaturization of the antenna structure 10.

For example, the second through hole 122 on the ground layer 12 is interconnected to the third space S3.

In addition, in this implementation, the first metal columns 173 and the second metal columns 174 of the third antenna element 14c may also be spaced from each other in two areas of the second metal layer 172, so that a current path is disposed as bent once. In this way, compared with an antenna structure that has a same current path, where the current path of the antenna structure is straight, a cross-sectional height of the antenna structure 10 in this embodiment is smaller, to facilitate achieving thinness of the antenna structure 10.

For example, the third antenna element 14c may be a symmetric structure, a partly symmetric structure, a structure having same or similar parts, or a structure having different parts. In this embodiment, the third antenna element 14c is a symmetric structure. Specifically, refer to FIG. 18 again. The third antenna element 14c is symmetrical along a symmetry plane of the third antenna element 14c. The symmetry plane of the third antenna element 14c is perpendicular to a plane on which the first metal layer 171 is located, and a diagonal line M3 of the first metal layer 171 is located on the symmetry plane of the third antenna element 14c. One end of the diagonal line M3 of the first metal layer 171 is located at a joint between a first edge 1711 and a third edge 1713, and the other end is located at a joint between the second edge 1712 and a fourth edge 1714.

For example, the third antenna element 14c and the first antenna element 14a may be symmetrical, partly symmetrical, have a same or similar structure, or have different structures. In this embodiment, the third antenna element 14c and the first antenna element 14a form a symmetric structure. Specifically, the third antenna element 14c and the first antenna element 14a are symmetrical along a second symmetry plane N2. It should be noted that the second symmetry plane N2 is not an actual structure on the antenna structure 10. The second symmetry plane N2 is a virtual plane. In FIG. 18, the second symmetry plane N2 is represented schematically by a dashed line.

Refer to FIG. 15 again. The fourth antenna element 14d includes a first metal layer 181, a second metal layer 182, first metal columns 183, second metal columns 184, third metal columns 185, a first metal connection sheet 186a, and second metal connection sheets 186b. For structures of the first metal layer 181, the second metal layer 182, the first metal columns 183, the second metal columns 184, the third metal columns 185, the first metal connection sheet 186a, and the second metal connection sheets 186b, refer to structures of the first metal layer 141, the second metal layer 142, the first metal columns 143, the second metal columns 144, the third metal columns 145, the first metal connection sheet 146a, and the second metal connection sheets 146b of the first antenna element 14a. Details are not described herein again.

The fourth antenna element 14d is located on a side that is of the third antenna element 14c and that is closer to the second antenna element 14b. The fourth antenna element 14d is disposed opposite and spaced from the third antenna element 14c, and is disposed opposite and spaced from the second antenna element 14b. In this case, the fourth antenna element 14d is located between the third antenna element 14c and the second antenna element 14b.

In addition, a first edge 1811 of the first metal layer 181 of the fourth antenna element 14d and the first edge 1711 of the first metal layer 171 of the third antenna element 14c form a third gap 193.

In addition, a third edge 1813 of the first metal layer 181 of the fourth antenna element 14d and the third edge 1613 of the first metal layer 161 of the second antenna element 14b form a fourth gap 194. The fourth gap 194 is interconnected to the first gap 191, the second gap 192, and the third gap 193. In this case, the first gap 191, the second gap 192, the third gap 193, and the fourth gap 194 roughly form a "cruciform" shape.

In this implementation, the second metal layer 182, the second metal columns 184, the third metal columns 185, the first metal connection sheet 186a, the second metal connection sheets 186b, and the ground layer 12 of the fourth antenna element 14d circle up to form a fourth space S4. The fourth space S4 is interconnected to the first space S1, the second space S2, and the third space S3. To be specific, the first space S1, the second space S2, the third space S3, and the fourth space S4 circle up to form a large space. It can be understood that another component of the antenna structure 10 may be disposed in the fourth space S4. In this way, on one hand, space utilization of the antenna structure 10 is high. On the other hand, the antenna structure 10 may be compactly disposed, to facilitate miniaturization of the antenna structure 10.

In addition, in this implementation, the first metal columns 183 and the second metal columns 184 of the fourth antenna element 14d may also be spaced from each other in two areas of the second metal layer 182, so that the current path is disposed as bent once. In this way, compared with an antenna structure that has a same current path, where the current path of the antenna structure is straight, a cross-sectional height of the antenna structure 10 in this embodiment is smaller, to facilitate achieving thinness of the antenna structure 10.

For example, the fourth antenna element 14d may be a symmetric structure, a partly symmetric structure, a structure having same or similar parts, or a structure having different parts. In this embodiment, the fourth antenna element 14d is a symmetric structure. Specifically, refer to FIG. 18 again. The fourth antenna element 14d is symmetrical along a symmetry plane of the fourth antenna element 14d. The symmetry plane of the fourth antenna element 14d is perpendicular to a plane on which the first metal layer 181 is located, and a diagonal line M4 of the first metal layer 181 is located on the symmetry plane of the fourth antenna element 14d. One end of the diagonal line M4 of the first metal layer 181 is located at a joint between the first edge 1811 and the third edge 1813, and the other end is located at a joint between a second edge 1812 and a fourth edge 1814.

For example, the fourth antenna element 14d and the third antenna element 14c may be symmetrical, partly symmetrical, have a same or similar structure, or have different structures. In this embodiment, the fourth antenna element 14d and the third antenna element 14c form a symmetric structure. Specifically, the fourth antenna element 14d and the third antenna element 14c are also symmetrical along the first symmetry plane N1.

For example, the fourth antenna element 14d and the second antenna element 14b may be symmetrical, or partly symmetrical, have a same or similar structure, or have different structures. In this embodiment, the fourth antenna element 14d and the second antenna element 14b form a symmetric structure. Specifically, the fourth antenna element 14d and the second antenna element 14b are symmetrical along the second symmetry plane N2.

For example, the first antenna element 14a, the second antenna element 14b, the third antenna element 14c, and the fourth antenna element 14d may be centrosymmetric, partly centrosymmetric, have a same or similar structure, or have different structures. In this embodiment, the first antenna element 14a, the second antenna element 14b, the third antenna element 14c, and the fourth antenna element 14d are centrosymmetric with respect to a central point. The central point is located at a joint between the first symmetry plane N1 and the second symmetry plane N2. The central point is a central location of the first antenna element 14a, the second antenna element 14b, the third antenna element 14c, and the fourth antenna element 14d. In this implementation, the symmetry plane of the first antenna element 14a, the symmetry plane of the second antenna element 14b, the symmetry plane of the third antenna element 14c, and the symmetry plane of the fourth antenna element 14d all pass through the central point. With reference to FIG. 11, the second metal columns 144 of the first antenna element 14a are located on a side that is of the first metal columns 143 of the first antenna element 14a and that is farther away from the central point. The second metal columns 164 of the second antenna element 14b are located on a side that is of the first metal columns 163 of the second antenna element 14b that is farther away from the central point. With reference to FIG. 17, the second metal columns 174 of the third antenna element 14c are located on a side that is of the first metal columns 163 of the third antenna element 14c and that is farther away from the central point. The second metal columns 184 of the fourth antenna element 14d are located on a side that is of the first metal columns 183 of the fourth antenna element 14d and that is farther away from the central point.

In this embodiment, the first space S1, the second space S2, the third space S3, and the fourth space S4 are formed in the antenna structure 10 by compactly disposing various parts of structures of the antenna elements 14. It can be understood that other components of the antenna structure 10 may be disposed in the first space S1, the second space S2, the third space S3, and the fourth space S4. In this way, on one hand, space utilization of the antenna structure 10 is high. On the other hand, the structure of the antenna structure 10 is compact, to facilitate miniaturization of the antenna structure 10. In addition, a current path of the antenna structure 10 is set to bent once. In this way, compared with an antenna structure that has a same current path, where the current path of the antenna structure is straight, not only a cross-sectional height H of the antenna structure 10 in this embodiment is smaller, widths of the first gap 191, the second gap 192, the third gap 193, and the fourth gap 194 in the antenna structure 10 are also smaller. For example, widths of the first gap 191, the second gap 192, the third gap 193, and the fourth gap 194 each may be in the range of $0.03\lambda0$ to $0.1\lambda0$. In this way, miniaturization of the antenna structure 10 is easier to achieve.

The first antenna element 14a, the second antenna element 14b, the third antenna element 14c, and the fourth antenna element 14d in the antenna structure 10 are described in detail with reference to the related accompanying drawings. In this implementation, the first antenna element 14a and the fourth antenna element 14d may form an electric dipole. The second antenna element 14b and the third antenna element 14c may form another electric dipole. In addition, the first gap 191 and the third gap 193 may form a magnetic dipole. The second gap 192 and the fourth gap 194 may form another magnetic dipole. The feeding element 13 of the antenna structure 10 is described below with reference to related accompanying drawings.

FIG. 19 is a schematic diagram of a structure of the feeding element shown in FIG. 4. The feeding element 13 includes a first feeding branch 131, a second feeding branch 132, a first metal hole 133, and a second metal hole 134. A structure of the first metal hole 133 may be formed by forming a layer of metal material on a wall of a via. In this case, the first metal hole 133 has a roughly "tube-like" structure. In addition, a structure of the first metal hole 133 may alternatively be formed by filling a metal material in a via. In this case, the first metal hole 133 may be of a "columnar" structure. In another implementation, the first metal hole 133 may alternatively be another structure. In addition, for a structure of the second metal hole 134, refer to the structure of the first metal hole 133 in this implementation. Details are not described below again.

The first feeding branch 131 includes a first part 1311, a second part 1312a, a third part 1312b, a fourth part 1312c, and a fifth part 1313 that are sequentially connected. The first part 1311 and the fifth part 1313 are disposed in a same layer. The second part 1312a, the third part 1312b, and the fourth part 1312c roughly form a "U" shape. For example, the second part 1312a and the fourth part 1312c may each use a metal hole structure. In this case, two ends of the third part 1312b are respectively connected to the first part 1311 and the fifth part 1313 by using one metal hole structure for each.

For example, the fifth part 1313 may have a "T" shape.

It can be understood that, in this implementation, a resonance frequency of the antenna structure 10 may be changed by changing factors such as shapes or sizes of the first part 1311, the second part 1312a, the third part 1312b, the fourth part 1312c, and the fifth part 1313 of the first feeding branch 131.

Refer to FIG. 19 again. The first metal hole 133 includes a first hole part 1331 and a second hole part 1332. The second hole part 1332 is connected to the first hole part 1331. A diameter of the first hole part 1331 is greater than a diameter of the second hole part 1332. It can be understood that, in a forming process of the first metal hole, two chip bodylectric boards (one chip bodylectric board is provided with the first hole part 1331, and the other chip bodylectric board is provided with the second hole part 1332) of different thicknesses may be stacked up into a whole by bonding, welding, or the like.

The second hole part 1332 is connected to the first part 1311 of the first feeding branch 131.

Refer to FIG. 19 again. The second feeding branch 132 generally has a roughly "bar-like" shape. The second feeding branch 132 includes a first part 1321, a second part 1322, and a third part 1323 that are sequentially connected. The first part 1321, the second part 1322, and the third part 1323 are disposed in a same layer.

For example, a width of the first part 1321 is greater than a width of the second part 1322. A width of the third part 1323 is greater than the width of the first part 1321 and the width of the second part 1322. The second part 1322 and the third part 1323 roughly form a "T" shape.

It can be understood that, in this implementation, the resonance frequency of the antenna structure 10 may be changed by changing factors such as shapes or sizes of the first part 1321, the second part 1322, and the third part 1323 of the second feeding branch 132.

In addition, the second metal hole 134 includes a third hole part 1341 and a fourth hole part 1342. The third hole part 1341 is connected to the fourth hole part 1342. A diameter of the third hole part 1341 is greater than a diameter of the fourth hole part 1342. The fourth hole part 1342 is connected to the first part 1321 of the second feeding branch 132. In this embodiment, a structure of the second metal hole 134 is the same as a structure of the first metal hole 133.

In another embodiment, a structure of the first feeding branch 131 may also be the structure of the second feeding branch 132, that is, the first feeding branch 131 has a "bar-like" shape. In this case, the first feeding branch 131 and the second feeding branch 132 are disposed in different layers, that is, a distance between the first feeding branch 131 and the ground layer 12 is greater than or less than a distance between the second feeding branch 132 and the ground layer 12, to avoid a short circuit between the first feeding branch 131 and the second feeding branch 132.

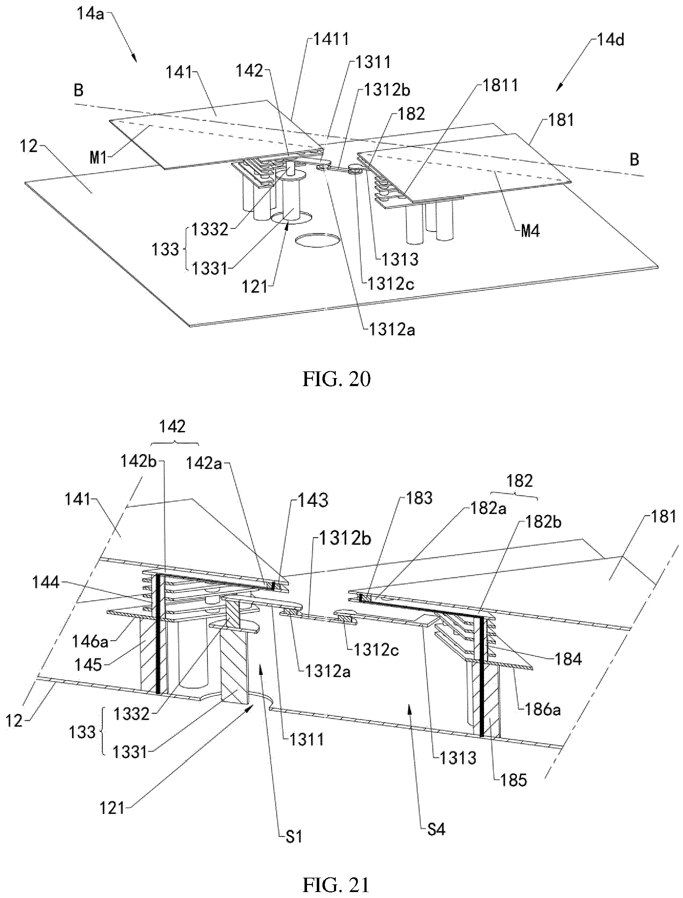

Refer to FIG. 20 and FIG. 21 with reference to FIG. 19. FIG. 20 is a schematic diagram of a part of the structure of the antenna structure 10 shown in FIG. 3. FIG. 21 is a schematic cross-sectional diagram of the antenna structure 10 shown in FIG. 20 cut along a line B-B. The first hole part 1331 of the first metal hole 133 is disposed opposite the first through hole 121 on the ground layer 12. The first hole part 1331 of the first metal hole 133 is electrically connected to the radio frequency circuit 20 through the first through hole 121 (refer to FIG. 3). For example, the first hole part 1331 may be electrically connected to the radio frequency circuit 20 by using a conductive structure, for example, a microstrip line, a coaxial cable, a strip line, or a probe. The first hole part 1331 is further spaced from the ground layer 12, to avoid a short circuit with the ground layer 12.

It can be understood that, as the first part 1311 and the fifth part 1313 of the first feeding branch 131 are disposed in a same layer, a distance between the first part 1311 of the first feeding branch 131 and the ground layer 12 is equal to a distance between the fifth part 1313 of the first feeding branch 131 and the ground layer 12.

In addition, a part of the first part 1311 of the first feeding branch 131 is located on a side that is of the second metal layer 142 of the first antenna element 14a and that faces the ground layer 12, that is, located in the first space S1 of the first antenna element 14a. In addition, a part of the fifth part 1313 of the first feeding branch 131 is located on a side that is of the second metal layer 182 of the fourth antenna element 14d and that faces the ground layer 12, that is, located in the fourth space S4 of the fourth antenna element 14d. In addition, an extension direction of the first feeding branch 131 is parallel to the diagonal line M1 of the first metal layer 141 of the first antenna element 14a, that is, an included angle between the extension direction of the first feeding branch 131 and the first edge 1411 of the first metal layer 141 of the first antenna element 14a may be 45°. In addition, the extension direction of the first feeding branch 131 is further parallel to the diagonal line M4 of the first metal layer 181 of the fourth antenna element 14d, that is, an included angle between the extension direction of the first feeding branch 131 and the first edge 1811 of the first metal layer 181 of the fourth antenna element 14d may be 45°.

It can be understood that, when the radio frequency circuit 20 transmits a radio frequency signal, the radio frequency signal may be coupled and fed to the second metal layer 182 and the first metal layer 181 of the fourth antenna element 14d through the first metal hole 133 and the first part 1311, the second part 1312a, the third part 1312b, the fourth part 1312c, and the fifth part 1313 of the first feeding branch 131. In this case, a current path passing the ground layer 12, the third metal columns 185, the first metal connection sheet 186a, the second metal columns 184, the second area 182b of the second metal layer 182, the first area 182a of the second metal layer 182, the first metal columns 183, and the first metal layer 181 has current transmission.

In addition, the radio frequency signal may be coupled and fed to the second metal layer 142 and the first metal layer 141 of the first antenna element 14a through the first metal hole 133 and the first part 1311 of the first feeding branch 131. In this case, a current path passing the ground layer 12, the third metal columns 145, the first metal connection sheet 146a, the second metal columns 144, the second area 142b of the second metal layer 142, the first area 142a of the second metal layer 142, the first metal columns 143, and the first metal layer 141 has current transmission.

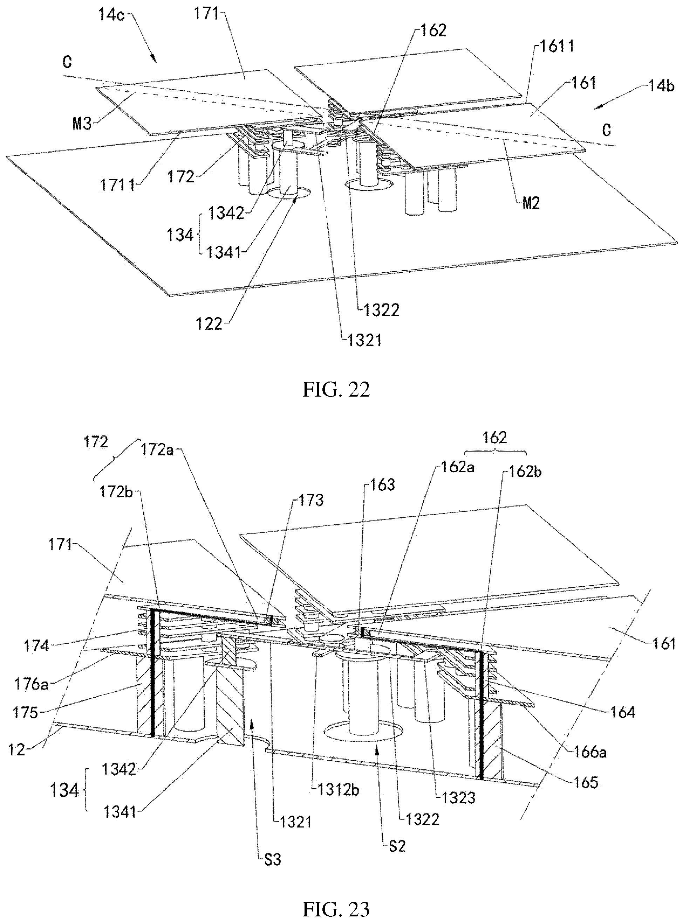

Refer to FIG. 22 and FIG. 23 with reference to FIG. 19. FIG. 22 is a schematic diagram of a part of the structure of the antenna structure 10 shown in FIG. 3. FIG. 23 is a schematic cross-sectional diagram of the antenna structure 10 shown in FIG. 22 cut along a line C-C. The third hole part 1341 of the second metal hole 134 is disposed opposite the second through hole 122 on the ground layer 12. The third hole part 1341 of the second metal hole 134 is electrically connected to the radio frequency circuit 20 through the second through hole 122 (refer to FIG. 3). For example, the third hole part 1341 may be electrically connected to the radio frequency circuit 20 by using a conductive structure, for example, a microstrip line, a coaxial cable, a strip line, or a probe. The third hole part 1341 is further spaced from the ground layer 12, to avoid a short circuit with the ground layer 12.

In this implementation, as the second feeding branch 132, the first part 1311 of the first feeding branch 131, and the fifth part 1313 of the first feeding branch 131 are disposed in a same layer, a distance between the second feeding branch 132 and the ground layer 12, a distance between the first part 1311 of the first feeding branch 131 and the ground layer 12, and a distance between the fifth part 1313 of the first feeding branch 131 and the ground layer 12 are all equal.

In addition, a part of the first part 1321 of the second feeding branch 132 is located on a side that is of the second metal layer 172 of the third antenna element 14c and that faces the ground layer 12, that is, located in the third space S3 of the third antenna element 14c. A part of the third part 1323 of the second feeding branch 132 is located on a side that is of the second metal layer 162 of the second antenna element 14b and that faces the ground layer 12, that is, located in the second space S2 of the second antenna element 14b. An extension direction of the second feeding branch 132 is parallel to the diagonal line M3 of the first metal layer 141 of the third antenna element 14c, that is, an included angle between the extension direction of the second feeding branch 132 and the first edge 1711 of the first metal layer 171 of the third antenna element 14c may be 45°. The extension direction of the second feeding branch 132 is further parallel to the diagonal line M2 of the first metal layer 161 of the second antenna element 14b, that is, an included angle between the extension direction of the second feeding branch 132 and the first edge 1611 of the first metal layer 161 of the second antenna element 14b may be 45°.

It can be understood that, when the radio frequency circuit 20 transmits a radio frequency signal, the radio frequency signal may be coupled and fed to the second metal layer 162 and the first metal layer 161 of the second antenna element 14b through the second metal hole 134 and the first part 1321, the second part 1322, and the third part 1323 of the second feeding branch 132. In this case, a current path passing the ground layer 12, the third metal columns 165, the first metal connection sheet 166a, the second metal columns 164, the second area 162b of the second metal layer 162, the first area 162a of the second metal layer 162, the first metal columns 163, and the first metal layer 161 has current transmission.

In addition, the radio frequency signal may alternatively be coupled and fed to the second metal layer 172 and the first metal layer 171 of the third antenna element 14c through the second metal hole 134 and the first part 1321 of the second feeding branch 132. In this case, a current path passing the ground layer 12, the third metal columns 175, the first metal connection sheet 176a, the second metal columns 174, the second area 172b of the second metal layer 172, the first area 172a of the second metal layer 172, the first metal columns 173, and the first metal layer 171 has current transmission.

In another embodiment, refer to FIG. 21 again. The first part 1311 of the first feeding branch 131 may be directly connected to the second metal layer 142 of the first antenna element 14a. In addition, the fifth part 1313 of the first feeding branch 131 may be directly connected to the second metal layer 182 of the fourth antenna element 14d. In this way, when the radio frequency circuit 20 transmits a radio frequency signal, the radio frequency signal may be directly fed to the second metal layer 182 and the first metal layer 181 of the fourth antenna element 14d through the first metal hole 133 and the first part 1311, the second part 1312a, the third part 1312b, the fourth part 1312c, and the fifth part 1313 of the first feeding branch 131. In addition, the radio frequency signal may alternatively be directly fed to the second metal layer 142 and the first metal layer 141 of the first antenna element 14a through the first metal hole 133 and the first part 1311 of the first feeding branch 131.

In another embodiment, refer to FIG. 23 again. The first part 1321 of the second feeding branch 132 may be directly connected to the second metal layer 172 of the third antenna element 14c. The third part 1323 of the second feeding branch 132 is directly connected to the second metal layer 162 of the second antenna element 14b. In this way, when the radio frequency circuit 20 transmits a radio frequency signal, the radio frequency signal may be directly fed to the second metal layer 162 and the first metal layer 161 of the second antenna element 14b through the second metal hole 134 and the first part 1321, the second part 1322, and the third part 1323 of the second feeding branch 132. The radio frequency signal may alternatively be directly fed to the second metal layer 172 and the first metal layer 171 of the third antenna element 14c through the second metal hole 134 and the first part 1321 of the second feeding branch 132.

The feeding element 13 is described above with reference to the related accompanying drawings. A specific structure of the matching via groups 15 is described below in detail with reference to related accompanying drawings.

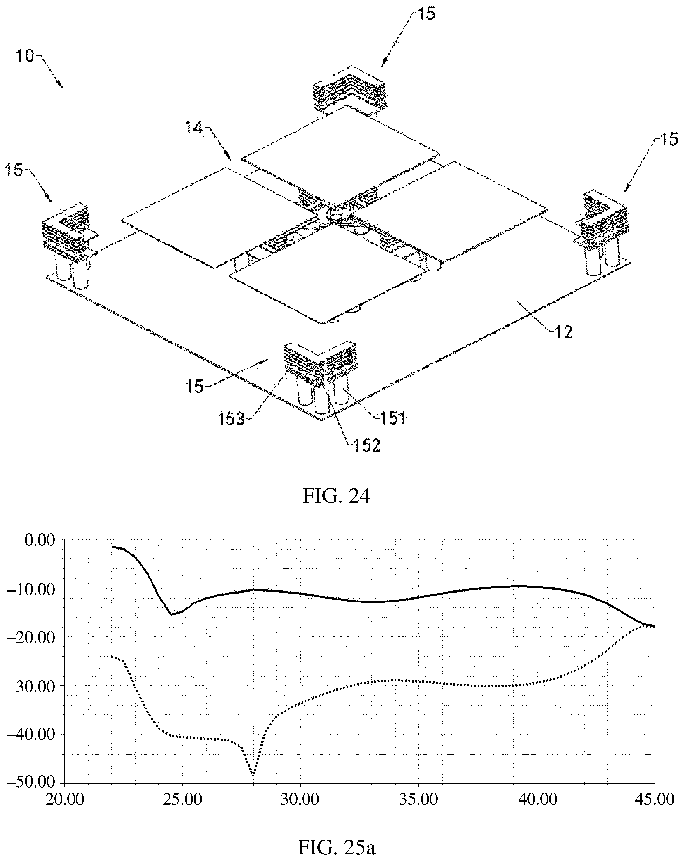

FIG. 24 is a schematic diagram of a part of the structure of the antenna structure 10 shown in FIG. 3. The plurality of matching via groups 15 are electrically connected to the ground layer 12. The plurality of matching via groups 15 are located on a periphery of the first antenna element 14a, the second antenna element 14b, the third antenna element 14c, and the fourth antenna element 14d. The plurality of matching via groups 15 are located on a periphery of the ground layer 12, that is, the plurality of matching via groups 15 are disposed near edges of the ground layer 12. The plurality of matching via groups 15 are disposed around the first antenna element 14a, the second antenna element 14b, the third antenna element 14c, and the fourth antenna element 14d.

For example, there are four matching via groups 15. The four matching via groups 15 are located at four corners of the ground layer 12. In this embodiment, one of the matching via groups 15 is used as an example for detailed description.

In this embodiment, the matching via group 15 includes first matching vias 151, second matching vias 152, and metal connection sheets 153. For structures of the first matching vias 151 and the second matching vias 152, refer to structures of the third metal columns 145 of the first antenna element 14a (refer FIG. 5). Details are not described herein again.

For example, there are three first matching vias 151. There are seven second matching vias 152. There are seven metal connection sheets 153.

The plurality of first matching vias 151 are spaced from each other, and one end of each of the first matching vias 151 is connected to the ground layer 12. For example, the plurality of first matching vias 151 are arranged into an "L" shape.

In addition, the plurality of metal connection sheets 153 are located on a side that is of the first matching vias 151 and that is farther away from the ground layer 12, and are spaced from each other. One of the metal connection sheets 153 is connected to the plurality of first matching vias 151. In this case, the first matching vias 151 are located between the metal connection sheets 153 and the ground layer 12.

For example, each of the metal connection sheets 153 has an "L" shape.

In addition, the plurality of second metal columns 144 are spaced from each other. The plurality of second matching vias 152 are also arranged into an "L" shape. Each of the second matching vias 152 is connected to each of the metal connection sheets 153.

It can be understood that, as the plurality of matching via groups 15 that are spaced from each other are disposed on the ground layer 12, the matching via groups 15 can enlarge a current path between the antenna elements 14 and the ground layer 12. The matching via groups 15 may be configured to tune impedance of the antenna structure 10, to implement impedance matching. In addition, because the matching via groups 15 can enlarge the current path between the antenna elements 14 and the ground layer 12, sizes of the antenna elements 14 and the ground layer 12 in embodiments may be made small, to achieve miniaturization of the antenna structure 10.

In another embodiment, the matching via groups 15 may not include the second matching vias 152 or the metal connection sheets 153, that is, the matching via groups 15 includes only the first matching vias 151.

FIG. 25a is a data diagram in which a reflection coefficient of the antenna structure 10 changes with a frequency according to an embodiment of this application. A solid line in FIG. 25a represents an S11 curve, and the S11 curve is used to indicate an input return loss. A dotted line represents an S21 curve, and the S21 curve is used to indicate isolation between two ports. A horizontal ordinate indicates a frequency, where a frequency unit is GHz, and a vertical ordinate indicates a unit, dB. A frequency band that can be covered by the antenna structure 10 ranges from 24.25 GHz to 43.5 GHz. A return loss is greater than 10 dB, and isolation is greater than 15 dB, to satisfy an antenna performance requirement. In this way, the antenna structure 10 may work in an operating frequency band ranging from 24.25 GHz to 29.5 GHz and from 37 GHz to 43.5 GHz. The antenna structure 10 may support frequency bands n257, n258, n259, n260, and n261.

In addition, the antenna structure 10 has two resonance frequencies (also referred to as center frequencies). The two resonance frequencies are 24 GHz and 33 GHz.

A signal bandwidth, corresponding to the antenna structure 10, $\Delta f=43.5$ GHz - 24.25 GHz=19.25 GHz.

A center frequency f0=(43.5 GHz+24.25 GHz)/2=33.875 GHz.

In this case, a relative bandwidth ffoc1=$\triangle$f/f0=19.25 GHz/33.875 GHz=56.83%. The antenna structure 10 is a wideband antenna.

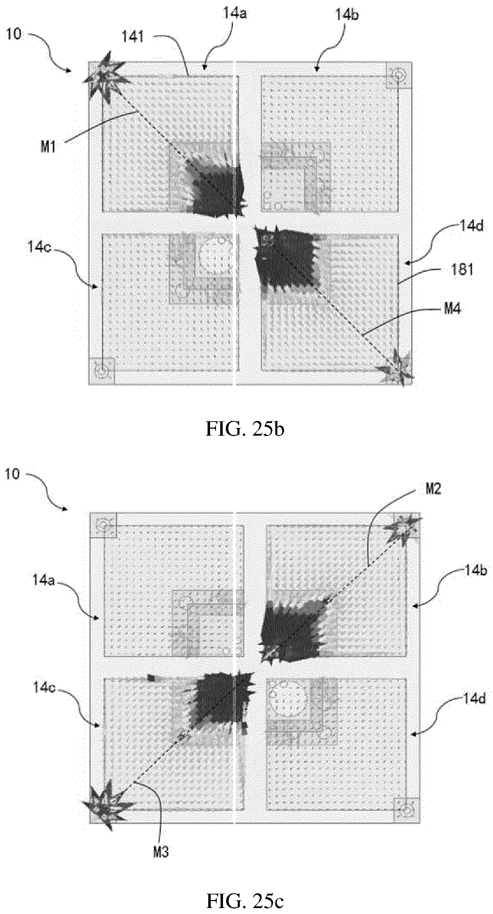

FIG. 25b is a schematic diagram of a type of polarization of the antenna structure 10 according to an embodiment of this application. A direction of an arrow in FIG. 25b indicates a direction of a current. In addition, a shade of the arrow indicates current intensity. A darker shade of the arrow indicates higher current intensity. A lighter shade of the arrow indicates lower current intensity. The first type of polarization of the antenna structure 10 is - 45° polarization of the antenna structure 10. Most currents in the antenna structure 10 are mainly in the first antenna element 14a and the fourth antenna element 14d, and a small part is in the second antenna element 14b and the third antenna element 14c. A current in the first antenna element 14a flows along the diagonal line M1 towards the fourth antenna element 14d. A current in the fourth antenna element 14d flows along the diagonal line M4 away from the first antenna element 14a.

FIG. 25c is a schematic diagram of another type of polarization of the antenna structure 10 according to an embodiment of this application. A direction of an arrow in FIG. 25c indicates a direction of a current. In addition, a shade of the arrow indicates current intensity. A darker shade of the arrow indicates higher current intensity. A lighter shade of the arrow indicates lower current intensity. The second type of polarization of the antenna structure 10 is +45° polarization of the antenna structure 10. Most currents in the antenna structure 10 are mainly in the second antenna element 14b and the third antenna element 14c, and a small part is in the first antenna element 14a and the fourth antenna element 14d. A current in the second antenna element 14b flows along the diagonal line M2 away from the third antenna element 14c. A current in the third antenna element 14c flows along the diagonal line M3 towards the second antenna element 14b.

It can be learned from FIG. 25b and FIG. 25c that the antenna structure 10 in this implementation has two types of polarization, that is, the antenna structure 10 features dual-polarization.

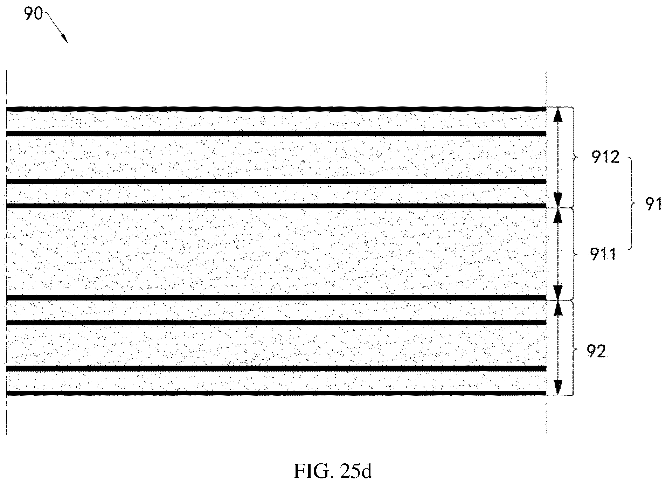

FIG. 25d is a schematic cross-sectional diagram of a part of a package substrate structure 90 according to an embodiment. The package substrate structure 90 may be disposed by using a multi-layer symmetric substrate. The package substrate structure 90 includes an antenna layer 91 and a prepreg (prepreg, PP) chip bodylectric layer 92 that are layered up. The antenna layer 91 is configured to dispose the antenna structure 10 shown in FIG. 4 to FIG. 24. There are a plurality of layers of routing in the PP chip bodylectric layer 92. In FIG. 25d, three layers of routing in the PP chip bodylectric layer 92 are represented schematically by using thick lines. A quantity of layers of routing in the PP chip bodylectric layer 92 is not specifically limited. Each layer of routing may be electrically connected through a metal hole or a metal column. Routing in the PP chip bodylectric layer 92 may be used to provide radio frequency signal routing, a ground cable, power routing, and the like for the antenna layer 91. Clearly, the PP chip bodylectric layer 92 may further be used to provide signal routing, a ground cable, power routing, and the like for another chip or device. In addition, the PP chip bodylectric layer 92 may further be used to raise the antenna layer 91. For example, the antenna structure 10 radiates or receives an electromagnetic wave to or from the outside of the electronic device 1 via an insulating part of the rear cover 202. The PP chip bodylectric layer 92 can enable the antenna structure 10 to be closer to the rear cover 202.

In this implementation, the antenna layer 91 further includes a core board (also referred to as a core chip bodylectric layer) 911 and a metal layer 912 that are layered up. The core chip bodylectric layer 911 is layered on the PP chip bodylectric layer 92. The core chip bodylectric layer 911 may be connected to the PP chip bodylectric layer 92 by press-fit or the like. The metal layer 912 includes a chip bodylectric part and a metal part. The chip bodylectric part may fully surround or half-surround the metal part. In FIG. 25d, three layers of the metal part of the metal layer 912 are represented schematically by thick lines. A quantity of layers of the metal part of the metal layer 912 is not specifically limited. A metal hole or a metal column may be disposed in the chip bodylectric part, to electrically connect each layer of the metal part. For example, the PP chip bodylectric layer 92 may be symmetrically distributed with respect to the core chip bodylectric layer 911.

In this implementation, the antenna structure 10 shown in FIG. 4 to FIG. 24 is disposed in the antenna layer 91. The first metal layer, the second metal layer, the first metal columns, the second metal columns, the first metal connection sheet, and the second metal connection sheets of each of the antenna elements 14 of the antenna structure 10 may all be disposed in the metal layer 912. In addition, both the third metal columns and the ground layer 12 of each of the antenna elements 14 of the antenna structure 10 may be disposed in the core chip bodylectric layer 911.

In addition, the first feeding branch 131 and the second feeding branch 132 of the feeding element 13, the second hole part 1332 of the first metal hole 133 of the feeding element 13, and the fourth hole part 1342 of the second metal hole 134 of the feeding element 13 may all be disposed in the metal layer 912. Both the first hole part 1331 of the first metal hole 133 of the feeding element 13 and the third hole part 1341 of the second metal hole 134 of the feeding element 13 may be disposed in the core chip bodylectric layer 911. The first hole part 1331 of the first metal hole 133 of the feeding element 13 and the third hole part 1341 of the second metal hole 134 of the feeding element 13 may be electrically connected to the radio frequency transceiver chip 21 through signal routing, a ground cable, and power routing in the PP chip bodylectric layer 92.

In addition, both the first matching vias 151 and the metal connection sheets 153 of the matching via groups 15 may be disposed in the metal layer 912. The second matching vias 152 of the matching via groups 15 may be disposed in the core chip bodylectric layer 911.

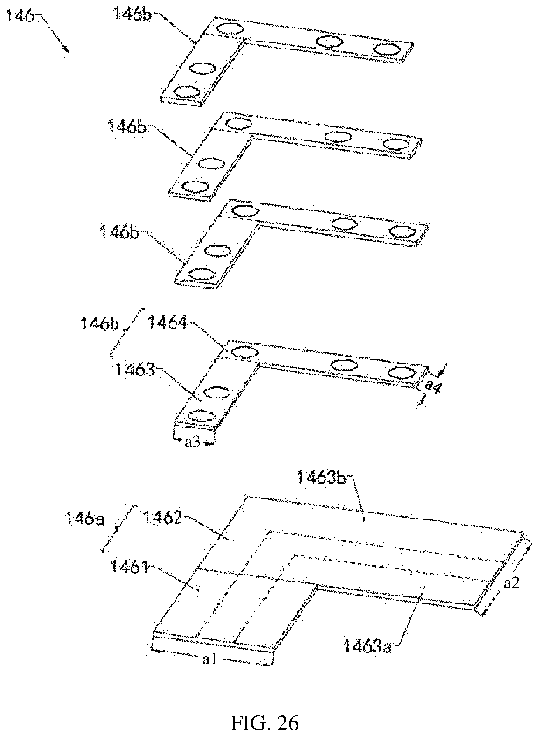

Technical content that is the same as or similar to the implementations shown in FIG. 4 to FIG. 24 is not described again. FIG. 26 is a schematic diagram of structures of the first metal connection sheet 146a and the second metal connection sheets 146b of the first antenna element 14a in another implementation according to an embodiment of this application. The first metal connection sheet 146a includes a third area 1463a and a fourth area 1463b that are spaced from each other. In FIG. 26, the third area 1463a and the fourth area 1463b are distinguished schematically by using a dashed line. A part of the third area 1463a is located in the first connection part 1461 of the first metal connection sheet 146a, and a part of the third area 1463a is located in the second connection part 1462 of the first metal connection sheet 146a. A part of the fourth area 1463b is located in the first connection part 1461 of the first metal connection sheet 146a, and a part of the fourth area 1463b is located in the second connection part 1462 of the first metal connection sheet 146a. For example, both the third area 1463a and the fourth area 1463b may each have an "L" shape. In another embodiment, shapes of the third area 1463a and the fourth area 1463b are not specifically limited.

It can be understood that, compared with the width a1 of the first connection part 1461 and the width a2 of the second connection part 1462 of the first metal connection sheet 146a in the first implementation, the width a1 of the first connection part 1461 and the width a2 of the second connection part 1462 of the first metal connection sheet 146a in this implementation are greater. In addition, for the second metal connection sheets 146b in this implementation, refer to the manner of disposing the second metal connection sheets 146b in the first implementation. Details are not described herein again.

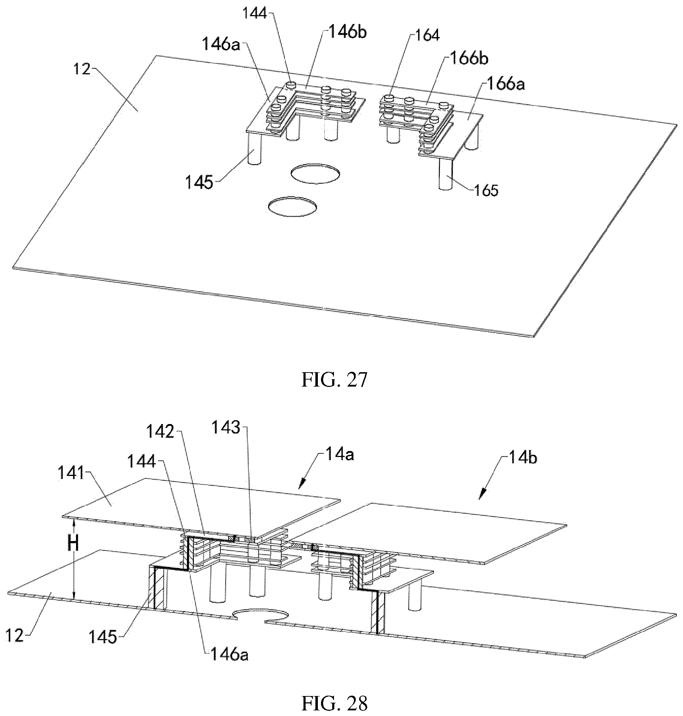

Refer to FIG. 27 with reference to FIG. 26. FIG. 27 is a schematic diagram of a part of the structure of the antenna structure 10 in another implementation according to an embodiment of this application. The second metal columns 144 are connected to the third area 1463a of the first metal connection sheet 146a. One end of each of the third metal columns 145 is connected to the fourth area 1463b of the first metal connection sheet 146a. In this way, the second metal columns 144 and the third metal columns 145 are spaced from each other in two areas of the first metal connection sheet 146a. In other words, projections of the second metal columns 144 on the first metal connection sheet 146a do not overlap projections of the third metal columns 145 on the first metal connection sheet 146a (that is, there is no overlapped part).

Refer to FIG. 28 with reference to FIG. 26 and FIG. 27. FIG. 28 is a schematic cross-sectional diagram of a part of the antenna structure 10 in another implementation according to an embodiment of this application. When the first antenna element 14a is in a working state, a current path (simply represented by thick lines in FIG. 28) includes the ground layer 12, the third metal columns 145, the fourth area 1463b of the first metal connection sheet 146a, the third area 1463a of the first metal connection sheet 146a, the second metal columns 144, the second metal layer 142, the first metal columns 143, and the first metal layer 141. In this case, because a current may be transmitted between the fourth area 1463b of the first metal connection sheet 146a and the third area 1463a of the first metal connection sheet 146a and transmitted between two areas of the second metal layer 142, the current path is disposed as bent twice. Compared with the current path in the first implementation, a cross-section H of the antenna structure 10 in this implementation can be smaller. In this way, thinness of the antenna structure 10 is easier to achieve.

For example, when a length of the current path (to be specific, an electrical length is equal to a sum of the cross-sectional height H of the antenna structure 10 and the length of the edges of the second metal layer 142) is in the range of $0.25\lambda 0$ to $0.32\lambda 0$, the cross-sectional height H of the antenna structure 10 in this embodiment may be in the range of $0.1\lambda 0$ to $0.15\lambda 0$.

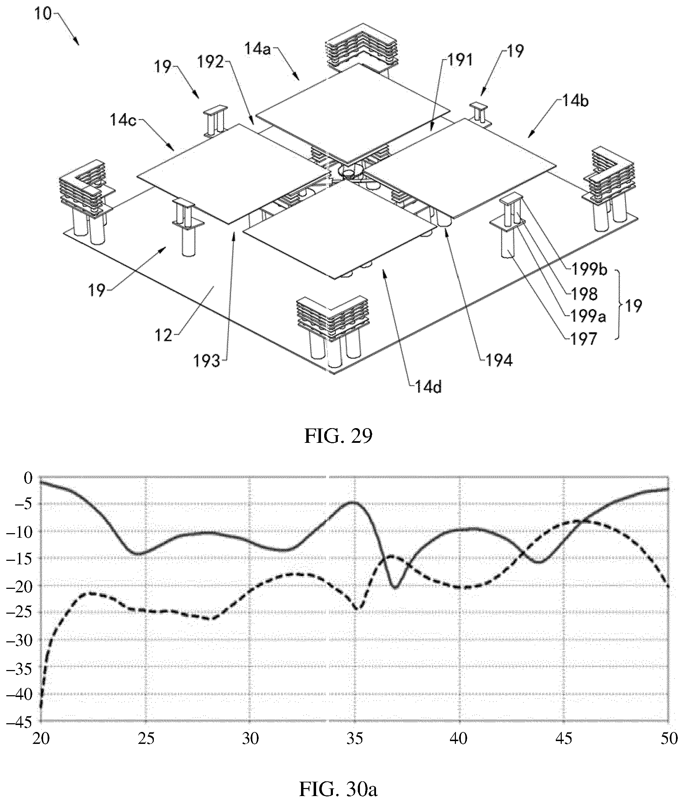

FIG. 29 is a schematic diagram of a structure of the antenna structure 10 in another implementation according to an embodiment of this application. For a manner of disposing the second antenna element 14b, the third antenna element 14c, and the fourth antenna element 14d, refer to the manner of disposing the first antenna element 14a. Details are not described herein again.

It can be understood that current paths of the first antenna element 14a, the second antenna element 14b, the third antenna element 14c, and the fourth antenna element 14d in this implementation may all be disposed as bent twice. In this way, not only the cross-sectional height H of the antenna structure 10 may be smaller, widths of the first gap 191, the second gap 192, the third gap 193, and the fourth gap 194 may also be smaller. For example, widths of the first gap 191, the second gap 192, the third gap 193, and the fourth gap 194 each may be in the range of $0.03\lambda 0$ to $0.1\lambda 0$. In this way, miniaturization of the antenna structure 10 is easier to achieve.

In another embodiment, the first antenna element 14a may further include a third metal connection sheet, a fourth metal connection sheet, a fifth metal connection sheet, ..., and an $m^{th}$ metal connection sheet, where m is an integer and is greater than 2. For a manner of disposing the mth metal connection sheet, refer to the manner of disposing the first metal connection sheet 146a. In addition, the first antenna element 14a may further include a fourth metal column, a fifth metal column, ..., and an nth metal column, where n is an integer and is greater than 3. In this way, as the mth metal connection sheet and the nth metal column are disposed, a current path of the first antenna element 14a can be disposed as bent a plurality of times, to further reduce the cross-sectional height H of the antenna structure 10 and the widths of the first gap 191, the second gap 192, the third gap 193, and the fourth gap 194.

Refer to FIG. 29 again. The antenna structure 10 further includes a plurality of metal short-circuit hole groups 19. The plurality of metal short-circuit hole groups 19 are electrically connected to the ground layer 12. The plurality of metal short-circuit hole groups 19 are located on the periphery of the first antenna element 14a, the second antenna element 14b, the third antenna element 14c, and the fourth antenna element 14d.

For example, there are four metal short-circuit hole groups 19. One of the metal short-circuit hole groups 19 is located on a same side of the first antenna element 14a and the second antenna element 14b, and is disposed in an extension direction of the first gap 191. One of the metal short-circuit hole groups 19 is disposed opposite the first gap 191. One of the metal short-circuit hole groups 19 is located on a same side of the first antenna element 14a and the third antenna element 14c, and is disposed in an extension direction of the second gap 192. One of the metal short-circuit hole groups 19 is disposed opposite the second gap 192. One of the metal short-circuit hole groups 19 is located on a same side of the third antenna element 14c and the fourth antenna element 14d, and is disposed in an extension direction of the third gap 193. One of the metal short-circuit hole groups 19 is disposed opposite the third gap 193. One of the metal short-circuit hole groups 19 is located on a same side of the fourth antenna element 14d and the second antenna element 14b, and is disposed in an extension direction of the fourth gap 194. One of the metal short-circuit hole groups 19 is disposed opposite the fourth gap 194.

In this embodiment, the metal short-circuit hole group 19 located on the same side of the fourth antenna element 14d and the second antenna element 14b is used as an example for detailed description.

In this embodiment, the metal short-circuit hole group 19 includes a first short-circuit hole 197, second short-circuit holes 198, a first metal sheet 199a, and a second metal sheet 199b. For structures of the first short-circuit hole 191 and the second short-circuit holes 198, refer to structures of the third metal columns 145 of the first antenna element 14a (refer to FIG. 5). Details are not described herein again.

For example, there is one first short-circuit hole 191. There are two second short-circuit holes 198. There is one first metal sheet 199a and one second metal sheet 199b.

One end of the first short-circuit hole 197 is connected to the ground layer 12, and the other end is connected to the first metal sheet 199a. In this case, the first short-circuit hole 197 is located between the ground layer 12 and the first metal sheet 199a. One end of each of the second short-circuit holes 198 is connected to the first metal sheet 199a, and the other end is connected to the second metal sheet 199b. In this case, the second short-circuit holes 198 are located between the first metal sheet 199a and the second metal sheet 199b.

For example, the first short-circuit hole 197 and the second short-circuit holes 198 may be spaced from each other in two areas of the first metal sheet 199a. For details, refer to the manner in which the second metal columns 144 and the third metal columns 145 are spaced from each other in two areas of the first metal connection sheet 146a in this implementation.

FIG. 30a is a data diagram in which a reflection coefficient of the antenna structure 10 changes with a frequency according to an embodiment of this application. A solid line in FIG. 30a represents an S11 curve, and the S11 curve is used to indicate an input return loss. A dotted line represents an S21 curve, and the S21 curve is used to indicate isolation between two ports. A horizontal ordinate indicates a frequency, where a frequency unit is GHz, and a vertical ordinate indicates a unit, dB. As shown in FIG. 30a, a frequency band that can be covered by the antenna structure 10 ranges from 24.25 GHz to 43.5 GHz. A return loss is greater than 10 dB, and isolation is greater than 15 dB, to satisfy an antenna performance requirement. In this way, the antenna structure 10 may work in an operating frequency band ranging from 24.25 GHz to 29.5 GHz and from 37 GHz to 43.5 GHz. The antenna structure 10 may support frequency bands n257, n258, n259, n260, and n261.

In addition, it can be learned from the S11 curve in FIG. 30a, when the antenna structure 10 includes the metal short-circuit hole groups 19, the antenna structure 10 has four resonance frequencies, that is, 24 GHz, 32 GHz, 37 GHz, and 44 GHz. It can be understood that, on one hand, within a frequency band range including n257, n258, n259, n260, and n261, the antenna structure 10 has another resonance point (and a resonance frequency is 44 GHz). On the other hand, within the frequency band range including n257, n258, n259, n260, and n261, the antenna structure 10 has another trap point (and a frequency is roughly 35 GHz). In this case, the resonance frequency (33 GHz) in the first implementation may be split into two resonance frequencies (32 GHz and 37 GHz).

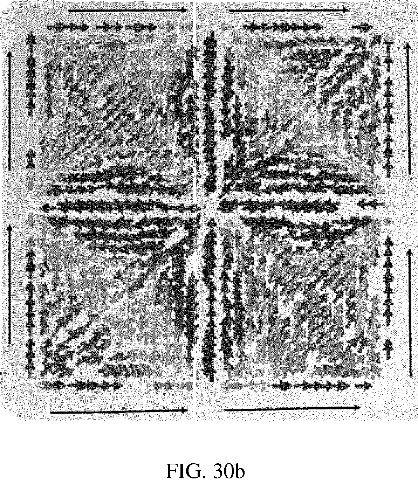

FIG. 30b is a schematic diagram of a current in the antenna structure 10 in the frequency band of n259 according to an embodiment of this application. A direction of a smaller arrow in FIG. 30b indicates a direction of a current at each location in the antenna structure 10. In addition, a shade of the smaller arrow indicates current intensity. A darker shade of the smaller arrow indicates higher current intensity. A lighter shade of the smaller arrow indicates lower current intensity. A direction of a bigger arrow in FIG. 30b indicates an overall direction of a current on one side of the antenna elements 14. A current generated around the antenna structure 10 when the antenna structure 10 is at 44 GHz can be learned from FIG. 30b. Directions of currents on a same side of the antenna structure 10 are basically the same. For example, currents on a left side of the antenna structure 10 are roughly in an upward direction. To be specific, a current on a left side of the first antenna element 14a and a current on a left side of the third antenna element 14c are both in an upward direction. A large solid-line arrow is used for representation in FIG. 30b.

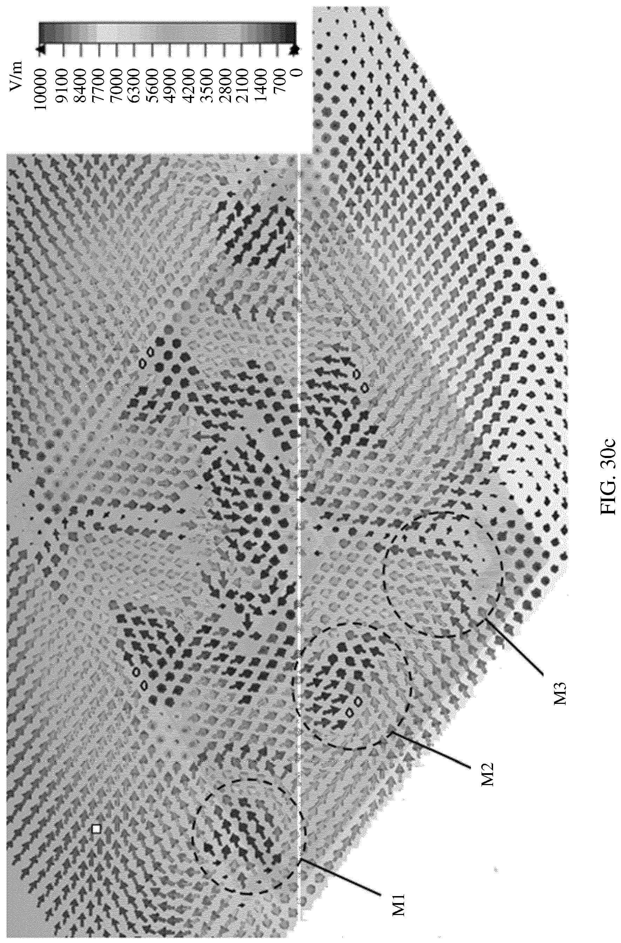

FIG. 30c is a schematic diagram of an electric field of the antenna structure 10 in the frequency band of n259 according to an embodiment of this application. A direction of an arrow in FIG. 30c indicates a direction of the electric field. In addition, a shade of the arrow indicates intensity of the electric field. A darker shade of the arrow indicates higher intensity of the electric field. A lighter shade of the arrow indicates lower intensity of the electric field. An electric field generated around the antenna structure 10 when the antenna structure 10 is at 44 GHz can be learned from FIG. 30c. Directions of the electric field on a same side of the antenna structure 10 are "negative-positive-negative". For example, an electric field on a left side of the antenna structure 10 includes a first area M1, a second area M2, and a third area M3. An electric field in the first area M1 is in an upward direction. An electric field in the second area M2 is in a downward direction. An electric field in the third area M3 is in an upward direction. The upward direction of the electric field in the first area M1 is referred to as positive. The downward direction of the electric field in the second area M2 is referred to as negative. It can be understood that the electric field in the second area M2 is relatively small, and therefore, the antenna structure 10 can work normally in a higher-order mode (that is, at the resonance frequency of 44 GHz).

It can be understood that, it can be learned from FIG. 30b and FIG. 30c that as the antenna structure 10 is at a resonance location of 44 GHz, because the antenna structure 10 is provided with the metal short-circuit hole groups 19, a higher-order type of field is introduced into the antenna structure 10, currents basically flow in a same direction, and the antenna structure 10 has a new resonance point (44 GHz).

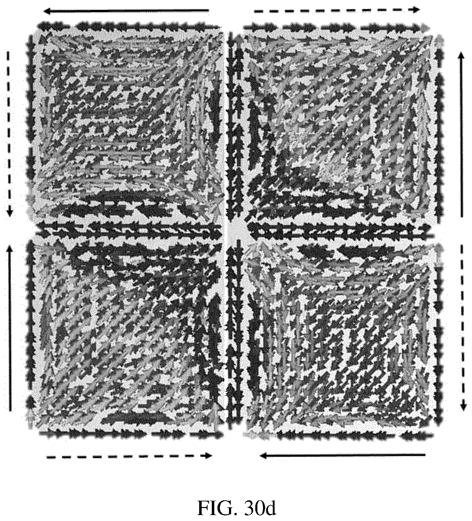

FIG. 30d is a schematic diagram of a current in the antenna structure in the frequency band of n260 according to an embodiment of this application. A direction of a smaller arrow in FIG. 30d indicates a direction of a current at each location in the antenna structure 10. In addition, a shade of the smaller arrow indicates current intensity. A darker shade of the smaller arrow indicates higher current intensity. A lighter shade of the smaller arrow indicates lower current intensity. A direction of a bigger arrow in FIG. 30d indicates an overall direction of a current on one side of the antenna elements 14. A current generated around the antenna structure 10 when the antenna structure 10 is at 35 GHz can be learned from FIG. 30d. Directions of currents on a same side of the antenna structure 10 are basically opposite. For example, currents on the left side of the antenna structure 10 are in opposite directions. To be specific, a current on the left side of the first antenna element 14a is in a downward direction (indicated by a bigger dashed-line arrow in FIG. 30d), and a current on the left side of the third antenna element 14c is in an upward direction (indicated by a bigger solid-line arrow in FIG. 30b).

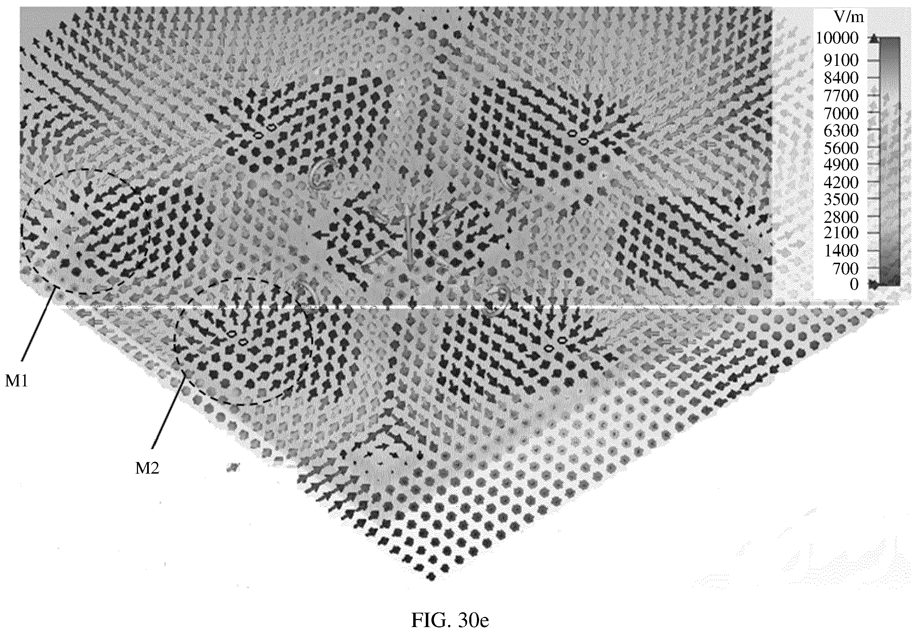

FIG. 30e is a schematic diagram of an electric field of the antenna structure 10 in the frequency band of n260 according to an embodiment of this application. A direction of an arrow in FIG. 30e indicates a direction of the electric field. In addition, a shade of the arrow indicates intensity of the electric field. A darker shade of the arrow indicates higher intensity of the electric field. A lighter shade of the arrow indicates lower intensity of the electric field. Directions of the electric field on a same side of the antenna structure 10 are "negative-positive". For example, an electric field on a left side of the antenna structure 10 includes a first area M1 and a second area M2. An electric field in the first area M1 is in a downward direction. An electric field in the second area M2 is in an upward direction. The downward direction of the electric field in the first area M1 is referred to as negative. The upward direction of the electric field in the second area M2 is referred to as positive. In this case, directions of the electric field are "negative-positive". The antenna structure 10 is in a higher-order cancellation mode.

It can be understood that, it can be learned from FIG. 30d and FIG. 30e that, at the 35 GHz trap point, because the antenna structure 10 is provided with the metal short-circuit hole groups 19, a reverse type of field is introduced into the antenna structure 10. In this case, a current is reversed, and a trap point is generated. In addition, because of the trap point, a resonance mode at an original location is split into two resonance points. Therefore, there are one more resonance point and one more trap point on S11 in FIG. 30a.

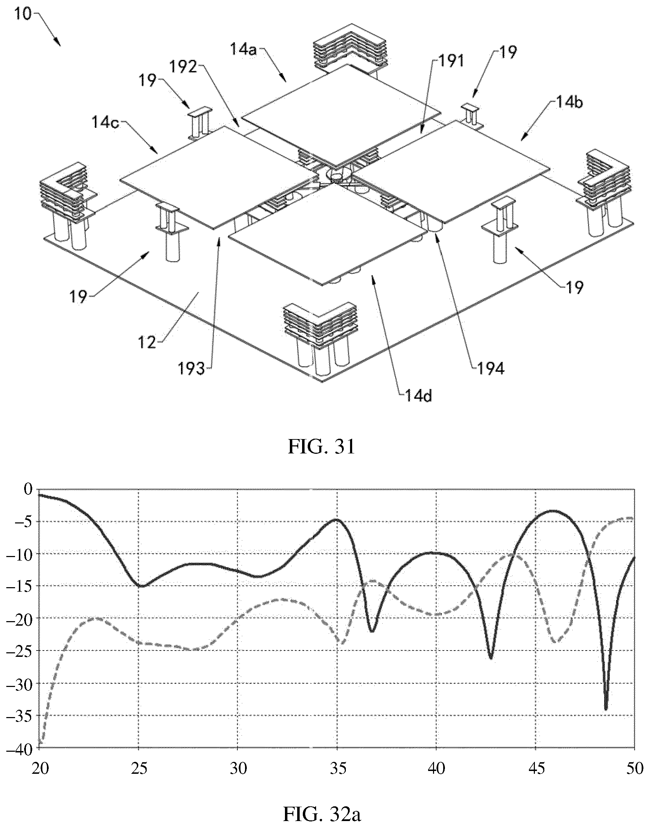

FIG. 31 is a schematic diagram of a structure of the antenna structure 10 in still another implementation according to an embodiment of this application. Current paths of the first antenna element 14a, the second antenna element 14b, the third antenna element 14c, and the fourth antenna element 14d in this implementation are all disposed as bent once. Specifically, for a manner of disposing the first antenna element 14a, the second antenna element 14b, the third antenna element 14c, and the fourth antenna element 14d, refer to the manner of disposing the first antenna element 14a, the second antenna element 14b, the third antenna element 14c, and the fourth antenna element 14d described in FIG. 4 to FIG. 24. Details are not described herein again.

In addition, the antenna structure 10 in this implementation further includes a plurality of metal short-circuit hole groups 19. For a manner of disposing the metal short-circuit hole groups 19, refer to the metal short-circuit hole groups 19 described in FIG. 29. Details are not described herein again.

FIG. 32a is a data diagram in which a reflection coefficient of the antenna structure 10 changes with a frequency according to an embodiment of this application. A solid line in FIG. 32a represents an S11 curve, and the S11 curve is used to indicate an input return loss. A dotted line represents an S21 curve, and the S21 curve is used to indicate isolation between two ports. A horizontal ordinate indicates a frequency, where a frequency unit is GHz, and a vertical ordinate indicates a unit, dB. As shown in. 32a, a frequency band that can be covered by the antenna structure 10 ranges from 24.25 GHz to 43.5 GHz. In addition, a return loss is greater than 10 dB, and isolation is greater than 15 dB, to satisfy an antenna performance requirement. In this way, the antenna structure 10 may work in an operating frequency band ranging from 24.25 GHz to 29.5 GHz and from 37 GHz to 43.5 GHz. The antenna structure 10 may support frequency bands n257, n258, n259, n260, and n261.

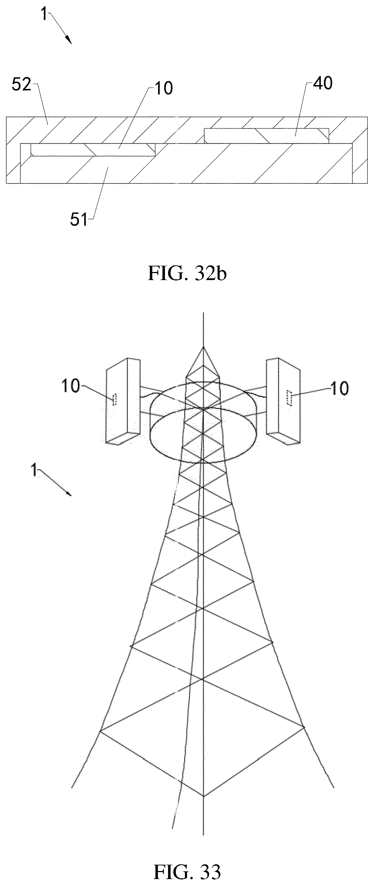

FIG. 32b is a schematic cross-sectional diagram of a chip 1 according to an embodiment of this application. The chip 1 in this embodiment may be a chip based on an AiP (AiP, Antenna-in-Package) solution.

The chip 1 includes an antenna structure 10, a chip body 40, a package substrate 51, and an injection molded piece 52. Both the antenna structure 10 and the chip body 40 are disposed on the package substrate 51 and are electrically connected to the package substrate 51. The injection molded piece 52 packages the antenna structure 10 and the chip body 40. For example, the injection molded piece 52 fully surrounds the antenna structure 10. The injection molded piece 52 fully surrounds the chip body 40. In another embodiment, the injection molded piece 52 may alternatively half-surround the antenna structure 10. The injection molded piece 52 may alternatively half-surround the chip body 40. For the antenna structure 10, refer to the antenna structure 10 shown in FIG. 4 to FIG. 24, the antenna structure 10 shown in FIG. 26 to FIG. 29, or the antenna structure 10 shown in FIG. 31. Details are not described herein again.

For example, the chip body 40 is a radio frequency transceiver chip. The antenna structure 10 may be electrically connected to the chip body 40 via the package substrate 51. In this case, the chip body 40 transmits a radio frequency signal to the antenna structure 10 via the package substrate 51, so that the antenna structure 10 radiates an electromagnetic wave based on the radio frequency signal. In addition, when the antenna structure 10 receives an electromagnetic wave and converts the electromagnetic wave into a radio frequency signal, the chip body 40 may further receive the radio frequency signal converted by the antenna structure 10.

For example, a matching circuit (not shown in the figure) may be further disposed on the package substrate 51. The matching circuit is electrically connected between the antenna structure 10 and the chip body 40.

In another implementation, the chip may alternatively be a chip based on an AiM (Antenna in Module) solution or a chip based on an AoC (Antenna-on-Chip) solution.

In this embodiment, the chip 1 may be used in an electronic device. Specifically, the chip 1 may be disposed on a circuit board of the electronic device. The package substrate 51 of the chip 1 may be electrically connected to the circuit board.

It can be understood that, in this implementation, as the antenna structure 10 is disposed on the package substrate 51 and is surrounded by the injection molded piece 52, the antenna structure 10, the chip body 40, and a package member 50 have higher integrity. FIG. 33 is a schematic diagram of a structure of an electronic device 1 according to another embodiment of this application. The electronic device 1 may be a base station, CPE (Customer Premise Equipment), a wireless access point device (for example, a wireless router), or a device configured to transmit a non-millimeter-wave signal (for example, a low frequency signal). An example in which the electronic device 1 in the embodiment shown in FIG. 33 is a base station is used for description.

The electronic device 1 includes an antenna structure 10. It should be noted that, because the antenna structure 10 is located inside the electronic device 1, in FIG. 33, the antenna structure 10 is represented by a dashed line. For example, a frequency band covered by the antenna structure 10 in this embodiment may be 1.5 GHz to 3 GHz. In another embodiment, the antenna structure 10 may alternatively cover another frequency band.

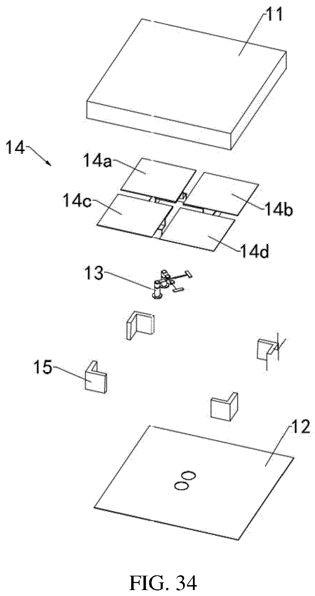

FIG. 34 is an exploded schematic diagram of the antenna structure 10 shown in FIG. 33. The antenna structure 10 includes a chip bodylectric layer 11, a ground layer 12, a feeding element 13, a plurality of antenna elements 14, and a plurality of matching metal walls 15. For a manner of disposing the chip bodylectric layer 11, the ground layer 12, and the feeding element 13, refer to the manner of disposing the chip bodylectric layer 11, the ground layer 12, and the feeding element 13 in the foregoing implementations. Details are not described herein again. In another embodiment, sizes, shapes, and the like of the chip bodylectric layer 11, the ground layer 12, and the feeding element 13 may be flexibly set based on an actual requirement.

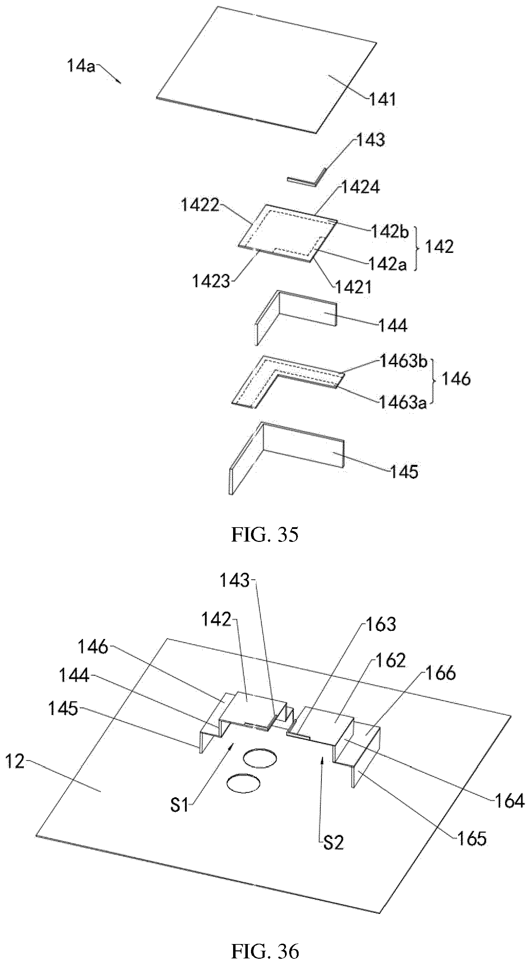

FIG. 35 is an exploded schematic diagram of the first antenna element 14a in FIG. 34. The first antenna element 14a includes a first metal layer 141, a second metal layer 142, a first metal wall 143, a second metal wall 144, a third metal wall 145, and a metal connection sheet 146. The first metal wall 143 forms a first conducting member in this implementation. The second metal wall 144, the third metal wall 145, and the metal connection sheet 146 form a second conducting member in this implementation.

In this implementation, for a manner of disposing the first metal layer 141 and the second metal layer 142, refer to the manner of disposing the first metal layer 141 and the second metal layer 142 in the foregoing implementations. Details are not described herein again. Sizes, shapes, and the like of the first metal layer 141 and the second metal layer 142 may be flexibly set based on an actual requirement.

For example, the first metal wall 143, the second metal wall 144, the third metal wall 145, and the metal connection sheet 146 all have an "L" shape. In another implementation, the first metal wall 143, the second metal wall 144, the third metal wall 145, and the metal connection sheet 146 may all have an arc shape.

The second metal layer 142 includes a first area 142a and a second area 142b that are spaced from each other. In FIG. 35, the first area 142a and the second area 142b are distinguished schematically by using a dashed line.

For example, both the first area 142a and the second area 142b have an "L" shape. The first area 142a includes a first edge 1421 and a third edge 1423 of the second metal layer 142. The second area 142b includes a second edge 1422 and a fourth edge 1424 of the second metal layer 142.

The metal connection sheet 146 includes a third area 1463a and a fourth area 1463b that are spaced from each other. In FIG. 35, the third area 1463a and the fourth area 1463b are distinguished schematically by using a dashed line.

For example, both the third area 1463a and the fourth area 1463b may each have an "L" shape.

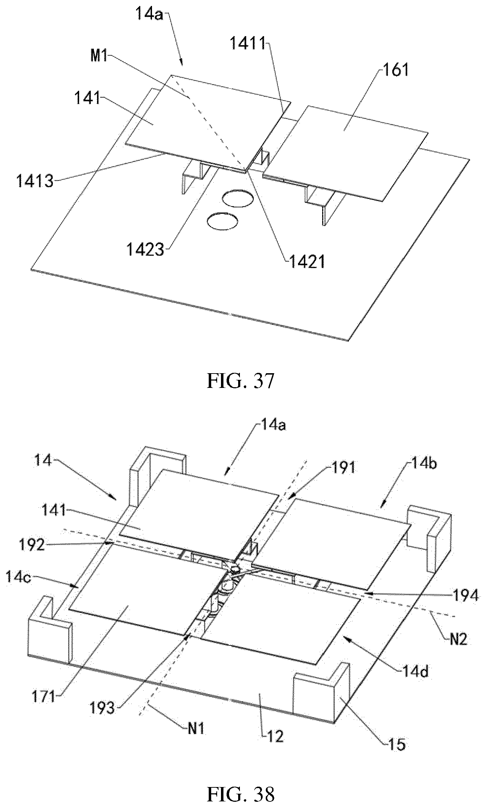

Refer to FIG. 36 and FIG. 37 with reference to FIG. 35. FIG. 36 is a schematic diagram of a part of the structure of the antenna structure 10 shown in FIG. 33. FIG. 37 is a schematic diagram of a part of the structure of the antenna structure 10 shown in FIG. 33. One end of the third metal wall 145 is connected to the ground layer 12, and the other end is connected to the fourth area 1463b of the metal connection sheet 146. In other words, the third metal wall 145 is connected between the ground layer 12 and the fourth area 1463b of the metal connection sheet 146. One end of the second metal wall 144 is connected to the third area 1463a of the metal connection sheet 146, and the other end is connected to the second area 142b of the second metal layer 142. In other words, the second metal wall 144 is connected between the third area 1463a of the metal connection sheet 146 and the second area 142b of the second metal layer 142. One end of the first metal wall 143 is connected to the first area 142a of the second metal layer 142, and the other end is connected to the first metal layer 141. In other words, the first metal wall 143 is connected between the first area 142a of the second metal layer 142 and the first metal layer 141.

In this implementation, a projection of the third metal wall 145 on the metal connection sheet 146 does not overlap a projection of the second metal wall 144 on the metal connection sheet 146. In addition, a projection of the second metal wall 144 on the second metal layer 142 does not overlap a projection of the first metal wall 143 on the second metal layer 142. In another implementation, a projection of the third metal wall 145 on the metal connection sheet 146 at least partly overlaps a projection of the second metal wall 144 on the metal connection sheet 146.

For example, the first edge 1421 of the second metal layer 142 is disposed opposite the first edge 1411 of the first metal layer 141. The third edge 1423 of the second metal layer 142 is disposed opposite the third edge 1413 of the first metal layer 141.

The second metal layer 142, the first metal wall 143, the second metal wall 144, the third metal wall 145, the metal connection sheet 146, and the ground layer 12 circle up to form a first space S1. It can be understood that another component of the antenna structure 10 may be disposed in the first space S1. In this way, on one hand, space utilization of the antenna structure 10 is high. On the other hand, the antenna structure 10 may be compactly disposed, to facilitate miniaturization of the antenna structure 10.

In this embodiment, as the second metal wall 144 and the third metal wall 145 are spaced from each other in two areas of the metal connection sheet 146, and the first metal wall 143 and the second metal wall 144 are spaced from each other in two areas of the second metal layer 142, when the first antenna element 14a is in a working state, a current path includes the ground layer 12, the third metal wall 145, the metal connection sheet 146, the second metal wall 144, the second metal layer 142, the first metal wall 143, and the first metal layer 141. Because a current may be transmitted between the third area 1463a and the fourth area 1463b of the metal connection sheet 146 and transmitted between the first area 142a and the second area 142b of the second metal layer 142, the current path may be disposed as bent twice. In this way, compared with an antenna structure that has a same current path, where the current path of the antenna structure is straight, a cross-sectional height H of the antenna structure 10 in this embodiment is smaller, to facilitate miniaturization of the antenna structure 10.

In another implementation, the first antenna element 14a may not include the third metal wall 145 or the metal connection sheet 146. In this case, the second metal wall 144 is directly connected to the ground layer 12. In this way, a current path of the first antenna element 14a is disposed as bent once.

In another implementation, the first antenna element 14a may further include a second metal connection sheet, a third metal connection sheet, ..., and an $m^{th}$ metal connection sheet, where m is an integer and is greater than 1. For a manner of disposing the $m^{th}$ metal connection sheet, refer to the manner of disposing the metal connection sheet 146a. In addition, the first antenna element 14a may further include a fourth metal wall, a fifth metal wall, ..., and an $n^{th}$ metal wall, where n is an integer and is greater than 3. In this way, as the $m^{th}$ metal connection sheet and the $n^{th}$ metal wall are disposed, the current path of the first antenna element 14a can be disposed as bent a plurality of times.

For example, the first antenna element 14a may be a symmetric structure, a partly symmetric structure, a structure having same or similar parts, or a structure having different parts. In this embodiment, the first antenna element 14a is a symmetric structure. Specifically, refer to FIG. 37 again. The first antenna element 14a is symmetrical along a symmetry plane of the first antenna element 14a. The symmetry plane of the first antenna element 14a is perpendicular to the plane on which the first metal layer 141 is located, and the diagonal line M1 of the first metal layer 141 is located on the symmetry plane of the first antenna element 14a.

FIG. 38 is a schematic diagram of the structure of the antenna structure 10 shown in FIG. 33. For a manner of disposing the second antenna element 14b, the third antenna element 14c, and the fourth antenna element 14d, refer to the manner of disposing the first antenna element 14a. In addition, for a location relationship and a connection relationship between the first antenna element 14a, the second antenna element 14b, the third antenna element 14c, and the fourth antenna element 14d, refer to the location relationship and the connection relationship between the first antenna element 14a, the second antenna element 14b, the third antenna element 14c, and the fourth antenna element 14d in the first embodiment. Details are not described herein again.

In this embodiment, new spaces are created in the antenna structure 10 by compactly disposing various parts of structures of the antenna elements 14. To be specific, the first space S1 (refer to FIG. 36), a second space S2 (refer to FIG. 36), a third space (not shown in the figure), and a fourth space (not shown in the figure) are formed in the antenna structure 10. It can be understood that other components of the antenna structure 10 may be disposed in the first space S1, the second space S2, the third space, and the fourth space. In this way, on one hand, space utilization of the antenna structure 10 is high. On the other hand, the structure of the antenna structure 10 is compact, to facilitate miniaturization of the antenna structure 10. In addition, a current path of the antenna structure 10 is set to bent twice. In this way, compared with an antenna structure that has a same current path, where the current path of the antenna structure is straight, not only a cross-sectional height H of the antenna structure 10 in this embodiment is smaller, widths of the first gap 191, the second gap 192, the third gap 193, and the fourth gap 194 in the antenna structure 10 are also smaller.

For example, the second antenna element 14b and the first antenna element 14a may be symmetrical, partly symmetrical, have a same or similar structure, or have different structures. The second antenna element 14b and the first antenna element 14a form a symmetric structure. Specifically, the second antenna element 14b and the first antenna element 14a are symmetrical along a first symmetry plane. The first symmetry plane is perpendicular to a plane on which the first metal layer 141 of the first antenna element 14a is located, and a central plane N1 between the first antenna element 14a and the second antenna element 14b is located on the first symmetry plane.

For example, the third antenna element 14c and the first antenna element 14a may be symmetrical, partly symmetrical, have a same or similar structure, or have different structures. In this embodiment, the third antenna element 14c and the first antenna element 14a form a symmetric structure. Specifically, the third antenna element 14c and the first antenna element 14a are symmetrical along a second symmetry plane. The second symmetry plane is perpendicular to a plane on which the first metal layer 171 of the third antenna element 14c is located, and a central plane N2 between the first antenna element 14a and the third antenna element 14c is located on the second symmetry plane.

For example, the fourth antenna element 14d and the third antenna element 14c may be symmetrical, partly symmetrical, have a same or similar structure, or have different structures. In this embodiment, the fourth antenna element 14d and the third antenna element 14c form a symmetric structure. Specifically, the fourth antenna element 14d and the third antenna element 14c are symmetrical along the first symmetry plane. The central plane N1 is also a central line between the fourth antenna element 14d and the third antenna element 14c.

For example, the fourth antenna element 14d and the second antenna element 14b may be symmetrical, or partly symmetrical, have a same or similar structure, or have different structures. In this embodiment, the fourth antenna element 14d and the second antenna element 14b form a symmetric structure. Specifically, the fourth antenna element 14d and the second antenna element 14b are symmetrical along the second symmetry plane. The central plane N2 is also a central line between the second antenna element 14b and the fourth antenna element 14d.

For example, the first antenna element 14a, the second antenna element 14b, the third antenna element 14c, and the fourth antenna element 14d may be centrosymmetric, partly centrosymmetric, have a same or similar structure, or have different structures. In this embodiment, the first antenna element 14a, the second antenna element 14b, the third antenna element 14c, and the fourth antenna element 14d are centrosymmetric with respect to a central axis. The central axis is an intersection point of the central plane N1 and the central plane N2.

Refer to FIG. 38 again. The plurality of matching metal walls 15 are located on a periphery of the ground layer 12, that is, the plurality of matching metal walls 15 are disposed near edges of the ground layer 12. The plurality of matching metal walls 15 are disposed around the periphery of the ground layer 12.

For example, there are four matching metal walls 15. The four matching metal walls 15 are located at four corners of the ground layer 12. For example, each of the matching metal walls 15 has an "L" shape or an arc shape.

It can be understood that, as the plurality of matching metal walls 15 that are spaced from each other are disposed on the ground layer 12, the matching metal walls 15 can enlarge a current path between the antenna elements 14 and the ground layer 12. The matching metal walls 15 may be configured to tune impedance of the antenna structure 10, to implement impedance matching. In addition, because the matching metal walls 15 can increase the current path between the antenna elements 14 and the ground layer 12, sizes of the antenna elements 14 and the ground layer 12 in this embodiment may be made small, to achieve miniaturization of the antenna structure 10.

In another implementation, for a manner of disposing the antenna structure 10 in this embodiment, refer to the manner of disposing the antenna structure 10 in the second implementation in the first embodiment. In this case, a current path of the antenna structure 10 may be disposed as bent a plurality of times. In addition, the antenna structure 10 further includes metal short-circuit hole groups 19. In this case, a bandwidth capability of the antenna structure 10 may be further improved, and a new trap point is generated.

In another implementation, for a manner of disposing the antenna structure 10 in this embodiment, refer to the manner of disposing the antenna structure 10 in the third implementation in the first embodiment. For example, the antenna structure 10 further includes the metal short-circuit hole groups 19.

The foregoing descriptions are merely specific implementations of this application, but are not intended to limit the protection scope of this application. Therefore, the protection scope of this application shall be subject to the protection scope of the claims.

**Claims**

1. A chip (21), comprising a package substrate (51), an injection molded piece, a chip body (40), and an antenna structure (10), wherein both the antenna structure (10) and the chip body (40) are disposed on the package substrate (51) and are electrically connected to the package substrate (51), and the injection molded piece is configured to package the antenna structure (10) and the chip body (40), the antenna structure (10) comprises a ground layer (12), a feeding element (13), and an antenna element (14, 14a), wherein

   the antenna element (14, 14a) comprises a first metal layer (141, 161, 171, 181), a second metal layer (142, 162, 172, 182), a first conducting member, and a second conducting member, the first metal layer (141, 161, 171, 181) and the ground layer (12) are disposed opposite and spaced from each other, the second metal layer (142, 162, 172, 182) is located between the first metal layer (141, 161, 171, 181) and the ground layer (12) and is spaced from both the first metal layer (141, 161, 171, 181) and the ground layer (12), the second metal layer (142, 162, 172, 182) comprises a first area (142a, 162a, 172a, 182a) and a second area (142b, 162b, 172b, 182b) that are spaced from each other, the first conducting member is connected between the first metal layer (141, 161, 171, 181) and the first area (142a, 162a, 172a, 182a) of the second metal layer (142, 162, 172, 182), and the second conducting member is connected between the ground layer (12) and the second area (142b, 162b, 172b, 182b) of the second metal layer (142, 162, 172, 182); and
   the feeding element (13) comprises a feeding branch (131, 132), a projection of a part of the feeding branch (131, 132) on a plane, on which the first metal layer (141, 161, 171, 181) is located, falls within the first metal layer (141, 161, 171, 181), and the feeding element (13) is configured to feed the second metal layer (142, 162, 172, 182) and the first metal layer (141, 161, 171, 181).

2. The chip (21) according to claim 1, wherein a projection of the first metal layer (141, 161, 171, 181) on the ground layer (12) falls within the ground layer (12); a projection of the second metal layer (142, 162, 172, 182) on a plane, on which the first metal layer (141, 161, 171, 181) is located, falls within the first metal layer (141, 161, 171, 181).

3. The chip (21) according to claim 1 or 2, wherein there are four antenna elements (14), the four antenna elements (14) are arranged in two rows and two columns and are spaced from each other, and the four antenna elements (14) are a first antenna element (14, 14a), a second antenna element (14b), a third antenna element (14c), and a fourth antenna element (14d);

   a first edge (1611) of the first metal layer (161) of the second antenna element (14b) and the first edge (1411) of the first metal layer (141) of the first antenna element (14, 14a) form a first gap (191);
   a third edge (1713) of the first metal layer (171) of the third antenna element (14c) and the third edge (1413) of the first metal layer (141) of the first antenna element (14, 14a) form a second gap (192);

a first edge (1811) of the first metal layer (181) of the fourth antenna element (14d) and the first edge (1711) of the first metal layer (171) of the third antenna element (14c) form a third gap (193); and

a third edge (1813) of the first metal layer (181) of the fourth antenna element (14d) and the third edge (1613) of the first metal layer (161) of the second antenna element (14b) form a fourth gap (194),

wherein the fourth gap (194) is interconnected to the first gap (191), the second gap (192), and the third gap (193), and wherein the first gap (191), the second gap (192), the third gap (193), and the fourth gap (194) form a "cruciform" shape.

4. The chip (21) according to claim 3, wherein the feeding branch (131, 132) comprises a first feeding branch (131) and a second feeding branch (132) that are spaced from each other, and the feeding element (13) further includes a first metal hole (133) and a second metal hole (134) that are spaced from each other, the first metal hole (133) is connected to the first feeding branch (131) and the second metal hole (134) is connected to the second feeding branch (132), and wherein projections of the first metal hole (133) and the second metal hole (134) on a plane, on which the first metal layer (141, 161, 171, 181) is located, falls within the first metal layer (141, 161, 171, 181).

5. The chip (21) according to claim 4, wherein the chip further comprises a radio frequency circuit (20), the ground layer (12) is provided with a first through hole (121) and a second through hole (122) that are spaced from each other, the first metal hole (133) is electrically connected to the radio frequency circuit (20) through the first through hole (121), and the second metal hole (134) is electrically connected to the radio frequency circuit (20) through the second through hole (122).

6. The chip (21) according to claim 5, wherein the first conducting member is a plurality of first metal columns (143, 163, 173, 183); and
the second conducting member comprises a first metal connection sheet (146a, 166a, 176a, 186a), a plurality of second metal columns (14, 144, 164, 174, 184), and a plurality of third metal columns (145, 165, 175, 185), wherein the first metal connection sheet (146a, 166a, 176a, 186a) is located between the second metal layer (142, 162, 172, 182) and the ground layer (12), the plurality of second metal columns (14, 144, 164, 174, 184) are connected between the first metal connection sheet (146a, 166a, 176a, 186a) and the second area (142b, 162b, 172b, 182b) of the second metal layer (142, 162, 172, 182), and the plurality of third metal columns (145, 165, 175, 185) are connected between the first metal connection sheet (146a, 166a, 176a, 186a) and the ground layer (12).

7. The chip (21) according to claim 6, wherein the plurality of third metal columns (145, 165, 175, 185) are disposed half-round the first through hole (121), and the plurality of third metal columns (145, 165, 175, 185) are disposed half-round the second through hole (122).

8. The chip (21) according to claim 6 or 7, wherein a diameter of the third metal column (145, 165, 175, 185) is greater than a diameter of the second metal column (14, 144, 164, 174, 184).

9. The chip (21) according to any one of claims 6 to 8, wherein the chip satisfies at least one of the following:

the plurality of first metal columns (143, 163, 173, 183) are arranged into an L shape or an arc shape;
the first metal connection sheet (146a, 166a, 176a, 186a) has an L shape or an arc shape;
the plurality of second metal columns (14, 144, 164, 174, 184) are arranged into an L shape or an arc shape;
and the plurality of third metal columns (145, 165, 175, 185) are arranged into an L shape or an arc shape.

10. The chip (21) according to any one of claims 6 to 9, wherein projections of the third metal columns (145, 165, 175, 185) on the first metal connection sheet (146a, 166a, 176a, 186a) at least partly overlap projections of the second metal columns (14, 144, 164, 174, 184) on the first metal connection sheet (146a, 166a, 176a, 186a).

11. The chip (21) according to any one of claims 3 to 10, wherein the four antenna elements (14) have a central point, a second conducting member of the first antenna element (14, 14a) is located on a side that is of a first conducting member of the first antenna element (14, 14a) and that is farther away from the central point, a second conducting member of the second antenna element (14b) is located on a side that is of a first conducting member of the second antenna element (14b) and that is farther away from the central point, a second conducting member of the third antenna element (14c) is located on a side that is of a first conducting member of the third antenna element (14c) and that is farther away from the central point, and a second conducting member of the fourth antenna element (14d) is located on a side that is of a first conducting member of the fourth antenna element (14d) and that is farther away from the central point.

12. The chip (21) according to any one of claims 3 to 11, wherein the feeding branch (131, 132) is located in a space encircled by the second conducting member of the first antenna element (14, 14a), the second conducting member of the second antenna element (14b), the second conducting member of the third antenna element (14c), and the second conducting member of the fourth antenna element (14d).

13. The chip (21) according to any one of claims 3 to 12, wherein the first antenna element (14, 14a), the second antenna element (14b), the third antenna element (14c), and the fourth antenna element (14d) form a centrosymmetric structure.

14. The chip (21) according to any one of claims 3 to 13, wherein

the third antenna element (14c) and the first antenna element (14a) form a symmetric structure, and the third antenna element (14c) and the first antenna element (14a) are symmetrical along a second symmetry plane (N2); the fourth antenna element (14d) and the second antenna element (14b) form a symmetric structure, and the fourth antenna element (14c) and the second antenna element (14b) are symmetrical along the second symmetry plane (N2).

15. The chip (21) according to claim 3, wherein the feeding branch (131, 132) comprises a first feeding branch (131) and a second feeding branch (132) that are spaced from each other;

a projection of one end of the first feeding branch (131) on the plane on which the first metal layer (141, 161, 171, 181) of the first antenna element (14, 14a) is located, falls within the first metal layer (141, 161, 171, 181) of the first antenna element (14, 14a); and a projection of the other end of the first feeding branch (131) on the plane on which the first metal layer (141, 161, 171, 181) of the fourth antenna element (14d) is located, falls within the first metal layer (141, 161, 171, 181) of the fourth antenna element (14d), and the first feeding branch (131) is configured to feed the second metal layer (142, 162, 172, 182) of the first antenna element (14, 14a), a first metal layer (141, 161, 171, 181) of the first antenna element (14, 14a), the second metal layer (142, 162, 172, 182) of the fourth antenna element (14d), and a first metal layer (141, 161, 171, 181) of the fourth antenna element (14d); and a projection of one end of the second feeding branch (132) on the plane on which the first metal layer (141, 161, 171, 181) of the second antenna element (14b) is located, falls within the first metal layer (141, 161, 171, 181) of the second antenna element (14b); and a projection of the other end of the second feeding branch (132) on the plane on which the first metal layer (141, 161, 171, 181) of the third antenna element (14c) is located, falls within the first metal layer (141, 161, 171, 181) of the third antenna element (14c), and the second feeding branch (132) is configured to feed the second metal layer (142, 162, 172, 182) of the second antenna element (14b), a first metal layer (141, 161, 171, 181) of the second antenna element (14b), the second metal layer (142, 162, 172, 182) of the third antenna element (14c), and a first metal layer (141, 161, 171, 181) of the third antenna element (14c).

16. The chip (21) according to claim 15, wherein the four antenna elements (14) have a central point, the first antenna element (14, 14a), the second antenna element (14b), the third antenna element (14c), and the fourth antenna element (14d) are all symmetric structures, and a symmetry plane of the first antenna element (14, 14a), a symmetry plane of the second antenna element (14b), a symmetry plane of the third antenna element (14c), and a symmetry plane of the fourth antenna element (14d) all pass through the central point; and an extension direction of the first feeding branch (131) is parallel to the symmetry plane of the first antenna element (14, 14a) and the symmetry plane of the fourth antenna element (14d), and an extension direction of the second feeding branch (132) is parallel to the symmetry plane of the second antenna element (14b) and the symmetry plane of the third antenna element (14c).

17. The chip (21) according to claim 15 or 16, wherein the first feeding branch (131) comprises a first part (1311, 1321), a second part (1312a, 1322), a third part (1312b, 1323), a fourth part (1312c), and a fifth part (1313) that are sequentially connected; a projection of a part of the first part (1311) on the plane on which the first metal layer (141, 161, 171, 181) of the first antenna element (14, 14a) is located, falls within the first metal layer (141, 161, 171, 181) of the first antenna element (14, 14a); and a projection of a part of the fifth part (1313) on the plane on which the first metal layer (141, 161, 171, 181) of the fourth antenna element (14d) is located, falls within the first metal layer (141, 161, 171, 181) of the fourth antenna element (14d).

18. The chip (21) according to claim 17, wherein a distance between the first part (1311, 1321) and the ground layer (12), a distance between the fifth part (1313) and the ground layer (12), and a distance between the second feeding branch (132) and the ground layer (12) are all equal; the second part (1312a, 1322), the third part (1312b, 1323), and the fourth part (1312c) of the first feeding branch (131) form a "U" shape; and the third part (1312b, 1323) is located between the second feeding branch (132) and the ground layer (12).

19. The chip (21) according to any one of claims 15 to 18, wherein the second feeding branch (132) includes a first part (1321), a second part (1322), and a third part (1323) that are sequentially connected, a projection of a part of the first part (1321) on the plane on which the first metal layer (141, 161, 171, 181) of the third antenna element (14c) is located, falls within the first metal layer (141, 161, 171, 181) of the third antenna element (14c); and a projection of a part of the third part (1323) on the plane on which the first metal layer (141, 161, 171, 181) of the second antenna element (14b) is located, falls within the first metal layer (141, 161, 171, 181) of the second antenna element (14b).

20. The chip (21) according to any one of claims 15 to 19, wherein the first feeding branch (131) and the second feeding branch (132) satisfy one of the following:

an included angle between the extension direction of the first feeding branch (131) and the first edge (1411) of the first metal layer (141) of the first antenna element (14a) is 45°;
an included angle between the extension direction of the first feeding branch (131) and the first edge (1811) of the first metal layer (181) of the fourth antenna element (14d) is 45°;
an included angle between the extension direction of the second feeding branch (132) and the first edge (1711) of the first metal layer (171) of the third antenna element (14c) is 45°; and
an included angle between the extension direction of the second feeding branch (132) and the first edge (1611) of the first metal layer (161) of the second antenna element (14b) is 45°.

21. The chip (21) according to any one of claims 3 to 20, wherein the antenna structure (10) further comprises a plurality of metal short-circuit hole groups, and the plurality of metal short-circuit hole groups are electrically connected to the ground layer (12) and are located on a periphery of the first antenna element (14, 14a), the second antenna element (14b), the third antenna element (14c), and the fourth antenna element (14d); and the first antenna element (14, 14a) and the second antenna element (14b) form a first gap (191), at least one metal short-circuit hole group is disposed in an extension direction of the first gap (191), the first antenna element (14, 14a) and the third antenna element (14c) form a second gap (192), at least one metal short-circuit hole group is disposed in an extension direction of the second gap (192), the third antenna element (14c) and the fourth antenna element (14d) form a third gap (193), at least one metal short-circuit hole group is disposed in an extension direction of the third gap (193), the fourth antenna element (14d) and the second antenna element (14b) form a fourth gap (194), and at least one metal short-circuit hole group is disposed in an extension direction of the fourth gap (194).

22. The chip (21) according to any one of claims 3 to 21, wherein the antenna structure (10) further comprises a plurality of matching via groups, the plurality of matching via groups are electrically connected to the ground layer (12), the plurality of matching via groups are located on the periphery of the antenna elements (14), and the plurality of matching via groups are disposed around the antenna elements (14).

23. The chip (21) according to any one of claims 1 to 22, wherein the antenna structure is an antenna configured to transmit and receive in a millimeter-wave frequency band.

24. The chip (21) according to claim 23, wherein the antenna structure is configured to support frequency bands n257, n258, n259, n260, and n261.

25. The chip (21) according to claim 23, wherein the antenna structure is configured to work in an operating frequency band ranging from 24.25 GHz to 29.5 GHz and from 37 GHz to 43.5 GHz.

26. An electronic device, comprising a circuit board (30) and the chip (21) according to any one of claims 1 to 25, wherein the chip (21) is disposed on the circuit board (30), and the package substrate (51) of the chip (21) is electrically connected to the circuit board (30).

**Patentansprüche**

1. Chip (21), der ein Gehäusesubstrat (51), ein spritzgegossenes Stück, einen Chipkörper (40) und eine Antennenstruktur (10) umfasst, wobei sowohl die Antennenstruktur (10) als auch der Chipkörper (40) auf dem Gehäusesubstrat (51) angeordnet und mit dem Gehäusesubstrat (51) elektrisch verbunden sind, und das spritzgegossene Stück konfiguriert ist, um die Antennenstruktur (10) und den Chipkörper (40) zu verpacken, wobei die Antennenstruktur (10) eine Erdungsschicht (12), ein Speiseelement (13) und ein Antennenelement (14, 14a) umfasst, wobei das Antennenelement (14, 14a) eine erste Metallschicht (141, 161, 171, 181), eine zweite Metallschicht (142, 162, 172, 182), ein erstes leitfähiges Glied und ein zweites leitfähiges Glied umfasst, wobei die erste Metallschicht (141, 161, 171, 181) und die Erdungsschicht (12) gegenüberliegend und voneinander beabstandet angeordnet sind, sich die zweite Metallschicht (142, 162, 172, 182) zwischen der ersten Metallschicht (141, 161, 171, 181) und der Erdungsschicht (12) befindet und sowohl von der ersten Metallschicht (141, 161, 171, 181) als auch von der Erdungsschicht (12) beabstandet ist, die zweite Metallschicht (142, 162, 172, 182) einen ersten Bereich (142a, 162a, 172a, 182a) und einen zweiten Bereich (142b, 162b, 172b, 182b), die voneinander beabstandet sind, umfasst, das erste leitfähige Glied zwischen der ersten Metallschicht (141, 161, 171, 181) und dem ersten Bereich (142a, 162a, 172a, 182a) der zweiten Metallschicht (142, 162, 172, 182) verbunden ist und das zweite leitfähige Glied zwischen der Erdungsschicht (12) und dem zweiten Bereich (142b, 162b, 172b, 182b) der zweiten Metallschicht (142, 162, 172, 182) verbunden ist; und

das Speiseelement (13) einen Speisezweig (131, 132) umfasst, eine Projektion eines Teils des Speisezweigs (131, 132) auf eine Ebene, auf der sich die erste Metallschicht (141, 161, 171, 181) befindet, in die erste Metallschicht (141, 161, 171, 181) fällt und das Speiseelement (13) konfiguriert ist, um die zweite Metallschicht (142, 162, 172, 182) und die erste Metallschicht (141, 161, 171, 181) zu speisen.

2.  Chip (21) nach Anspruch 1, wobei eine Projektion der ersten Metallschicht (141, 161, 171, 181) auf die Erdungsschicht (12) in die Erdungsschicht (12) fällt; eine Projektion der zweiten Metallschicht (142, 162, 172, 182) auf eine Ebene, auf der sich die erste Metallschicht (141, 161, 171, 181) befindet, in die erste Metallschicht (141, 161, 171, 181) fällt.

3.  Chip (21) nach Anspruch 1 oder 2, wobei vier Antennenelemente (14) vorhanden sind, die vier Antennenelemente (14) in zwei Reihen und zwei Spalten eingerichtet sind und voneinander beabstandet sind und die vier Antennenelemente (14) ein erstes Antennenelement (14, 14a), ein zweites Antennenelement (14b), ein drittes Antennenelement (14c) und ein viertes Antennenelement (14d) sind;

    eine erste Kante (1611) der ersten Metallschicht (161) des zweiten Antennenelements (14b) und die erste Kante (1411) der ersten Metallschicht (141) des ersten Antennenelements (14, 14a) einen ersten Spalt (191) bilden; eine dritte Kante (1713) der ersten Metallschicht (171) des dritten Antennenelements (14c) und die dritte Kante (1413) der ersten Metallschicht (141) des ersten Antennenelements (14, 14a) einen zweiten Spalt (192) bilden; eine erste Kante (1811) der ersten Metallschicht (181) des vierten Antennenelements (14d) und die erste Kante (1711) der ersten Metallschicht (171) des dritten Antennenelements (14c) einen dritten Spalt (193) bilden; und eine dritte Kante (1813) der ersten Metallschicht (181) des vierten Antennenelements (14d) und die dritte Kante (1613) der ersten Metallschicht (161) des zweiten Antennenelements (14b) einen vierten Spalt (194) bilden, wobei der vierte Spalt (194) mit dem ersten Spalt (191), dem zweiten Spalt (192) und dem dritten Spalt (193) verbunden ist und wobei der erste Spalt (191), der zweite Spalt (192), der dritte Spalt (193) und der vierte Spalt (194) eine "kreuzförmige" Form bilden.

4.  Chip (21) nach Anspruch 3, wobei der Speisezweig (131, 132) einen ersten Speisezweig (131) und einen zweiten Speisezweig (132), die voneinander beabstandet sind, umfasst und das Speiseelement (13) ferner ein erstes Metallloch (133) und ein zweites Metallloch (134), die voneinander beabstandet sind, einschließt, das erste Metallloch (133) mit dem ersten Speisezweig (131) verbunden ist und das zweite Metallloch (134) mit dem zweiten Speisezweig (132) verbunden ist und wobei Projektionen des ersten Metalllochs (133) und des zweiten Metalllochs (134) auf eine Ebene, auf der sich die erste Metallschicht (141, 161, 171, 181) befindet, in die erste Metallschicht (141, 161, 171, 181) fallen.

5.  Chip (21) nach Anspruch 4, wobei der Chip ferner eine Hochfrequenzschaltung (20) umfasst, die Erdungsschicht (12) mit einem ersten Durchgangsloch (121) und einem zweiten Durchgangsloch (122), die voneinander beabstandet sind, versehen ist, das erste Metallloch (133) durch das erste Durchgangsloch (121) mit der Hochfrequenzschaltung (20) elektrisch verbunden ist und das zweite Metallloch (134) durch das zweite Durchgangsloch (122) mit der Hochfrequenzschaltung (20) elektrisch verbunden ist.

6.  Chip (21) nach Anspruch 5, wobei das erste leitfähige Glied eine Vielzahl von ersten Metallsäulen (143, 163, 173, 183) ist; und das zweite leitfähige Glied ein erstes Metallverbindungsblech (146a, 166a, 176a, 186a), eine Vielzahl von zweiten Metallsäulen (14, 144, 164, 174, 184) und eine Vielzahl von dritten Metallsäulen (145, 165, 175, 185) umfasst, wobei sich das erste Metallverbindungsblech (146a, 166a, 176a, 186a) zwischen der zweiten Metallschicht (142, 162, 172, 182) und der Erdungsschicht (12) befindet, die Vielzahl von zweiten Metallsäulen (14, 144, 164, 174, 184) zwischen dem ersten Metallverbindungsblech (146a, 166a, 176a, 186a) und dem zweiten Bereich (142b, 162b, 172b, 182b) der zweiten Metallschicht (142, 162, 172, 182) verbunden sind und die Vielzahl von dritten Metallsäulen (145, 165, 175, 185) zwischen dem ersten Metallverbindungsblech (146a, 166a, 176a, 186a) und der Erdungsschicht (12) verbunden sind.

7. Chip (21) nach Anspruch 6, wobei die Vielzahl von dritten Metallsäulen (145, 165, 175, 185) in einem Halbrund um das erste Durchgangsloch (121) angeordnet sind und die Vielzahl von dritten Metallsäulen (145, 165, 175, 185) in einem Halbrund um das zweite Durchgangsloch (122) angeordnet sind.

8. Chip (21) nach Anspruch 6 oder 7, wobei ein Durchmesser der dritten Metallsäule (145, 165, 175, 185) größer ist als ein Durchmesser der zweiten Metallsäule (14, 144, 164, 174, 184).

9. Chip (21) nach einem der Ansprüche 6 bis 8, wobei der Chip mindestens eines von Folgenden erfüllt:

   die Vielzahl von ersten Metallsäulen (143, 163, 173, 183) sind in einer L-Form oder einer Bogenform eingerichtet;
   das erste Metallverbindungsblech (146a, 166a, 176a, 186a) weist eine L-Form oder eine Bogenform auf;
   die Vielzahl von zweiten Metallsäulen (14, 144, 164, 174, 184) sind in einer L-Form oder einer Bogenform eingerichtet;
   und die Vielzahl von dritten Metallsäulen (145, 165, 175, 185) sind in einer L-Form oder einer Bogenform eingerichtet.

10. Chip (21) nach einem der Ansprüche 6 bis 9, wobei Projektionen der dritten Metallsäulen (145, 165, 175, 185) auf das erste Metallverbindungsblech (146a, 166a, 176a, 186a) mindestens teilweise Projektionen der zweiten Metallsäulen (14, 144, 164, 174, 184) auf das erste Metallverbindungsblech (146a, 166a, 176a, 186a) überlappen.

11. Chip (21) nach einem der Ansprüche 3 bis 10, wobei die vier Antennenelemente (14) einen Mittelpunkt aufweisen, sich ein zweites leitfähiges Glied des ersten Antennenelements (14, 14a) auf einer Seite befindet, die von einem ersten leitfähigen Glied des ersten Antennenelements (14, 14a) ist und die vom Mittelpunkt weiter entfernt ist, sich ein zweites leitfähiges Glied des zweiten Antennenelements (14b) auf einer Seite, die von einem ersten leitfähigen Glied des zweiten Antennenelements (14b) ist und die vom Mittelpunkt weiter entfernt ist, befindet, sich ein zweites leitfähiges Glied des dritten Antennenelements (14c) auf einer Seite, die von einem ersten leitfähigen Glied des dritten Antennenelements (14c) ist und die vom Mittelpunkt weiter entfernt ist, befindet und sich ein zweites leitfähiges Glied des vierten Antennenelements (14d) auf einer Seite, die von einem ersten leitfähigen Glied des vierten Antennenelements (14d) ist und die vom Mittelpunkt weiter entfernt ist, befindet.

12. Chip (21) nach einem der Ansprüche 3 bis 11, wobei sich der Speisezweig (131, 132) in einem Raum, der von dem zweiten leitfähigen Glied des ersten Antennenelements (14, 14a), dem zweiten leitfähigen Glied des zweiten Antennenelements (14b), dem zweiten leitfähigen Glied des dritten Antennenelements (14c) und dem zweiten leitfähigen Glied des vierten Antennenelements (14d) umschlossen wird, befindet.

13. Chip (21) nach einem der Ansprüche 3 bis 12, wobei das erste Antennenelement (14, 14a), das zweite Antennenelement (14b), das dritte Antennenelement (14c) und das vierte Antennenelement (14d) eine zentralsymmetrische Struktur bilden.

14. Chip (21) nach einem der Ansprüche 3 bis 13, wobei das dritte Antennenelement (14c) und das erste Antennenelement (14a) eine symmetrische Struktur bilden und das dritte Antennenelement (14c) und das erste Antennenelement (14a) symmetrisch entlang einer zweiten Symmetrieebene (N2) sind; das vierte Antennenelement (14d) und das zweite Antennenelement (14b) eine symmetrische Struktur bilden und das vierte Antennenelement (14c) und das zweite Antennenelement (14b) symmetrisch entlang der zweiten Symmetrieebene (N2) sind.

15. Chip (21) nach Anspruch 3, wobei der Speisezweig (131, 132) einen ersten Speisezweig (131) und einen zweiten Speisezweig (132) umfasst, die voneinander beabstandet sind; eine Projektion eines Endes des ersten Speisezweigs (131) auf die Ebene, auf der sich die erste Metallschicht (141, 161, 171, 181) des ersten Antennenelements (14, 14a) befindet, in die erste Metallschicht (141, 161, 171, 181) des ersten Antennenelements (14, 14a) fällt; und eine Projektion des anderen Endes des ersten Speisezweigs (131) auf die Ebene, auf der sich die erste Metallschicht (141, 161, 171, 181) des vierten Antennenelements (14d) befindet, in die erste Metallschicht (141, 161, 171, 181) des vierten Antennenelements (14d) fällt und der erste Speisezweig (131) konfiguriert ist, um die zweite Metallschicht (142, 162, 172, 182) des ersten Antennenelements (14, 14a), eine erste Metallschicht (141, 161, 171, 181) des ersten Antennenelements (14, 14a), die zweite Metallschicht (142, 162, 172, 182) des vierten Antennenelements (14d) und eine erste Metallschicht (141, 161, 171, 181) des vierten Antennenelements (14d) zu speisen; und

eine Projektion eines Endes des zweiten Speisezweigs (132) auf die Ebene, auf der sich die erste Metallschicht (141, 161, 171, 181) des zweiten Antennenelements (14b) befindet, in die erste Metallschicht (141, 161, 171, 181) des zweiten Antennenelements (14b) fällt; und eine Projektion des anderen Endes des zweiten Speisezweigs (132) auf die Ebene, auf der sich die erste Metallschicht (141, 161, 171, 181) des dritten Antennenelements (14c) befindet, in die erste Metallschicht (141, 161, 171, 181) des dritten Antennenelements (14c) fällt und der zweite Speisezweig (132) konfiguriert ist, um die zweite Metallschicht (142, 162, 172, 182) des zweiten Antennenelements (14b), eine erste Metallschicht (141, 161, 171, 181) des zweiten Antennenelements (14b), die zweite Metallschicht (142, 162, 172, 182) des dritten Antennenelements (14c) und eine erste Metallschicht (141, 161, 171, 181) des dritten Antennenelements (14c) zu speisen.

16. Chip (21) nach Anspruch 15, wobei die vier Antennenelemente (14) einen Mittelpunkt aufweisen, das erste Antennenelement (14, 14a), das zweite Antennenelement (14b), das dritte Antennenelement (14c) und das vierte Antennenelement (14d) allesamt symmetrische Strukturen sind und eine Symmetrieebene des ersten Antennenelements (14, 14a), eine Symmetrieebene des zweiten Antennenelements (14b), eine Symmetrieebene des dritten Antennenelements (14c) und eine Symmetrieebene des vierten Antennenelements (14d) alle durch den Mittelpunkt verlaufen; und
eine Erstreckungsrichtung des ersten Speisezweigs (131) parallel zu der Symmetrieebene des ersten Antennenelements (14, 14a) und der Symmetrieebene des vierten Antennenelements (14d) ist und eine Erstreckungsrichtung des zweiten Speisezweigs (132) parallel zu der Symmetrieebene des zweiten Antennenelements (14b) und der Symmetrieebene des dritten Antennenelements (14c) ist.

17. Chip (21) nach Anspruch 15 oder 16, wobei der erste Speisezweig (131) einen ersten Teil (1311, 1321), einen zweiten Teil (1312a, 1322), einen dritten Teil (1312b, 1323), einen vierten Teil (1312c) und einen fünften Teil (1313), die sequenziell verbunden sind, umfasst; eine Projektion eines Teils des ersten Teils (1311) auf die Ebene, auf der sich die erste Metallschicht (141, 161, 171, 181) des ersten Antennenelements (14, 14a) befindet, in die erste Metallschicht (141, 161, 171, 181) des ersten Antennenelements (14, 14a) fällt; und eine Projektion eines Teils des fünften Teils (1313) auf die Ebene, auf der sich die erste Metallschicht (141, 161, 171, 181) des vierten Antennenelements (14d) befindet, in die erste Metallschicht (141, 161, 171, 181) des vierten Antennenelements (14d) fällt.

18. Chip (21) nach Anspruch 17, wobei ein Abstand zwischen dem ersten Teil (1311, 1321) und der Erdungsschicht (12), ein Abstand zwischen dem fünften Teil (1313) und der Erdungsschicht (12) und ein Abstand zwischen dem zweiten Speisezweig (132) und der Erdungsschicht (12) alle gleich sind; der zweite Teil (1312a, 1322), der dritte Teil (1312b, 1323) und der vierte Teil (1312c) des ersten Speisezweigs (131) eine "U"-Form bilden; und sich der dritte Teil (1312b, 1323) zwischen dem zweiten Speisezweig (132) und der Erdungsschicht (12) befindet.

19. Chip (21) nach einem der Ansprüche 15 bis 18, wobei der zweite Speisezweig (132) einen ersten Teil (1321), einen zweiten Teil (1322) und einen dritten Teil (1323), die sequenziell verbunden sind, einschließt, wobei eine Projektion eines Teils des ersten Teils (1321) auf die Ebene, auf der sich die erste Metallschicht (141, 161, 171, 181) des dritten Antennenelements (14c) befindet, in die erste Metallschicht (141, 161, 171, 181) des dritten Antennenelements (14c) fällt; und eine Projektion eines Teils des dritten Teils (1323) auf die Ebene, auf der sich die erste Metallschicht (141, 161, 171, 181) des zweiten Antennenelements (14b) befindet, in die erste Metallschicht (141, 161, 171, 181) des zweiten Antennenelements (14b) fällt.

20. Chip (21) nach einem der Ansprüche 15 bis 19, wobei der erste Speisezweig (131) und der zweite Speisezweig (132) eines von Folgenden erfüllen:

   ein eingeschlossener Winkel zwischen der Erstreckungsrichtung des ersten Speisezweigs (131) und der ersten Kante (1411) der ersten Metallschicht (141) des ersten Antennenelements (14a) beträgt 45°;
   ein eingeschlossener Winkel zwischen der Erstreckungsrichtung des ersten Speisezweigs (131) und der ersten Kante (1811) der ersten Metallschicht (181) des vierten Antennenelements (14d) beträgt 45°;
   ein eingeschlossener Winkel zwischen der Erstreckungsrichtung des zweiten Speisezweigs (132) und der ersten Kante (1711) der ersten Metallschicht (171) des dritten Antennenelements (14c) beträgt 45°; und
   ein eingeschlossener Winkel zwischen der Erstreckungsrichtung des zweiten Speisezweigs (132) und der ersten Kante (1611) der ersten Metallschicht (161) des zweiten Antennenelements (14b) beträgt 45°.

21. Chip (21) nach einem der Ansprüche 3 bis 20, wobei die Antennenstruktur (10) ferner eine Vielzahl von Metallkurzschlusslochgruppen umfasst und die Vielzahl von Metallkurzschlusslochgruppen mit der Erdungsschicht (12) elektrisch verbunden sind und sich an einer Peripherie des ersten Antennenelements (14, 14a), des zweiten Antennenelements (14b), des dritten Antennenelements (14c) und des vierten Antennenelements (14d) befinden; und das erste Antennenelement (14, 14a) und das zweite Antennenelement (14b) einen ersten Spalt (191) bilden, mindestens eine Metallkurzschlusslochgruppe in einer Erstreckungsrichtung des ersten Spalts (191) angeordnet ist, das erste Antennenelement (14, 14a) und das dritte Antennenelement (14c) einen zweiten Spalt (192) bilden, mindestens eine Metallkurzschlusslochgruppe in einer Erstreckungsrichtung des zweiten Spalts (192) angeordnet ist, das dritte Antennenelement (14c) und das vierte Antennenelement (14d) einen dritten Spalt (193) bilden, mindestens eine Metallkurzschlusslochgruppe in einer Erstreckungsrichtung des dritten Spalts (193) angeordnet ist, das vierte Antennenelement (14d) und das zweite Antennenelement (14b) einen vierten Spalt (194) bilden und mindestens eine Metallkurzschlusslochgruppe in einer Erstreckungsrichtung des vierten Spalts (194) angeordnet ist.

**22.** Chip (21) nach einem der Ansprüche 3 bis 21, wobei die Antennenstruktur (10) ferner eine Vielzahl von Anpassungsdurchkontaktierungsgruppen umfasst, die Vielzahl von Anpassungsdurchkontaktierungsgruppen mit der Erdungsschicht (12) elektrisch verbunden sind, sich die Vielzahl von Anpassungsdurchkontaktierungsgruppen an der Peripherie der Antennenelemente (14) befinden und die Vielzahl von Anpassungsdurchkontaktierungsgruppen um die Antennenelemente (14) herum angeordnet sind.

**23.** Chip (21) nach einem der Ansprüche 1 bis 22, wobei die Antennenstruktur eine Antenne ist, die konfiguriert ist, um in einem Millimeterwellenfrequenzband zu senden und zu empfangen.

**24.** Chip (21) nach Anspruch 23, wobei die Antennenstruktur konfiguriert ist, um Frequenzbänder n257, n258, n259, n260 und n261 zu unterstützen.

**25.** Chip (21) nach Anspruch 23, wobei die Antennenstruktur konfiguriert ist, um in einem Betriebsfrequenzband von 24,25 GHz bis 29,5 GHz und von 37 GHz bis 43,5 GHz zu arbeiten.

**26.** Elektronische Vorrichtung, die eine Leiterplatte (30) und den Chip (21) nach einem der Ansprüche 1 bis 25 umfasst, wobei der Chip (21) auf der Leiterplatte (30) angeordnet ist und das Gehäusesubstrat (51) des Chips (21) mit der Leiterplatte (30) elektrisch verbunden ist.

## Revendications

**1.** Puce (21), comprenant un substrat de boîtier (51), une pièce moulée par injection, un corps de puce (40) et une structure d'antenne (10), dans laquelle à la fois la structure d'antenne (10) et le corps de puce (40) sont disposés sur le substrat de boîtier (51) et sont connectés électriquement au substrat de boîtier (51), et la pièce moulée par injection est conçue pour conditionner la structure d'antenne (10) et le corps de puce (40), la structure d'antenne (10) comprend une couche de mise à la terre (12), un élément d'alimentation (13) et un élément d'antenne (14, 14a), dans laquelle l'élément d'antenne (14, 14a) comprend une première couche métallique (141, 161, 171, 181), une seconde couche métallique (142, 162, 172, 182), un premier organe conducteur et un second organe conducteur, la première couche métallique (141, 161, 171, 181) et la couche de mise à la terre (12) sont disposées de manière opposée et espacées l'une de l'autre, la seconde couche métallique (142, 162, 172, 182) est située entre la première couche métallique (141, 161, 171, 181) et la couche de mise à la terre (12) et est espacée à la fois de la première couche métallique (141, 161, 171, 181) et de la couche de mise à la terre (12), la seconde couche métallique (142, 162, 172, 182) comprend une première zone (142a, 162a, 172a, 182a) et une seconde zone (142b, 162b, 172b, 182b) qui sont espacées l'une de l'autre, le premier organe conducteur est connecté entre la première couche métallique (141, 161, 171, 181) et la première zone (142a, 162a, 172a, 182a) de la seconde couche métallique (142, 162, 172, 182), et le second organe conducteur est connecté entre la couche de mise à la terre (12) et la seconde zone (142b, 162b, 172b, 182b) de la seconde couche métallique (142, 162, 172, 182) ; et
l'élément d'alimentation (13) comprend une branche d'alimentation (131, 132), une saillie d'une partie de la branche d'alimentation (131, 132) sur un plan, sur lequel la première couche métallique (141, 161, 171, 181) est située, se trouve dans la première couche métallique (141, 161, 171, 181), et l'élément d'alimentation (13) est configuré pour alimenter la seconde couche métallique (142, 162, 172, 182) et la première couche métallique (141, 161, 171, 181).

**2.** Puce (21) selon la revendication 1, dans laquelle une saillie de la première couche métallique (141, 161, 171, 181) sur la couche de mise à la terre (12) se trouve dans la couche de mise à la terre (12) ; une saillie de la seconde couche métallique (142, 162, 172, 182) sur un plan, sur lequel la première couche métallique (141, 161, 171, 181) est située, se trouve dans la première couche métallique (141, 161, 171, 181).

**3.** Puce (21) selon la revendication 1 ou 2, dans laquelle il existe quatre éléments d'antenne (14), les quatre éléments d'antenne (14) sont agencés en deux rangées et deux colonnes et sont espacés les uns des autres, et les quatre éléments d'antenne (14) sont un premier élément d'antenne (14, 14a), un deuxième élément d'antenne (14b), un troisième élément d'antenne (14c) et un quatrième élément d'antenne (14d) ;

un premier bord (1611) de la première couche métallique (161) du deuxième élément d'antenne (14b) et le premier bord (1411) de la première couche métallique (141) du premier élément d'antenne (14, 14a) forment un premier espace (191) ;
un troisième bord (1713) de la première couche métallique (171) du troisième élément d'antenne (14c) et le troisième bord (1413) de la première couche métallique (141) du premier élément d'antenne (14, 14a) forment un deuxième espace (192) ;
un premier bord (1811) de la première couche métallique (181) du quatrième élément d'antenne (14d) et le premier bord (1711) de la première couche métallique (171) du troisième élément d'antenne (14c) forment un troisième espace (193) ; et
un troisième bord (1813) de la première couche métallique (181) du quatrième élément d'antenne (14d) et le troisième bord (1613) de la première couche métallique (161) du deuxième élément d'antenne (14b) forment un quatrième espace (194),
dans laquelle le quatrième espace (194) est relié au premier espace (191), au deuxième espace (192) et au troisième espace (193), et dans laquelle le premier espace (191), le deuxième espace (192), le troisième espace (193) et le quatrième espace (194) forment une forme « cruciforme ».

**4.** Puce (21) selon la revendication 3, dans laquelle la branche d'alimentation (131, 132) comprend une première branche d'alimentation (131) et une seconde branche d'alimentation (132) qui sont espacées l'une de l'autre, et l'élément d'alimentation (13) comporte en outre un premier trou métallique (133) et un second trou métallique (134) qui sont espacés l'un de l'autre, le premier trou métallique (133) est relié à la première branche d'alimentation (131) et le second trou métallique (134) est relié à la seconde branche d'alimentation (132), et dans laquelle des saillies du premier trou métallique (133) et du second trou métallique (134) sur un plan, sur lequel la première couche métallique (141, 161, 171, 181) est située, se trouvent dans la première couche métallique (141, 161, 171, 181).

**5.** Puce (21) selon la revendication 4, dans laquelle la puce comprend en outre un circuit radiofréquence (20), la couche de mise à la terre (12) est pourvue d'un premier trou traversant (121) et d'un second trou traversant (122) qui sont espacés l'un de l'autre, le premier trou métallique (133) est connecté électriquement au circuit radiofréquence (20) par le biais du premier trou traversant (121), et le second trou métallique (134) est connecté électriquement au circuit radiofréquence (20) par le biais du second trou traversant (122).

**6.** Puce (21) selon la revendication 5, dans laquelle le premier organe conducteur est une pluralité de premières colonnes métalliques (143, 163, 173, 183) ; et le second organe conducteur comprend une première feuille de liaison métallique (146a, 166a, 176a, 186a), une pluralité de deuxièmes colonnes métalliques (14, 144, 164, 174, 184), et une pluralité de troisièmes colonnes métalliques (145, 165, 175, 185), dans laquelle la première feuille de liaison métallique (146a, 166a, 176a, 186a) est située entre la seconde couche métallique (142, 162, 172, 182) et la couche de mise à la terre (12), la pluralité de deuxièmes colonnes métalliques (14, 144, 164, 174, 184) est reliée entre la première feuille de liaison métallique (146a, 166a, 176a, 186a) et la seconde zone (142b, 162b, 172b, 182b) de la seconde couche métallique (142, 162, 172, 182), et la pluralité de troisièmes colonnes métalliques (145, 165, 175, 185) est reliée entre la première feuille de liaison métallique (146a, 166a, 176a, 186a) et la couche de mise à la terre (12).

**7.** Puce (21) selon la revendication 6, dans laquelle la pluralité de troisièmes colonnes métalliques (145, 165, 175, 185) est disposée à mi-chemin du premier trou traversant (121), et la pluralité de troisièmes colonnes métalliques (145, 165, 175, 185) est disposée à mi-chemin du second trou traversant (122).

**8.** Puce (21) selon la revendication 6 ou 7, dans laquelle un diamètre de la troisième colonne métallique (145, 165, 175, 185) est supérieur à un diamètre de la deuxième colonne métallique (14, 144, 164, 174, 184).

**9.** Puce (21) selon l'une quelconque des revendications 6 à 8, dans laquelle la puce satisfait à au moins l'un parmi ce qui suit :

la pluralité de premières colonnes métalliques (143, 163, 173, 183) est agencée en forme de L ou en forme d'arc ;
la première feuille de liaison métallique (146a, 166a, 176a, 186a) a une forme en L ou une forme d'arc ;
la pluralité de deuxièmes colonnes métalliques (14, 144, 164, 174, 184) est agencée en forme de L ou en forme d'arc ;

et la pluralité de troisièmes colonnes métalliques (145, 165, 175, 185) est agencée en forme de L ou en forme d'arc.

10. Puce (21) selon l'une quelconque des revendications 6 à 9, dans laquelle des saillies des troisièmes colonnes métalliques (145, 165, 175, 185) sur la première feuille de liaison métallique (146a, 166a, 176a, 186a) chevauchent au moins partiellement des saillies des deuxièmes colonnes métalliques (14, 144, 164, 174, 184) sur la première feuille de liaison métallique (146a, 166a, 176a, 186a).

11. Puce (21) selon l'une quelconque des revendications 3 à 10, dans laquelle les quatre éléments d'antenne (14) ont un point central, un second organe conducteur du premier élément d'antenne (14, 14a) est situé sur un côté qui appartient à un premier organe conducteur du premier élément d'antenne (14, 14a) et qui est plus éloigné du point central, un second organe conducteur du deuxième élément d'antenne (14b) est situé sur un côté qui appartient à un premier organe conducteur du deuxième élément d'antenne (14b) et qui est plus éloigné du point central, un second organe conducteur du troisième élément d'antenne (14c) est situé sur un côté qui appartient à un premier organe conducteur du troisième élément d'antenne (14c) et qui est plus éloigné du point central, et un second organe conducteur du quatrième élément d'antenne (14d) est situé sur un côté qui appartient un premier organe conducteur du quatrième élément d'antenne (14d) et qui est plus éloigné du point central.

12. Puce (21) selon l'une quelconque des revendications 3 à 11, dans laquelle la branche d'alimentation (131, 132) est situé dans un espace encerclé par le second organe conducteur du premier élément d'antenne (14, 14a), le second organe conducteur du deuxième élément d'antenne (14b), le second organe conducteur du troisième élément d'antenne (14c) et le second organe conducteur du quatrième élément d'antenne (14d).

13. Puce (21) selon l'une quelconque des revendications 3 à 12, dans laquelle le premier élément d'antenne (14, 14a), le deuxième élément d'antenne (14b), le troisième élément d'antenne (14c) et le quatrième élément d'antenne (14d) forment une structure centrosymétrique.

14. Puce (21) selon l'une quelconque des revendications 3 à 13, dans laquelle le troisième élément d'antenne (14c) et le premier élément d'antenne (14a) forment une structure symétrique, et le troisième élément d'antenne (14c) et le premier élément d'antenne (14a) sont symétriques le long d'un second plan de symétrie (N2) ; le quatrième élément d'antenne (14d) et le deuxième élément d'antenne (14b) forment une structure symétrique, et le quatrième élément d'antenne (14c) et le deuxième élément d'antenne (14b) sont symétriques le long du second plan de symétrie (N2).

15. Puce (21) selon la revendication 3, dans laquelle la branche d'alimentation (131, 132) comprend une première branche d'alimentation (131) et une seconde branche d'alimentation (132) qui sont espacées l'une de l'autre ;

une saillie d'une extrémité de la première branche d'alimentation (131) sur le plan sur lequel la première couche métallique (141, 161, 171, 181) du premier élément d'antenne (14, 14a) est située, se trouve dans la première couche métallique (141, 161, 171, 181) du premier élément d'antenne (14, 14a) ; et une saillie de l'autre extrémité de la première branche d'alimentation (131) sur le plan sur lequel la première couche métallique (141, 161, 171, 181) du quatrième élément d'antenne (14d) est située, se trouve dans la première couche métallique (141, 161, 171, 181) du quatrième élément d'antenne (14d), et la première branche d'alimentation (131) est configurée pour alimenter la seconde couche métallique (142, 162, 172, 182) du premier élément d'antenne (14, 14a), une première couche métallique (141, 161, 171, 181) du premier élément d'antenne (14, 14a), la seconde couche métallique (142, 162, 172, 182) du quatrième élément d'antenne (14d), et une première couche métallique (141, 161, 171, 181) du quatrième élément d'antenne (14d) ; et une saillie d'une extrémité de la seconde branche d'alimentation (132) sur le plan sur lequel la première couche métallique (141, 161, 171, 181) du deuxième élément d'antenne (14b) est située, se trouve dans la première couche métallique (141, 161, 171, 181) du deuxième élément d'antenne (14b) ; et une saillie de l'autre extrémité de la seconde branche d'alimentation (132) sur le plan sur lequel la première couche métallique (141, 161, 171, 181) du troisième élément d'antenne (14c) est située, se trouve dans la première couche métallique (141, 161, 171, 181) du troisième élément d'antenne (14c), et la seconde branche d'alimentation (132) est configurée pour alimenter la seconde couche métallique (142, 162, 172, 182) du deuxième élément d'antenne (14b), une première couche métallique (141, 161, 171, 181) du deuxième élément d'antenne (14b), la seconde couche métallique (142, 162, 172, 182) du troisième élément d'antenne (14c) et une première couche métallique (141, 161, 171, 181) du troisième élément d'antenne (14c).

**16.** Puce (21) selon la revendication 15, dans laquelle les quatre éléments d'antenne (14) ont un point central, le premier élément d'antenne (14, 14a), le deuxième élément d'antenne (14b), le troisième élément d'antenne (14c), et le quatrième élément d'antenne (14d) sont tous des structures symétriques, et un plan de symétrie du premier élément d'antenne (14, 14a), un plan de symétrie du deuxième élément d'antenne (14b), un plan de symétrie du troisième élément d'antenne (14c) et un plan de symétrie du quatrième élément d'antenne (14d) passent tous par le point central ; et
une direction d'extension de la première branche d'alimentation (131) est parallèle au plan de symétrie du premier élément d'antenne (14, 14a) et au plan de symétrie du quatrième élément d'antenne (14d), et une direction d'extension de la seconde branche d'alimentation (132) est parallèle au plan de symétrie du deuxième élément d'antenne (14b) et au plan de symétrie du troisième élément d'antenne (14c).

**17.** Puce (21) selon la revendication 15 ou 16, dans laquelle la première branche d'alimentation (131) comprend une première partie (1311, 1321), une deuxième partie (1312a, 1322), une troisième partie (1312b, 1323), une quatrième partie (1312c) et une cinquième partie (1313) qui sont connectés de manière séquentielle ; une saillie d'une partie de la première partie (1311) sur le plan sur lequel la première couche métallique (141, 161, 171, 181) du premier élément d'antenne (14, 14a) est située, se trouve dans la première couche métallique (141, 161, 171, 181) du premier élément d'antenne (14, 14a) ; et une saillie d'une partie de la cinquième partie (1313) sur le plan sur lequel la première couche métallique (141, 161, 171, 181) du quatrième élément d'antenne (14d) est située, se trouve dans la première couche métallique (141, 161, 171, 181) du quatrième élément d'antenne (14d).

**18.** Puce (21) selon la revendication 17, dans laquelle une distance entre la première partie (1311, 1321) et la couche de mise à la terre (12), une distance entre la cinquième partie (1313) et la couche de mise à la terre (12), et une distance entre la seconde branche d'alimentation (132) et la couche de mise à la terre (12) sont toutes égales ; la deuxième partie (1312a, 1322), la troisième partie (1312b, 1323) et la quatrième partie (1312c) de la première branche d'alimentation (131) forment un « U » ; et la troisième partie (1312b, 1323) est située entre la seconde branche d'alimentation(132) et la couche de mise à la terre (12).

**19.** Puce (21) selon l'une quelconque des revendications 15 à 18, dans laquelle la seconde branche d'alimentation (132) comporte une première partie (1321), une deuxième partie (1322) et une troisième partie (1323) qui sont connectées de manière séquentielle, une saillie d'une partie de la première partie (1321) sur le plan sur lequel la première couche métallique (141, 161, 171, 181) du troisième élément d'antenne (14c) est située, se trouve dans la première couche métallique (141, 161, 171, 181) du troisième élément d'antenne (14c) ; et une saillie d'une partie de la troisième partie (1323) sur le plan sur lequel la première couche métallique (141, 161, 171, 181) du deuxième élément d'antenne (14b) est située, se trouve dans la première couche métallique (141, 161, 171, 181) du deuxième élément d'antenne (14b).

**20.** Puce (21) selon l'une quelconque des revendications 15 à 19, dans laquelle la première branche d'alimentation (131) et la seconde branche d'alimentation (132) satisfont à l'un de ce qui suit :

un angle inclus entre la direction d'extension de la première branche d'alimentation (131) et le premier bord (1411) de la première couche métallique (141) du premier élément d'antenne (14a) est de 45 ° ;
un angle inclus entre la direction d'extension de la première branche d'alimentation (131) et le premier bord (1811) de la première couche métallique (181) du quatrième élément d'antenne (14d) est de 45 ° ;
un angle inclus entre la direction d'extension de la seconde branche d'alimentation (132) et le premier bord (1711) de la première couche métallique (171) du troisième élément d'antenne (14c) est de 45 ° ; et
un angle inclus entre la direction d'extension de la seconde branche d'alimentation (132) et le premier bord (1611) de la première couche métallique (161) du deuxième élément d'antenne (14b) est de 45 °.

**21.** Puce (21) selon l'une quelconque des revendications 3 à 20, dans laquelle la structure d'antenne (10) comprend en outre une pluralité de groupes de trous de court-circuit métalliques, et la pluralité de groupes de trous de court-circuit métalliques est connectée électriquement à la couche de mise à la terre (12) et est située à une périphérie du premier élément d'antenne (14, 14a), du deuxième élément d'antenne (14b), du troisième élément d'antenne (14c) et du quatrième élément d'antenne (14d) ; et le premier élément d'antenne (14, 14a) et le deuxième élément d'antenne (14b) forment un premier espace (191), au moins un groupe de trous de court-circuit métallique est disposé dans une direction d'extension du premier espace (191), le premier élément d'antenne (14, 14a) et le troisième élément d'antenne (14c) forment un deuxième espace (192), au moins un groupe de trous de court-circuit métallique est disposé dans une direction d'extension du deuxième espace (192), le troisième élément d'antenne (14c) et le quatrième élément d'antenne (14d) forment un troisième espace (193), au moins un groupe de trous de court-circuit métallique est disposé dans une direction d'extension du troisième espace (193), le quatrième élément d'antenne (14d) et le deuxième élément d'antenne (14b) forment un quatrième espace (194), et au moins un groupe de trous de court-circuit métallique est disposé dans une direction d'extension du quatrième espace (194).

22. Puce (21) selon l'une quelconque des revendications 3 à 21,
dans laquelle la structure d'antenne (10) comprend en outre une pluralité de groupes de trous d'interconnexion correspondants, la pluralité de groupes de trous d'interconnexion correspondants est connectée électriquement à la couche de mise à la terre (12), la pluralité de groupes de trous d'interconnexion correspondants est située à la périphérie des éléments d'antenne (14), et la pluralité de groupes de trous d'interconnexion correspondants est disposée autour des éléments d'antenne (14).

23. Puce (21) selon l'une quelconque des revendications 1 à 22, dans laquelle la structure d'antenne est une antenne configurée pour transmettre et recevoir dans une bande de fréquences à ondes millimétriques.

24. Puce (21) selon la revendication 23, dans laquelle la structure d'antenne est configurée pour prendre en charge les bandes de fréquences n257, n258, n259, n260, et n261.

25. Puce (21) selon la revendication 23, dans laquelle la structure d'antenne est configurée pour fonctionner dans une bande de fréquences de fonctionnement allant de 24,25 GHz à 29,5 GHz et de 37 GHz à 43,5 GHz.

26. Dispositif électronique, comprenant une carte de circuit imprimé (30) et la puce (21) selon l'une quelconque des revendications 1 à 25, dans lequel la puce (21) est disposée sur la carte de circuit imprimé (30), et le substrat de boîtier (51) de la puce (21) est connecté électriquement à la carte de circuit imprimé (30).

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

FIG. 25a

FIG. 25b

FIG. 25c

FIG. 25d

EP 4 345 885 B1

146
146b
146b
146b

146b  1464
1463  a4
a3

1463b
146a  1462
1463a
1461  a2
a1

FIG. 26

60

FIG. 27

FIG. 28

FIG. 29

FIG. 30a

FIG. 30b

FIG. 30c

FIG. 30d

FIG. 30e

EP 4 345 885 B1

FIG. 31

FIG. 32a

FIG. 32b

FIG. 33

FIG. 34

FIG. 35

FIG. 36

FIG. 37

FIG. 38

# EP 4 345 885 B1

**Non-patent literature cited in the description**

- A Wideband mmWave Antenna in Fan-Out Water Level Packaging With Tall Vertical Interconnects for 5G Wireless Communication. **YU BIN et al.** IEEE TRANSACTIONS ON ANTENNAS AND PROPAGATION. IEEE, 15 June 2021, vol. 69, 6906-6911